(19) Europäisches Patentamt
European Patent Office
Office européen des brevets

(11) EP 2 899 034 B1

# (12) EUROPEAN PATENT SPECIFICATION

(45) Date of publication and mention of the grant of the patent:
**03.07.2019 Bulletin 2019/27**

(21) Application number: **13839219.6**

(22) Date of filing: **20.08.2013**

(51) Int Cl.:
***B41C 1/10*** *(2006.01)* ***B41N 1/14*** *(2006.01)*
***G03F 7/00*** *(2006.01)* ***G03F 7/004*** *(2006.01)*
***G03F 7/029*** *(2006.01)* ***G03F 7/11*** *(2006.01)*

(86) International application number:
**PCT/JP2013/072212**

(87) International publication number:
**WO 2014/045783 (27.03.2014 Gazette 2014/13)**

## (54) ORIGINAL PLANOGRAPHIC PRINTING PLATE, AND PLATE MAKING METHOD

ORIGINALFLACHDRUCKPLATTE UND PLATTENHERSTELLUNGSVERFAHREN

PLAQUE D'IMPRESSION PLANOGRAPHIQUE ORIGINALE ET PROCÉDÉ DE FABRICATION DE PLAQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.09.2012 JP 2012207525**

(43) Date of publication of application:
**29.07.2015 Bulletin 2015/31**

(73) Proprietor: **FUJIFILM Corporation**
**Tokyo 106-8620 (JP)**

(72) Inventors:
- **SATO Noriaki**
  **Haibara-gun**
  **Shizuoka 421-0396 (JP)**
- **NAGATA Yuzo**
  **Haibara-gun**
  **Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A2- 0 828 195** **JP-A- 2003 295 425**
**JP-A- 2006 154 074** **JP-A- 2009 069 802**
**JP-A- 2009 163 003** **JP-A- 2009 204 874**
**JP-A- 2009 237 332** **JP-A- 2011 213 113**
**US-A1- 2007 099 115** **US-A1- 2007 160 935**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 899 034 B1

**Description**

TECHNICAL FIELD

The present invention relates to a lithographic printing plate precursor, and more particularly, to a lithographic printing plate precursor having a negative type recording layer excellent in printing durability and excellent in reproducibility of image.

BACKGROUND ART

Development of laser in recent years is outstanding, in particular, in a solid laser and a semiconductor laser each having an emission region in a range from a near-infrared ray to an infrared ray, high power and miniaturization proceed. Thus, these lasers are very useful as an exposure light source at the time of direct plate making from digital data, for example, of a computer.

As the printing plate material used for a CTP system, for example, that comprising a film base material having provided thereon an image-recording layer of silver salt diffusion transfer system as disclosed in Patent Document 1, that comprising a film base material having provided thereon a hydrophilic layer and an oleophilic layer stacked in such a manner that any one of the hydrophilic layer and the oleophilic layer is stacked as a surface layer so as to form a printing plate by ablation of the surface layer with laser exposure as disclosed in Patent Document 2 or 3, that comprising a base material having provided thereon a hydrophilic layer and a heat fusible image-forming layer wherein heat is generated imagewise with lase exposure in the hydrophilic layer or the image-forming layer to fuse and fix the image-forming layer on the hydrophilic layer as disclosed in Patent Document 4, and that comprising a base material having provided thereon an image-recording layer containing a polymerizable compound are known.

As a negative type image-recording material, for example, a recording material composed of an infrared absorbing agent, an acid generator, and a cresol resin or a novolac resin is described in Patent Document 5. However, such a negative type image-recording material requires a heat treatment of approximately from 140 to 200°C for from 50 to 120 seconds after laser exposure in order to form an image and thus, a large-scale equipment and energy are needed for the heat treatment after exposure.

Also, a recording material comprising a cyanine dye having a specific structure, an iodonium salt, and an addition polymerizable compound having an ethylenically unsaturated double bond, which does not require the heat treatment after imagewise exposure is described in Patent Document 6. However, the image-recording material causes polymerization inhibition due to oxygen in the air at the polymerization reaction to result in problems of decrease in sensitivity and insufficient strength in the image area formed. On the other hand, in order to increase the sensitivity, a method of using as the initiator, a borate compound having a high donor property and a photopolymerization inhibition ability itself is considered. According to the method, however, for example, in the case of being handled under a white lamp, in the case of using a platesetter having a low extinction ratio, or in the case of preserving for a long period of time, an undesirable curing reaction proceeds and there is a concern that the image-forming property degrades, for example, stain is apt to occur in the non-image area.

Further, in order to improve these problems, an attempt to prevent the degradation of the image-forming property by adding a polymerization inhibitor to the image-recording layer using an initiator of high sensitivity has been made. A heat mode accepting printing plate material using as a polymerization initiator, for example, a borate compound, a triazine compound or a specific onium salt, which does not require the heat treatment after exposure is known (for example, Patent Document 7 and Patent Document 8). In Patent Document 7, a negative lithographic printing plate capable of being recorded with an infrared ray having an image-recording layer containing (A) a borate or a triazine, (B) a polymerization inhibitor, (C) a light-heat converting agent, and (D) a polymerizable unsaturated group-containing compound is disclosed.

As to a polymerization type image-recording layer, a lithographic printing plate material comprising a support having thereon an image-recording layer containing (a) a light-heat converting agent having an absorption in a wavelength range from 700 to 1,300 nm, (b) a polymerization initiator, (c) a polymerizable unsaturated group-containing compound, (d) an alkali-soluble polymer compound, and (e) a polymerization inhibitor, wherein the polymerization inhibitor is a hindered amine compound containing a piperidine skeleton having a base constant (pKb) from 7 to 14 is disclosed (Patent Document 9).

Also, a polymerizable composition containing (A) a non-acrylic binder polymer having an ethylenically unsaturated bond in its side chain, (B) a compound which is neutral in charge and generates a radical with light or heat, and (C) a compound having an ethylenically unsaturated bond, which further contains (D) a polymerization inhibitor is disclosed.

On the other hand, by the addition of the polymerization inhibitor, sensitivity and printing durability decrease, although the undesirable curing reaction is suppressed so that the stain and the like can be prevented.

US 2007/160935 and US 2007/099115 equally disclose certain lithographic printing plate precursors, but do not disclose the use of at least one or more benzoquinone trapping sites.

PRIOR ART DOCUMENT

PATENT DOCUMENT

Patent Document 1: JP-A-5-66564

Patent Document 2: JP-A-8-507727

Patent Document 3: JP-A-10-58636

Patent Document 4: JP-A-2001-96710

Patent Document 5: U.S. Patent 5,340,699

Patent Document 6: JP-B-7-103171

Patent Document 7: JP-A-2002-107916

Patent Document 8: JP-A-2003-76010

Patent Document 9: JP-A-2005-77978

DISCLOSURE OF THE INVENTION

PROBLEMS THAT THE INVENTION IS TO SOLVE

An object of the present invention is to provide a lithographic printing plate precursor which is capable of being directly recorded from digital data, for example, of a computer, which has high sensitivity, and which can form an image having a high image quality by preventing an undesirable curing reaction in the non-image area from proceeding, wherein the lithographic printing plate precursor can provide a lithographic printing plate having high printing durability, and a plate making method using the same.

MEANS FOR SOLVING THE PROBLEMS

Specifically, the means for solving the problems described above are as follows. In the specification, the range represented by using "to" indicates a range including the numerical values described before and after "to" as the minimum value and the maximum value, respectively.

(1) A lithographic printing plate precursor comprising a support having provided thereon an image-recording layer containing (A) a radical polymerization initiator, (B) a radical polymerizable compound, and (C) a polyfunctional polymerization inhibitor, wherein the polyfunctional polymerization inhibitor (C) has, in a molecule thereof, two or more radical trapping sites to form a covalent bond by directly connecting with a radical, wherein the trapping sites include one, two or more benzoquinone sites.

(2) The lithographic printing plate precursor as described in (1) above, wherein the benzoquinone site has the following structure in which X represents S or NH:

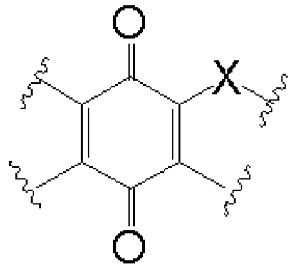

(3) The lithographic printing plate precursor as described in (2) above, wherein X is S.

(4) The lithographic printing plate precursor as described in (1) above, wherein the polyfunctional polymerization inhibitor (C) in addition has a 4-substituted-2,2,6,6-tetramethylpiperidin-1-oxyl free radical site shown below:

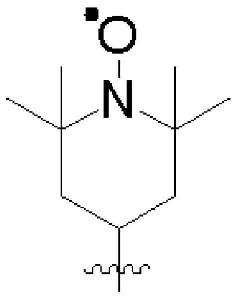

(5) The lithographic printing plate precursor as described in (1) above, wherein the polyfunctional polymerization inhibitor (C) in addition has a 4-oxy-2,2,6,6-tetramethylpiperidin-1-oxyl free radical site shown below:

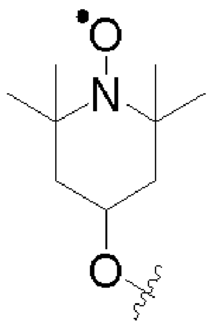

(6) The lithographic printing plate precursor as described in any one of (1) to (5) above, wherein the number of the radical trapping sites of the polyfunctional polymerization inhibitor (C) is from 2 to 6.

(7) The lithographic printing plate precursor as described in any one of (1) to (6) above, wherein the content of the polyfunctional polymerization inhibitor (C) is from 0.1 to 20% by mole to the radical polymerization initiator (A).

(8) The lithographic printing plate precursor as described in any one of (1) to (7) above, wherein the polyfunctional polymerization inhibitor (C) has a center skeleton B and n number, wherein n represents an integer of 2 or more of the radical trapping sites.

(9) The lithographic printing plate precursor as described in (8) above, wherein the center skeleton B contains at least one of a benzene skeleton, an isocyanuric skeleton and an ester skeleton.

(10) The lithographic printing plate precursor as described in any one of (1) to (9) above, wherein the image-recording layer further contains (D) a sensitizing dye having an absorption wavelength in a range from 300 to 900 nm.

(11) The lithographic printing plate precursor as described in any one of (1) to (10) above, wherein the radical polymerization initiator (A) is an iodonium salt or a sulfonium salt.

(12) The lithographic printing plate precursor as described in any one of (1) to (11) above, wherein the image-recording layer contains an organic boron compound.

(13) The lithographic printing plate precursor as described in any one of (1) to (12) above, which has a protective layer containing an inorganic stratiform compound on the image-recording layer.

(14) The lithographic printing plate precursor as described in any one of (1) to (13) above, wherein an unexposed

area of the image-recording layer is capable of being removed with at least one of dampening water and printing ink.
(15) A plate making method comprising exposing imagewise the lithographic printing plate precursor as described in (14) above by an infrared laser, mounting the exposed lithographic printing plate precursor on a cylinder of printing machine, and removing the unexposed area of the image-recording layer with at least one of dampening water and printing ink.

The mechanism of the invention is not clear, but it is supposed as follows.

In the case where a polymerization initiator of high sensitivity is used, even due to exposure of weak energy, for example, a small amount of laser beam irradiated to the non-image area at the laser exposure or influence of light during handling under a white lamp, a radical generates, although in a small amount, to cause the undesirable curing reaction in the unexposed area.

When a polymerization inhibitor having a monofunctional radical trapping site is added to the case described above, polymerization in the portion which is irradiated with a weak laser beam so as not to want to form an image (hereinafter, referred to as a low exposure portion) is suppressed to prevent the undesirable film curing and at the same time, polymerization in the portion which is irradiated with a strong laser beam so as to want to form an image (hereinafter, referred to as a high exposure portion) is also suppressed to result in the decrease in the sensitivity and the printing durability.

Also, when a polymerization inhibitor which exhibits a polymerization inhibition ability without forming a covalent bond even by an interaction with a radical is added to the case described above, the polymerization is suppressed in both the low exposure portion and the high exposure portion to result in the decrease in the sensitivity and the printing durability same as in the case of adding the polymerization inhibitor having a monofunctional radical trapping site.

On the other hand, according to the invention, the polyfunctional polymerization inhibitor (C) has a number of radical trapping sites in a molecule thereof. Hence, it is supposed that the polyfunctional polymerization inhibitor acts as a polymerization inhibitor in the portion which is irradiated with a weak light to prevent the undesirable curing of the unexposed area, and in the portion which is irradiated with a strong light, it reacts with a propagating radical to act as a crosslinking point for crosslinking propagating chains of the radicals with each other, thereby increasing the film strength to achieve high printing durability.

## ADVANTAGE OF THE INVENTION

According to the invention, a lithographic printing plate precursor which is capable of being directly recorded from digital data, for example, of a computer, which has high sensitivity, which prevents an undesirable curing reaction in the non-image area from proceeding, and which provides high printing durability can be obtained.

## MODE FOR CARRYING OUT THE INVENTION

The lithographic printing plate precursor according to the invention is a lithographic printing plate precursor comprising a support having provided thereon an image-recording layer containing (A) a radical polymerization initiator, (B) a radical polymerizable compound, and (C) a polyfunctional polymerization inhibitor, wherein the polyfunctional polymerization inhibitor has, in a molecule thereof, two or more radical trapping sites to form a covalent bond by directly connecting with a radical.

### [Lithographic printing plate precursor]

The lithographic printing plate precursor according to the invention comprises a support having provided thereon an image-recording layer containing components (A) to (C) described above. The lithographic printing plate precursor according to the invention can be provided with an undercoat layer between the support and the image-recording layer or a protective layer on the image-recording layer, if desired.

Hereinafter, the constituting components of the lithographic printing plate precursor according to the invention will be described.

### [Image-recording layer]

The image-recording layer according to the invention is characterized by containing (A) a radical polymerization initiator, (B) a radical polymerizable compound, and (C) a polyfunctional polymerization inhibitor.

(A) Radical polymerization initiator

The radical polymerization initiator which can be used in the invention indicates a compound which initiates or accelerates polymerization of the radical polymerizable compound (B). As the radical polymerization initiator usable in the invention, for example, known thermal polymerization initiators and compounds containing a bond having small bond dissociation energy can be used.

The radical polymerization initiator according to the invention include, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound, (k) an onium salt compound, and (1) a carboxylic acid compound.

As the organic halide (a), compounds described in Paragraph Nos. [0022] to [0023] of JP-A-2008-195018 are preferred.

As the carbonyl compound (b), compounds described in Paragraph No. [0024] of JP-A-2008-195018 are preferred.

As the azo compound (c), for example, azo compounds described in JP-A-8-108621 can be used.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azide compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate compound (h), for example, compounds described in Paragraph No. [0028] of JP-A-2008-195018 are preferred.

As the disulfone compound (i), for example, compounds described in JP-A-61-166544 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S. I. Schlesinger, Photogr. Sci. Eng., 18, 387 (1974), T. S. Bal et al., Polymer, 21, 423 (1980) and JP-A-5-158230 (corresponding to diazonium of N13), ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848, JP-A-2008-195018 and J. V. Crivello et al., Macromolecules, 10 (6), 1307 (1977), sulfonium salts described in European Patents 370,693, 233,567, 297,443 and 297,442, U.S. Patents 4,933,377, 4,760,013, 4,734,444 and 2,833,827 and German Patents 2,904,626, 3,604,580 and 3,604,581, selenonium salts described in J. V. Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.

As the carboxylic acid compound (1), for example, compounds described in Paragraph Nos. [0118] to [0164] of U. S. Patent Publication No. 2003/0118939, Paragraph Nos. [0065] to [0068] of U. S. Patent Publication No. 2004/0091811, Paragraph Nos. [0114] to [0162] of U. S. Patent Publication No. 2004/0259027, and Paragraph Nos. [0071] to [0115] of JP-A-2005-59446 are exemplified.

Of the radical polymerization initiators described above, an onium salt is preferred, among them, an iodonium salt, a sulfonium salt or an azinium salt is more preferred, and an iodonium salt or a sulfonium salt is particularly preferred. Specific examples of these compounds are set forth below, but the invention should not be construed as being limited thereto.

[Iodonium salt, sulfonium salt and azinium salt polymerization initiators]

According to the invention, it is preferred to use an onium polymerization initiator represented by any one of formulae (4) to (6) as the onium polymerization initiator. The onium polymerization initiator represented by formula (4) or (5) is more preferred.

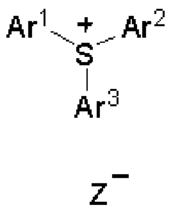 (4) 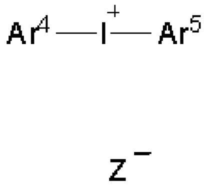 (5) 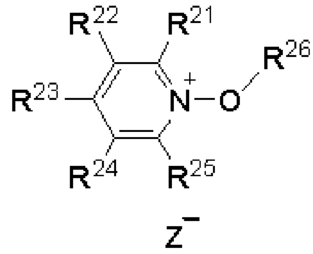 (6)

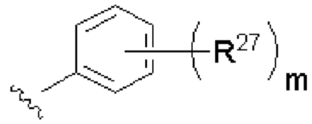 (7)

In formulae (4) and (5), $Ar^1$, $Ar^2$, $Ar^3$, $Ar^4$ and $Ar^5$ each independently represents a group represented by formula (7). In formula (6), $R^{21}$, $R^{22}$, $R^{23}$, $R^{24}$ and $R^{25}$ each independently represents a hydrogen atom, an alkyl group, an alkoxy group, an aryl group, a cyano group or a halogen atom, or $R^{21}$ and $R^{22}$ or $R^{22}$ and $R^{23}$ may be combined with each other to form a condensed ring structure. $R^{26}$ represents an alkyl group or an aryl group. $Z^-$ represents an anion.

In formula (7), $R^{27}$ represents an alkyl group, an alkoxy group or a halogen atom, and plural $R^{27}$s may be the same or different. m represents an integer from 0 to 5.

In formula (4), $Ar^1$, $Ar^2$ and $Ar^3$ each more preferably represents a group represented by formula (10) shown below. In formula (5), $Ar^4$ and $Ar^5$ each more preferably represents a group represented by formula (11) shown below.

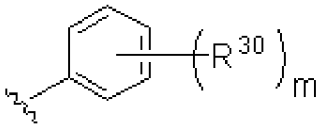 (10) 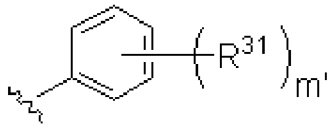 (11)

In formulae (10), $R^{30}$ represents a halogen atom, and plural $R^{30}$s may be the same or different. In formulae (11), $R^{31}$ represents an alkyl group or an alkoxy group, and plural $R^{31}$s may be the same or different. m and m' each independently represents an integer from 1 to 5.

Of the onium polymerization initiators represented by formulae (4) and (5), the polymerization initiators in which the sum of ms in $Ar^1$, $Ar^2$ and $Ar^3$ and the sum of m's in $Ar^4$ and $Ar^5$ are 4 or more, respectively, are most preferred.

The reason for why the polymerization initiators having many substituents in which the sum of ms and the sum of m's are 4 or more, respectively, are preferred is not clear, but it is supposed as follows.

As increase in the number of substituents, an energy level of the lowest unoccupied molecular orbital (LUMO) of the onium polymerization initiator decreases and electron transfer from an excited IR dye proceeds more efficiently. The electron transfer is most efficient when the total number of the substituents is 4 or more. The good efficiency of the electron transfer brings about also the increase in the efficiency of decomposition reaction of the compound represented by formula (1).

The alkyl group represented by any of $R^{21}$, $R^{22}$, $R^{23}$, $R^{24}$, $R^{25}$, $R^{26}$, $R^{27}$ and $R^{31}$ is preferably an alkyl group having from 1 to 20 carbon atoms, more preferably an alkyl group having from 1 to 10 carbon atoms, and most preferably an alkyl group having from 1 to 4 carbon atoms.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, 1-methylbutyl group, an isohexyl group, a 2-ethylhexyl group, a 2-methylhexyl group, a cyclohexyl group, a cyclopentyl group and a 2-norbornyl group.

Of the alkyl groups, a methyl group, an ethyl group, a propyl group, a butyl group and a tert-butyl group are particularly preferred.

In the case where any of $R^{21}$, $R^{22}$, $R^{23}$, $R^{24}$, $R^{25}$, $R^{27}$ and $R^{31}$ represents an alkoxy group, it is represented by an alkyl group-O-, and a preferred embodiment of the alkyl group is same as the preferred embodiment of the alkyl group in the case where any of $R^{21}$, $R^{22}$, $R^{23}$, $R^{24}$, $R^{25}$, $R^{26}$, $R^{27}$ and $R^{31}$ represents the alkyl group.

The aryl group represented by any of $R^{21}$, $R^{22}$, $R^{21}$, $R^{24}$, $R^{25}$ and $R^{26}$ is preferably an aryl group having from 6 to 30 carbon atoms, more preferably an aryl group having from 6 to 20 carbon atoms, and most preferably an aryl group having from 6 to 12 carbon atoms.

Specific examples of the aryl group include a phenyl group, a biphenyl group, a 1-naphthyl group, a 2-naphthyl group, a 9-fluorenyl group, a terphenyl group, an o-, m- or p-tolyl group, a xylyl group, an o-, m- or p-cumenyl group, a mesityl group, a biphenylenyl group, an indacenyl group, a fluorenyl group, a p-chlorophenyl group, a p-bromophenyl group, a p-fluorophenyl group, an o-chlorophenyl group, an o-bromophenyl group, an o-fluorophenyl group, a p-methoxyphenyl group, a m-methoxyphenyl group, a p-dimethylaminophenyl group, a p-methylthiophenyl group, a m-methylthiophenyl group, p-phenylthiophenyl group, a 2,3-difluorophenyl group, a 2,3-dichlorophenyl group, a 2,4-difluorophenyl group, a 2,4-dichlorophenyl group, a 2,5-difluorophenyl group, a 2,5-dichlorophenyl group, a 2,6-difluorophenyl group, a 2,6-dichlorophenyl group, a 2,4,6-trifluorophenyl group, a 2,4,6-trichlorophenyl group, a 3,4,5-trifluorophenyl group and a 3,4,5-trichlorophenyl group.

Of the aryl groups, a phenyl group, a p-methoxyphenyl group and a p-dimethylaminophenyl group are particularly preferred.

The anion represented by $Z^-$ preferably includes a halide ion, a perchlorate ion, a tetrafluoroborate ion, a hexafluorophosphate ion and a sulfonate ion, and is particularly preferably a perchlorate ion, a hexafluorophosphate ion or an arylsulfonate ion, and most preferably a hexafluorophosphate ion.

Preferred specific examples of the onium salt polymerization initiator are set forth below, but the invention should not be construed as being limited thereto.

Examples of the compound (sulfonium salt) represented by formula (4) include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate, tris(4-chlorophenyl)sulfonium hexafluorophosphate, tris(2,4-dichlorophenyl)sulfonium hexafluorophosphate, bis(2,4-dichlorophenyl)phenylsulfonium hexafluorophosphate and bis(2,4-dichlorophenyl)-4-methoxyphenylsulfonium hexafluorophosphate.

Examples of the compound (iodonium salt) represented by formula (5) include diphenyliodonium hexafluorophosphate, 4-methoxyphenyl-4-(2-methylpropyl)phenyliodonium hexafluorophosphate, 4-chlorophenyl-4-phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium hexafluorophosphate.

Examples of the compound (azinium salt) represented by formula (6) include 1-cyclohexylmethyloxypyridinium hexafluorophosphate, 1-cyclohexyloxy-4-phenylpyridinium hexafluorophosphate, 1-methoxypyridinium hexafluorophosphate, 1 -methoxy-4-tert-butylpyridinium hexafluorophosphate, 1-methoxy-4-methoxypyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1 -(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The radical polymerization initiator can be preferably added in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area during printing are obtained. The radical polymerization initiator may be used only one kind or may be used in combination of two or more kinds thereof.

In addition to the iodonium salt, sulfonium salt and azinium salt, the organic boron compound (h) may be used together. For example, compounds described in Paragraph No. [0028] of JP-A-2008-195018 are preferred. Specific examples of these compounds are set forth below, but the invention should not be construed as being limited thereto.

Specific examples of the organic borate compound include a tetraphenylborate salt, a tetratolylborate salt, a tetrakis(4-methoxyphenyl)borate salt, a tetrakis(pentafluorophenyl)borate salt, a tetrakis(3,5-bis(trifluoromethyl)phenyl)borate salt, a tetrakis(4-chlorophenyl)borate salt, a tetrakis(4-fluorophenyl)borate salt, a tetrakis(2-thienyl)borate salt, a tetrakis(4-phenylphenyl)borate salt, a tetrakis(4-tert-butylphenyl)borate salt, an ethyltriphenylborate salt and a butyltriphenylborate salt. As a counter cation of the borate salt, a known cation, for example, an alkali metal cation, an alkaline earth metal cation, an ammonium cation, a phosphonium cation, a sulfonium cation, an iodonium cation, a diazonium cation or an azinium cation is exemplified.

(B) Radical polymerizable compound

The radical polymerizable compound for use in the image-recording layer according to the invention is an addition-polymerizable compound having at least one ethylenically unsaturated double bond and it is selected from compounds having at least one, preferably two or more, terminal ethylenically unsaturated double bonds. The radical

polymerizable compound has a chemical form, for example, a monomer, a prepolymer, specifically, a dimer, a trimer or an oligomer, or a mixture thereof.

Examples of the monomer include an unsaturated carboxylic acid (for example, acrylic acid, methacrylic acid, itaconic acid, crotonic acid, isocrotonic acid or maleic acid) and an ester or amide thereof. Preferably, an ester of an unsaturated carboxylic acid with a polyhydric alcohol compound and an amide of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of an unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether can also be used. These compounds are described in references including JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule described in JP-B-48-41708.

$$CH_2=C(R^4)COOCH_2CH(R^5)OH \qquad (A)$$

wherein $R^4$ and $R^5$ each represents H or $CH_3$.

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, an isocyanuric acid ethyleneoxide-modified acrylate, for example, tris(acryloyloxyethyl) isocyanurate or bis(acryloyloxyethyl) hydroxyethyl isocyanurate is particularly preferred from the standpoint of excellent balance between hydrophilicity relating to the on-press development property and polymerization ability relating to the printing durability.

Details of the method of using the polymerizable compound, for example, selection of the structure, individual or combination use or the addition amount can be appropriately determined in accordance with the characteristic design of the final lithographic printing plate precursor. The polymerizable compound is used preferably in a range from 5 to 75% by weight, more preferably in a range from 25 to 70% by weight, particularly preferably in a range from 30 to 60% by weight, based on the total solid content of the image-recording layer.

(C) Polyfunctional polymerization inhibitor

The polyfunctional polymerization inhibitor refers to a compound which has, in a molecule thereof, two or more radical trapping sites to form a covalent bond by directly connecting with a radical (R·).

The polyfunctional polymerization inhibitor preferably has, in a molecule thereof, from 2 to 10 radical trapping

sites, more preferably from 2 to 8 radical trapping sites, particularly preferably from 2 to 6 radical trapping sites.

Polyfunctional polymerization inhibitor + nR· →
Polyfunctional polymerization inhibitor-(R)n
(n ≥ 2)

The polyfunctional polymerization inhibitor preferably has a center skeleton B and n number of the radical trapping sites.

B-[Radical trapping site]$_n$

In the formula above, B represents an n-valent organic group, and n represents an integer of 2 or more.

[Radical trapping site]

The radical trapping site includes a benzoquinone site, optionally in combination with an N-oxyl free radical site, a 2-mercaptobenzothiazole site, a 2-mercaptobenzoxazole site, a 2-mercaptobenzimidazole site, a nitroso site and a nitro site shown below.

As the polyfunctional polymerization inhibitor according to the invention, a polyfunctional polymerization inhibitor having, in a molecule thereof, as the radical trapping sites, two or more benzoquinone sites is used.

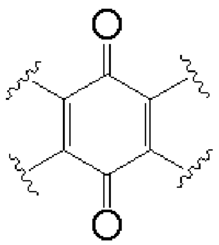
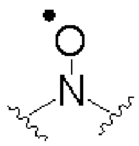
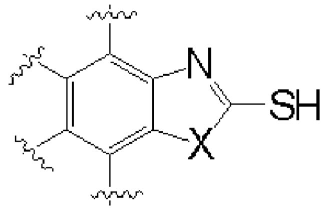
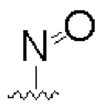
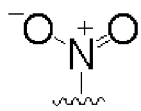

(X is S, O or NH)

[Center skeleton B]

The center skeleton B is an n-valent organic group, and n is an integer of 2 or more. Examples of the center skeleton B include structures shown below and organic group constituted by combination of the structures. n is preferably an integer from 2 to 10, more preferably an integer from 2 to 8, and particularly preferably an integer from 2 to 6.

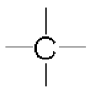
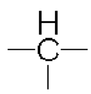
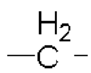
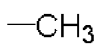
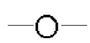
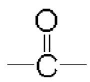

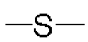
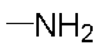
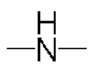
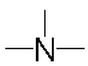
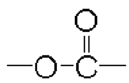
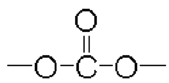
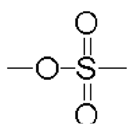

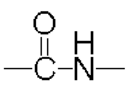
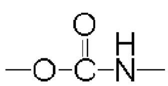
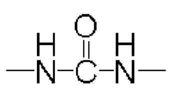

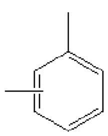
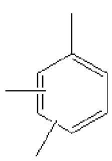
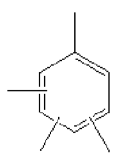
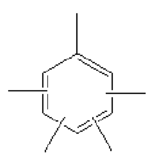
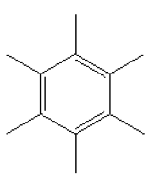
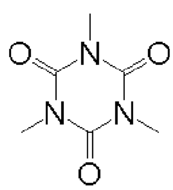

Polyvalent naphthalene, Polyvalent anthracene

It is preferred that the center skeleton B contains at least any of a benzene skeleton, an isocyanuric skeleton (a residue obtained by eliminating at least one hydrogen atom from isocyanuric acid) and an ester skeleton. It is more preferred to contain an ester skeleton.

The polyfunctional polymerization inhibitor is preferably obtained by a reaction of a compound having the radical trapping site and a hydroxy group, an amino group, a carboxyl group, an isocyanate group, a thioisocyanate group or a mercapto group with a polyfunctional alcohol, a polyfunctional carboxylic acid, a polyfunctional amine, a polyfunctional isocyanate, a polyfunctional alcoholamine or a polyfunctional thiol, which corresponds to the center skeleton B, or an addition reaction of an α,β-unsaturated carbonyl compound having the radical trapping site with a polyfunctional thiol.

The polyfunctional polymerization inhibitor and the synthesis method thereof are not particularly limited and, for example, the embodiments described below can be used.

[N-oxy free radical site]

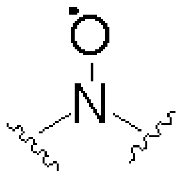

The N-oxy free radical site has the structure shown above.

The N-oxy free radical site is preferably a 4-substituted-2,2,6,6-tetramethylpiperidin-1-oxyl free radical site shown below.

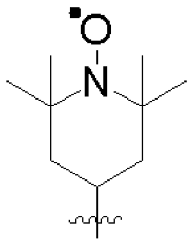

Further, the N-oxyl free radical site is more preferably a 4-oxy-2,2,6,6-tetramethylpiperidin-1-oxyl free radical site shown below.

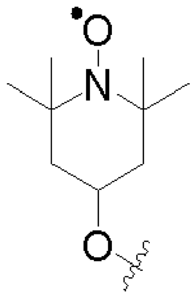

Specific examples of the compound (hereinafter, also referred to as a "raw material compound") which can be used as a raw material for introducing the N-oxyl free radical site into the polyfunctional polymerization inhibitor are set forth below as T-1 to T-7, but the invention should not be construed as being limited thereto.

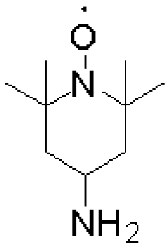

T-1

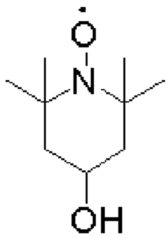

T-2

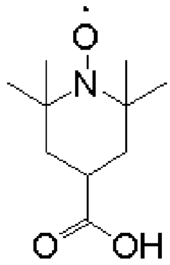

T-3

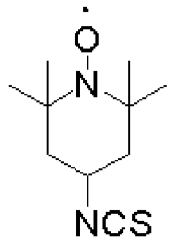

T-4

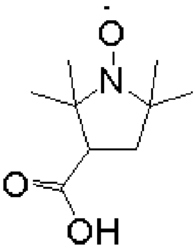

T-5

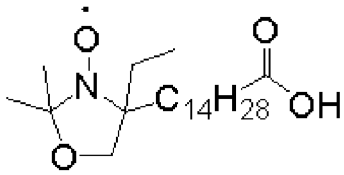

T-6

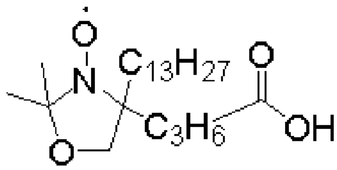

T-7

Of the compounds, T-1, T-2, T-3, T-4 and T-5 are preferred, T-1, T-2, T-3 and T-4 are more preferred, and T-1, T-2 and T-3 are particularly preferred.

[Benzoquinone site]

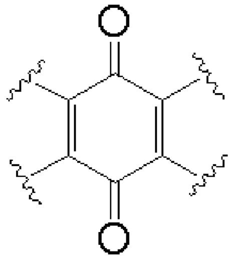

The benzoquinone site has the structure shown above.

The benzoquinone site is preferably the structure shown below.

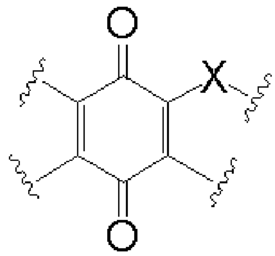

In the formula above, X represents S or NH. X is preferably S.

As specific examples of the raw material compound for introducing the benzoquinone site into the polyfunctional polymerization inhibitor, the raw material compounds having the benzoquinone site are set forth below, but the invention should not be construed as being limited thereto.

1,4-Benzoquinone, 2-chloro-1,4-benzoquinone, 2-bromo-1,4-benzoquinone, p-toluquinone, 2-tert-butyl-1,4-benzoquinone, p-xyloquinone, m-xyloquinone, 2,5-dichloro-1,4-benzoquinone, 2,5-dibromo-1,4-benzoquinone, 2,6-dichloro-1,4-benzoquinone, 2,6-dibromo-1,4-benzoquinone, 2-chloro-5-methyl-p-quinone, 2-bromo-5-methyl-1,4-benzoquinone, methoxybenzoquinone, 2,5-dihydroxy-1,4-benzoquinone, 2,5-dimethoxy-1,4-benzoquinone, 2,6-dimethoxy-1,4-benzoquinone, 2,3-dimethoxy-5-methyl-1,4-benzoquinone, chloranil, bromanil, 1,4-naphthoquinone, 1,4-chrysenequinone, 2-methyl-1,4-naphthoquinone, 2,3-dichloro-1,4-naphthoquinone, 2-hydroxy-1,4-naphthoquinone, 5-hydroxy-1,4-naphthoquinone, 5,8-dihydroxy-1,4-naphthoquinone, plumbagin, 2-amino-3-chloro-1,4-naphthoquinone, 2,3-dichloro-5,8-dihydroxy-1,4-naphthoquinone, 2,3-dichloro-6-nitro-1,4-naphthoquinone and 2,3-dichloro-5-nitro-1,4-naphthoquinone are exemplified.

Of the compounds, 1,4-benzoquinone, 2-chloro-1,4-benzoquinone, 2-bromo-1,4-benzoquinone, p-toluquinone, 2-tert-butyl-1,4-benzoquinone, p-xyloquinone, m-xyloquinone, 2,5-dichloro-1,4-benzoquinone, 2,5-dibromo-1,4-benzoquinone, 2,6-dichloro-1,4-benzoquinone, 2,6-dibromo-1,4-benzoquinone, 2-chloro-5-methyl-p-quinone, 2-bromo-5-methyl-1,4-benzoquinone, chloranil, bromanil, 1,4-naphthoquinone, 1,4-chrysenequinone, 2-methyl-1,4-naphthoquinone, 2,3-dichloro-1,4-naphthoquinone, 2-hydroxy-1,4-naphthoquinone, 5-hydroxy-1,4-naphthoquinone, 5,8-dihydroxy-1,4-naphthoquinone, 2-amino-3-chloro-1,4-naphthoquinone, 2,3-dichloro-5,8-dihydroxy-1,4-naphthoquinone, 2,3-dichloro-6-nitro-1,4-naphthoquinone and 2,3-dichloro-5-nitro-1,4-naphthoquinone are preferred, 1,4-benzoquinone, 2-chloro-1,4-benzoquinone, p-toluquinone, 2-tert-butyl-1,4-benzoquinone, p-xyloquinone, m-xyloquinone, 2,5-dichloro-1,4-benzoquinone, 2,6-dichloro-1,4-benzoquinone, 2-chloro-5-methyl-p-quinone, chloranil, 1,4-naphthoquinone, 2,3-dichloro-1,4-naphthoquinone, 2-hydroxy-1,4-naphthoquinone, 5,8-dihydroxy-1,4-naphthoquinone, 2-amino-3-chloro-1,4-naphthoquinone and 2,3-dichloro-5,8-dihydroxy-1,4-naphthoquinone are more preferred, and 1,4-benzoquinone, 2-chloro-1,4-benzoquinone, 2,5-dichloro-1,4-benzoquinone, 2,6-dichloro-1,4-benzoquinone, 2-chloro-5-methyl-p-quinone, chloranil, 2,3-dichloro-1,4-naphthoquinone, 2-amino-3-chloro-1,4-naphthoquinone and 2,3-dichloro-5,8-dihydroxy-1,4-naphthoquinone are particularly preferred.

The benzoquinone site may be introduced by, for example, an addition reaction of a thiol group between the raw material compound having the benzoquinone site described above and a carboxylic acid having a thiol group, an alcohol having a thiol group or an amine having a thiol group, or an addition reaction of an amino group between the raw material compound having the benzoquinone site described above and a carboxylic acid having an amino group or an alcohol having an amino group.

As specific examples of the carboxylic acid having a thiol group, the alcohol having a thiol group, the amine having a thiol group, the carboxylic acid having an amino group and the alcohol having an amino group, the compounds are set forth below, but the invention should not be construed as being limited thereto.

Specific examples of a monocarboxylic acid having one thiol group include mercaptoacetic acid, 3-mercaptopropionic acid, 2-mercaptopropionic acid, 3-mercaptoisobutyric acid, N-acetylcysteine, N-(2-mercaptopropionyl)glycine and thiosalicylic acid.

Of the compounds, mercaptoacetic acid, 3-mercaptopropionic acid, 2-mercaptopropionic acid, 3-mercaptoisobutyric acid, N-acetylcysteine and N-(2-mercaptopropionyl)glycine are preferred, 3-mercaptopropionic acid, 2-mercaptopropionic acid, 3-mercaptoisobutyric acid, N-acetylcysteine and N-(2-mercaptopropionyl)glycine are more preferred, and 3-mercaptopropionic acid, 3-mercaptoisobutyric acid, N-acetylcysteine and N-(2-mercaptopropionyl)glycine are particularly preferred.

Specific examples of the alcohol having a thiol group include 2-mercaptoethanol (1), 1-mercapto-2-propanol (1), 3-mercapto-1-propanol (1), 3-mercapto-2-butanol (1), 2,3-dimercapto-1-propanol (2) and 4-hydroxythiophenol (1).

Of the compounds, 2-mercaptoethanol (1), 3-mercapto-1-propanol (1) and 2,3-dimercapto-1-propanol (2) are preferred, 2-mercaptoethanol (1) and 3-mercapto-1-propanol (1) are more preferred, and 3-mercapto-1-propanol (1) is particularly preferred. Herein, the number shown in parentheses denotes a number of the functional groups.

Specific examples of the amine having one or more thiol groups, as the amine having a thiol group, include 2-aminoethanethiol, 2-aminothiophenol, 3-aminothiophenol and 4-aminothiophenol.

Of the compounds, 2-aminoethanethiol and 4-aminothiophenol are preferred, and 2-aminoethanethiol is more preferred.

Specific examples of the carboxylic acid having an amino group include glycine, 3-aminopropanoic acid, 4-aminobutanoic acid, 5-aminopentanoic acid, 6-aminohexanoic acid, 7-aminoheptanoic acid, 8-aminooctanoic acid, 12-aminododecanoic acid, DL-norvaline, 3-aminocyclohexanecarboxylic acid, 4-aminocyclohexanecarboxylic acid, 4-(aminomethyl)cyclohexanecarboxylic acid, 5-amino-2-methylbenzoic acid, 4-aminobenxoic acid, 6-amino-2-naphthoic acid, 4-(methylamino)benzoic acid, 3-aminobenzoic acid, 2-aminobenzoic acid, 4-amino-3-methylbenzoic acid, 4-amino-2-methylbenzoic acid, 3-amino-4-methylbenzoic acid, 4-amino-3-chlorobenzoic acid, 4-(aminomethyl)benzoic acid, 4-amino-2-chlorobenzoic acid, 2-(2-aminophenyl)ethanol and 4-aminophenyl acetic acid.

Specific examples of the alcohol having an amino group include 2-aminoethanol, 3-amino-1-propanol, 4-amino-1-butanol, 5-amino-1-pentanol, 6-amino-1-hexanol, 8-amino-1-octanol, 10-amino-1-decanol, 12-amino-1-dodecanol, 4-aminophenol, 5-amino-1-naphthol, 8-amino-2-naphthol, 5-amino-2-naphthol, 6-amino-1-naphthol, 3-aminophenol, 2-aminophenol, 2-aminophenol, 4-amino-m-cresol, 4-amino-2,6-dichlorophenol, 4-amino-2-chlorophenol, 4-amino-o-cresol, 4-amino-3-fluorophenol, 4-amino-3,5-xylenol, 4-amino-2-fluorophenol, 2-amino-5-chlorophenol, 5-amino-o-cresol, 2-amino-4-chlorophenol, 5-amino-2-chlorophenol, 4-(aminomethyl)phenol, 2-hydroxy-N-methylbenzylamine, 2-(4-hydroxyphenyl)ethylamine, 4-aminobenzyl alcohol, 2-aminobenzyl alcohol, 3-aminobenzyl alcohol and 2-(4-aminophenyl)ethanol.

As specific examples of the compound obtained by an addition reaction of a thiol group between the benzoquinone raw material compound and a carboxylic acid having a thiol group, an alcohol having a thiol group or an amine having a thiol group, or an addition reaction of an amino group between the benzoquinone raw material compound and a carboxylic acid having an amino group or an alcohol having an amino group, the compounds are set forth below, but the invention should not be construed as being limited thereto.

In the table below, the symbol which indicates the specific example (for example, BQ-1) is a symbol which denotes a compound obtained by a reaction between the corresponding raw material compound having the benzoquinone site described above (for example, 1,4-benzoquinone) and the corresponding carboxylic acid having a thiol group or the like described above (for example, 3-mercaptopropionic acid).

TABLE 1

| Raw Material Compound Having Benzoquinone Site | Carboxylic Acid Having Thiol Group | | | Alcohol Having Thiol Group | | Amine Having Thiol Group | Carboxylic Acid Having Amino Group | Alcohol Having Amino Group |
|---|---|---|---|---|---|---|---|---|
| | 3-Mercaptopropionic Acid | 3-Mercaptoisobutyric Acid | N-Acetylcysteine | 2-Mercaptoethanol | 3-Mercapto-1-propanol | 2-Aminoethanethiol | 3-Aminopropanoic Acid | 2-Aminoethanol |
| 1,4-Benzoquinone | BQ-1 | RQ-2 | RQ-3 | RQ-4 | RQ-5 | RQ-6 | RQ-7 | RQ-8 |
| 2-Chloro-1,4-benzoquinone | BQ-9 | RQ-10 | RQ-11 | RQ-12 | RQ-13 | RQ-14 | RQ-15 | RQ-16 |
| 2-tert-Butyl-1,4-benzoquinone | BQ-17 | RQ-18 | RQ-19 | RQ-20 | RQ-21 | RQ-22 | RQ-23 | RQ-24 |
| Chloranil | BQ-25 | RQ-26 | RQ-27 | RQ-28 | RQ-29 | RQ-30 | RQ-31 | RQ-32 |
| p-Toluquinone | BQ-33 | RQ-34 | RQ-35 | RQ-36 | RQ-37 | RQ-38 | RQ-39 | RQ-40 |
| 1,4-Naphthoquinone | BQ-41 | RQ-42 | RQ-43 | RQ-44 | RQ-45 | RQ-46 | RQ-47 | RQ-48 |
| 2-Methyl-1,4-naphthoquinone | BQ-49 | RQ-50 | RQ-51 | RQ-52 | RQ-53 | RQ-54 | RQ-55 | RQ-56 |
| 2,3-Dichloro-1,4-naphthoquinone | BQ-57 | RQ-58 | RQ-59 | RQ-60 | RQ-61 | RQ-62 | RQ-63 | RQ-64 |

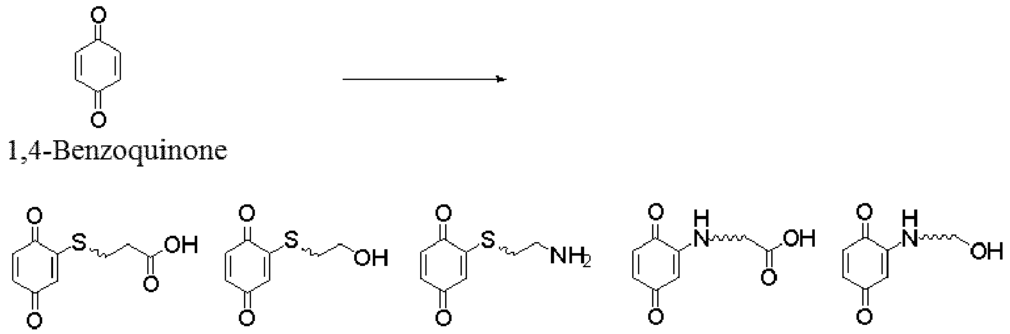

1,4-Benzoquinone

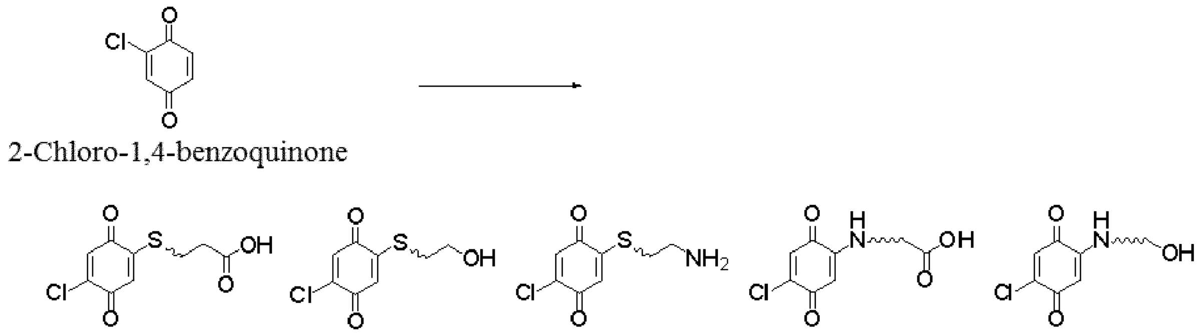

2-Chloro-1,4-benzoquinone

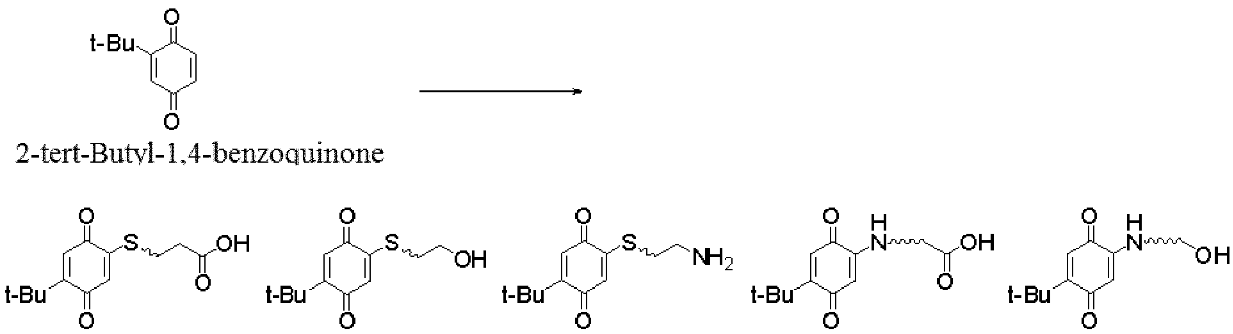

2-tert-Butyl-1,4-benzoquinone

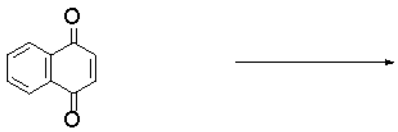

1,4-Naphthoquinone

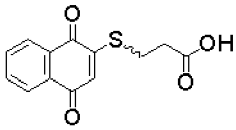 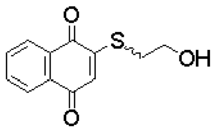 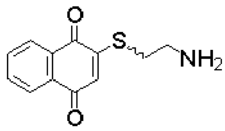 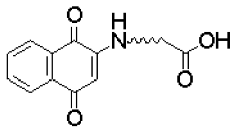 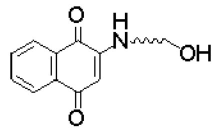

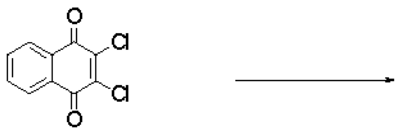

2,3-Dichloro-1,4-naphthoquinone

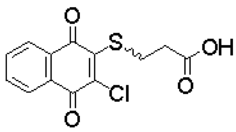 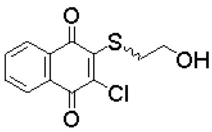 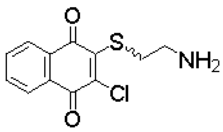 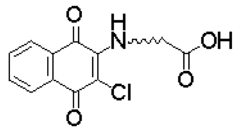 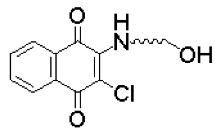

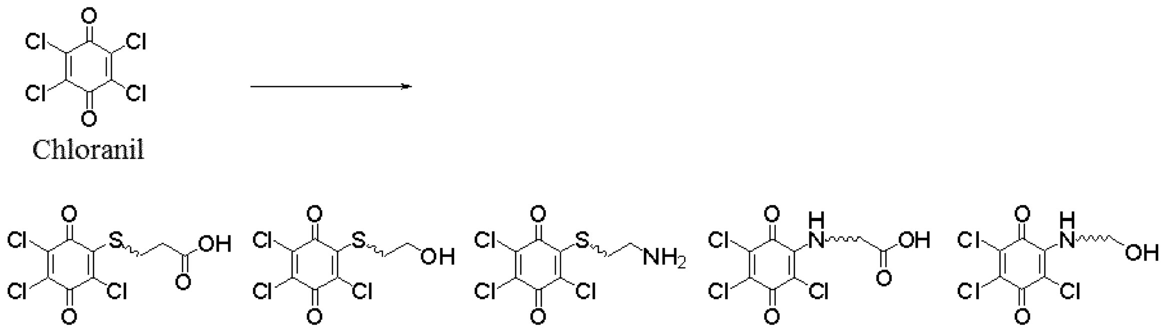

Chloranil

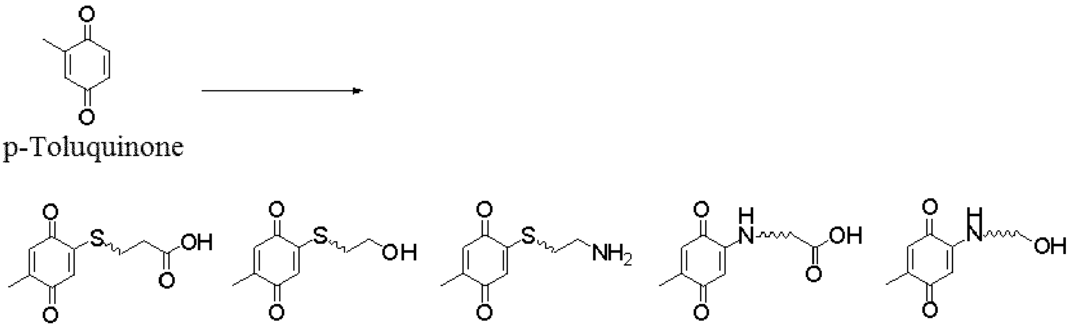

p-Toluquinone

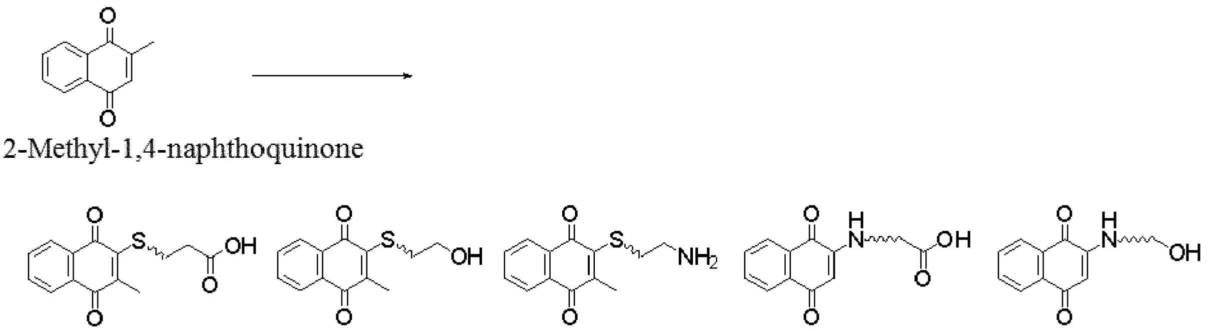

2-Methyl-1,4-naphthoquinone

[2-Mercaptobenzothiazole site]

As specific examples of the raw material compound for introducing the 2-mercaptobenzothiazole site into the polyfunctional polymerization inhibitor, the compounds are set forth below, but the invention should not be construed as being limited thereto.

6-Amino-2-mercaptobenzothiazole (MB-1), 6-hydroxy-2-mercaptobenzothiazole (MB-2), 2-mercapro-5-benzothiazolecarboxylic acid (MB-3) [2-Mercaptobenzoxazole site]

As specific examples of the raw material compound for introducing the 2-mercaptobenzoxazole site into the polyfunctional polymerization inhibitor, the compounds are set forth below, but the invention should not be construed as being limited thereto.

6-Amino-2-mercaptobenzoxazole (MB-4), 6-hydroxy-2-mercaptobenzoxazole (MB-5), 2-mercapro-5-benzoxazolecarboxylic acid (MB-6)

[2-Mercaptobenimidazole site]

As specific examples of the raw material compound for introducing the 2-mercaptobenimidazole site into the polyfunctional polymerization inhibitor, the compounds are set forth below, but the invention should not be construed as being limited thereto.

2-Mercapro-5-benzimidazolecarboxylic acid (MB-7), 5-amino-2-mercaptobenzimidazole (MB-8), 5-hydroxy-2-mercaptobenzimidazole (MB-9)

[Nitroso site]

As specific examples of the raw material compound for introducing the nitroso site into the polyfunctional polymerization inhibitor, the compounds are set forth below, but the invention should not be construed as being limited thereto.

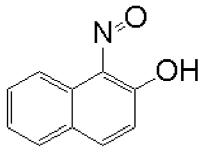

NO-1

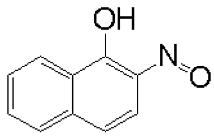

NO-2

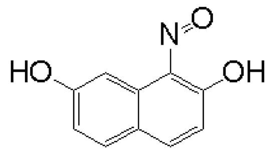

NO-3

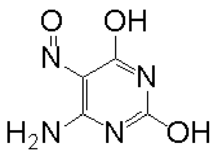

NO-4

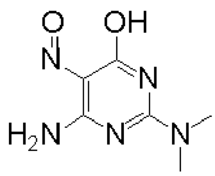

NO-5

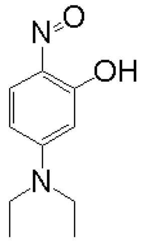

NO-6

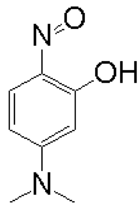

NO-7

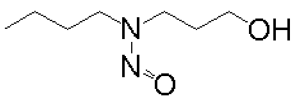

NO-8

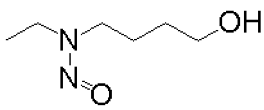

NO-9

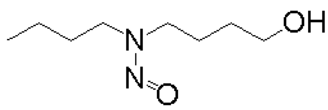

NO-10

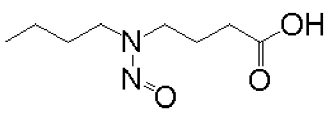

NO-11

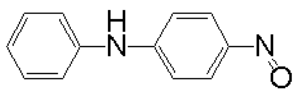

NO-12

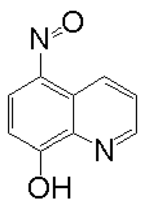

NO-13

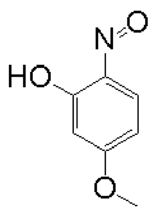

NO-14

Of the compounds described above, NO-1, NO-2, NO-3, NO-8, NO-9, NO-10, NO-11, NO-12, NO-13 and NO-14 are preferred, NO-1, NO-2, NO-3, NO-11, NO-12, NO-13 and NO-14 are more preferred, and NO-1, NO-2, NO-12, NO-13 and NO-14 are particularly preferred.

[Nitro site]

As specific examples of the raw material compound for introducing the nitro site into the polyfunctional polymerization inhibitor, the compounds are set forth below, but the invention should not be construed as being limited thereto.

[0098]

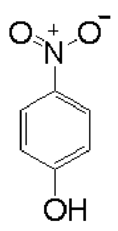

NI-1

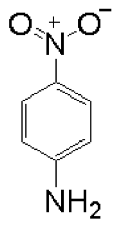

NI-2

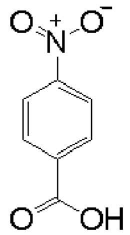

NI-3

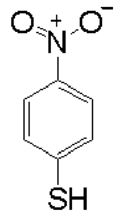

NI-4

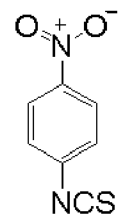

NI-5

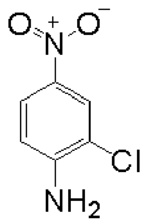

NI-6

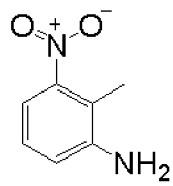

NI-7

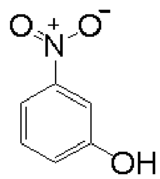

NI-8

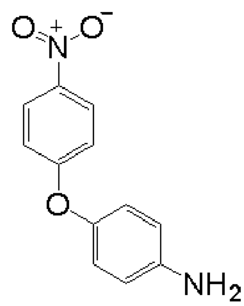

NI-9

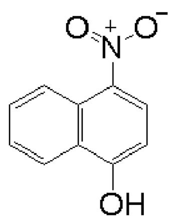

NI-10

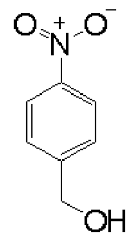

NI-11

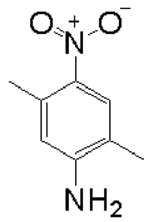

NI-12

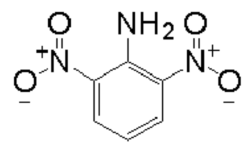

NI-13

Of the compounds described above, NI-1, NI-2, NI-3, NI-6, NI-7, NI-8, NI-9, NI-10, NI-11 and NI-12 are preferred, NI-1, NI-2, NI-3, NI-6, NI-8, NI-9 and NI-10 are more preferred, and NI-1, NI-2, NI-3, NI-9 and NI-10 are particularly preferred.

As described above, the polyfunctional polymerization inhibitor is preferably obtained by a reaction of a hydroxy group, an amino group, a carboxyl group, an isocyanate group, a thioisocyanate group or a mercapto group of the raw material compound with a polyfunctional alcohol, a polyfunctional carboxylic acid, a polyfunctional amine, a polyfunctional isocyanate, a polyfunctional alcoholamine or polyfunctional thiol, which corresponds to the center skeleton B, or an addition reaction of a polyfunctional thiol to an $\alpha,\beta$-unsaturated carbonyl of the raw material compound. Specific examples of the compounds are set forth below, but the invention should not be construed as being limited thereto.

[Polyfunctional alcohol]

Specific examples of the polyfunctional alcohol include ethylene glycol (2), 1,3-propanediol (2), 1,4-butanediol (2), 1,5-pentanediol (2), 1,6-hexanediol diol (2), 1,7-heptane diol (2), 1,8-octane diol (2), 1,9-nonane diol (2), 1,10-decane diol (2), 1,12-dodecane diol (2), 1,16-hexadecanediol (2), 9,9-bis(4-hydroxyphenyl)fluorene (2), 2,2-bis(4-hydroxy-3-methylphenyl)propane (2), 2,2'-biphenol (2), bis(4-hydroxyphenyl)sulfone (2), 2,2-bis(4-hydroxyphenyl)propane (2), 4,4'-biphenol (2), (2), cyclohexanetriol (3), glycerol (3), 2-hydroxymethyl-1,3-propanediol (3), 1,1,1-tris(hydroxymethyl)ethane (3), 1,2,4-butanetriol (3), trimethylolpropane (3), 1,2,3-trihydroxyhexane (3), 1,2,6-trihydroxyhexane (3), 1,2,3-heptanetriol (3), pyrogallol (3), 1,2,4-benzenetriol (3), phloroglucinol (3), 1,1,1-tris(4-hydroxyphenyl)ethane (3), 1,3,5-tris(2-hydroxyethyl)isocyanurate (3), pentaerythritol (4), threitol (4), erythritol (4), xylulose (4), ribulose (4), quebrachitol (5), adonitol (5), arabitol (5), xylitol (5), catechin (5), epicatechine (5), inositol (6), sorbitol (6), mannitol (6), iditol (6), dulcitol

(6), dipentaerythritol (6) and tripentaerythritol (8). Herein, the number shown in parentheses denotes a number of the functional groups.

Of the polyfunctional alcohols, cyclohexanetriol (3), glycerol (3), 2-hydroxymethyl-1,3-propanediol (3), 1,1,1-tris(hydroxymethyl)ethane (3), trimethylolpropane (3), phloroglucinol (3), 1,1,1-tris(4-hydroxyphenyl)ethane (3), 1,3,5-tris(2-hydroxyethyl)isocyanurate (3), pentaerythritol (4), catechin (5), epicatechin (5), inositol (6), dipentaerythritol (6) and tripentaerythritol (8) are preferred, cyclohexanetriol, 2-hydroxymethyl-1,3-propanediol (3), 1,1,1-tris(hydroxymethyl)ethane (3), trimethylolpropane (3), phloroglucinol (3), 1,1,1-tris(4-hydroxyphenyl)ethane (3), 1,3,5-tris(2-hydroxyethyl)isocyanurate (3), pentaerythritol (4), catechin (5), epicatechin (5), inositol (6), dipentaerythritol (6) and tripentaerythritol (8) are more preferred, and 1,3,5-tris(2-hydroxyethyl)isocyanurate (3), pentaerythritol (4), catechin (5), epicatechin (5), inositol (6), dipentaerythritol (6) and tripentaerythritol (8) are particularly preferred.

The polyfunctional polymerization inhibitor having the center skeleton composed of a polyfunctional carboxylic acid is obtained by a dehydration condensation reaction of the polyfunctional carboxylic acid with a raw material compound having an alkoxy group or a dehydration condensation reaction of the polyfunctional carboxylic acid with a raw material compound having an amino group.

[Polyfunctional carboxylic acid]

Specific examples of the polyfunctional carboxylic acid include oxalic acid (2), malonic acid (2), methylmalonic acid (2), succinic acid (2), methylsuccinic acid (2), glutaric acid (2), adipic acid (2), pimelic acid (2), suberic acid (2), azelaic acid (2), sebacic acid (2), tricarballylic acid (3), 1,2,3,4-butanetetracarboxylic acid (4), aconitic acid (3), hexafluoroglutaric acid (2), malic acid (2), tartaric acid (2), citric acid (3), diglycolic acid (2), 3,6-dioxaoctanedicarboxylic acid (2), tetrahydrofuran-2,3,4,5-tetracarboxylic acid (4), mercaptosuccinic acid (2), thioglycolic acid (2), 2,2',2'',2'''-[1,2-ethanediylidenetetrakis(thio)]tetrakisacetic acid (4), 1,3,5-cyclohexanetricarboxylic acid (3), 1,2,3,4-cyclobutanetetracarboxylic acid (4), 1,2,3,4,5,6-cyclohexanehexacarboxylic acid (6), 1,2-phenylenediacetic acid (2), 1,2-phenylenedioxydiacetic acid (2), homophthalic acid (2), 1,3-phenylenediacetic acid (2), 4-carboxyphenoxyacetic acid (2), 1,4-phenylenediacetic acid (2), 1,4-phenylenedipropionic acid (2), phthalic acid (2), isophthalic acid (2), terephthalic acid (2), 1,2,3-benzenetricarboxylic acid (3), 1,2,4-benzenetricarboxylic acid (3), 1,3,5-benzenetricarboxylic acid (3), 1,2,4,5-benzenetetracarboxylic acid (4), mellitic acid (6) and 1,4,5,8-naphthalenetetracarboxylic acid (4). Herein, the number shown in parentheses denotes a number of the functional groups.

Of the polyfunctional carboxylic acids, tricarballylic acid (3), 1,2,3,4-butanetetracarboxylic acid (4), aconitic acid (3), citric acid (3), tetrahydrofuran-2,3,4,5-tetracarboxylic acid (4), mercaptosuccinic acid (2), 2,2',2'',2'''-[1,2-ethanediylidenetetrakis(thio)]tetrakisacetic acid (4), 1,3,5-cyclohexanetricarboxylic acid (3), 1,2,3,4-cyclobutanetetracarboxylic acid (4), 1,2,3,4,5,6-cyclohexanehexacarboxylic acid (6), 1,2-phenylenediacetic acid (2), 1,2-phenylenedioxydiacetic acid (2), 1,3-phenylenediacetic acid (2), 1,4-phenylenediacetic acid (2), 1,4-phenylenedipropionic acid (2), phthalic acid (2), isophthalic acid (2), terephthalic acid (2), 1,3,5-benzenetricarboxylic acid (3), 1,2,4,5-benzenetetracarboxylic acid (4), mellitic acid (6) and 1,4,5,8-naphthalenetetracarboxylic acid (4) are preferred, and tricarballylic acid (3), 1,2,3,4-butanetetracarboxylic acid (4), tetrahydrofuran-2,3,4,5-tetracarboxylic acid (4), mercaptosuccinic acid (2), 2,2',2'',2'''-[1,2-ethanediylidenetetrakis(thio)]tetrakisacetic acid (4), 1,3,5-cyclohexanetricarboxylic acid (3), 1,2,3,4-cyclobutanetetracarboxylic acid (4), 1,2,3,4,5,6-cyclohexanehexacarboxylic acid (6), 1,3,5-benzenetricarboxylic acid (3), 1,2,4,5-benzenetetracarboxylic acid (4), mellitic acid (6) and 1,4,5,8-naphthalenetetracarboxylic acid (4) are particularly preferred.

[Polyfunctional amine]

The polyfunctional polymerization inhibitor having the center skeleton composed of a polyfunctional amine is obtained by a dehydration condensation reaction of the polyfunctional amine with a raw material compound having a carboxyl group, an addition reaction of the polyfunctional amine with a raw material compound having an isocyanate group or an addition reaction of the polyfunctional amine with a raw material compound having a thioisocyanate group.

Specific examples of the polyfunctional amine include ethylenediamine (2), diethylenetriamine (3), N-(2-aminoethyl)-1,3-propanediamine (3), N-(3-aminopropyl)-1,3-propanediamine (3), spermidine (3), bis(hexamethylene)triamine (3), 4-(aminomethyl)-1,8-octanediamine (3), triethylenetetramine (4), 1,4,7,11-tetraazaundecane (4), N,N'-bis(3-aminopropyl)ethylenediamine (4), N,N'-bis(2-aminoethyl)-1,3-propanediamine (4), N,N'-bis(3-aminopropyl)-1,3-propanediamine (4), spermine (4), tris(2-aminoethyl)amine (3), tetraethylenepentamine (5), pentaethylenehexamine (6), 1,4,7-triazacyclononane (3), 1,5,9-triazacyclododecane (3), cyclene (4), 1,4,8,11-tetraazacyclotetradecane (4), 1,4,8,12-tetraazacyclopentadecane (4), hexacyclene (6), 3,3'-diaminobenzidine (4) and 1,2,4,5-benzenetetramine (4). Herein, the number shown in parentheses denotes a number of the functional groups.

Of the polyfunctional amines, 4-(aminomethyl)-1,8-octanediamine (3), triethylenetetramine (4), 1,4,7,11-tetraazaundecane (4), N,N'-bis(3-aminopropyl)ethylenediamine (4), N,N'-bis(2-aminoethyl)-1,3-propanediamine (4), N,N'-bis(3-aminopropyl)-1,3-propanediamine (4), spermine (4), tris(2-aminoethyl)amine (3), tetraethylenepentamine (5), pentaethylenehexamine (6), cyclene (4) and hexacyclene (6) are preferred, 4-(aminomethyl)-1,8-octanediamine (3), tris(2-aminoethyl)amine (3), tetraethylenepentamine (5), pentaethylenehexamine (6), cyclene (4) and hexacyclene (6) are more preferred, and tetraethylenepentamine (5), pentaethylenehexamine (6), cyclene (4) and hexacyclene (6) are particularly preferred.

The polyfunctional polymerization inhibitor having the center skeleton composed of a polyfunctional isocyanate is obtained by an urethanization reaction of the polyfunctional isocyanate with a raw material compound having an alkoxy group or an addition reaction of the polyfunctional isocyanate with a raw material compound having an amino group.

[Polyfunctional isocyanate]

Specific examples of the polyfunctional isocyanate include isophorone diisocyanate, m-phenylene diisocyanate, p-phenylene diisocyanate, 2,6-tolylene diisocyanate, 2,4-tolylene diisocyanate, naphthalene 1,4-diisocyanate, diphenylmethane 4,4'-diisocyanate, 3,3'-dimethoxybiphenyl diisocyanate, 3,3'-dimethyldiphenylmethane 4,4'-diisocyanate, xylylene 1,4-diisocyanate, xylylene 1,3-diisocyanate, 4-chloroxylylene 1,3-diisocyanate, 2-methylxylylene 1,3-diisocyanate, 4,4'-diphenylpropane diisocyanate, 4,4'-diphenylhexafluoropropane diisocyanate, trimethylene diisocyanate, hexamethylene diisocyanate, propylene 1,2-diisocyanate, butylene 1,2-diisocyanate, cyclohexylene 1,2-diisocyanate, cyclohexylene 1,3-diisocyanate, cyclohexylene 1,4-diisocyanate, dicyclohexylmethane 4,4'-diisocyanate, 1,4-bis(isocyanatemethyl)cyclohexane and 1,3-bis(isocyanatemethyl)cyclohexane.

Of the polyfunctional isocyanates, isophorone diisocyanate, 2,4-tolylene diisocyanate, 2,6-tolylene diisocyanate, xylylene 1,4-diisocyanate and xylylene 1,3-diisocyanate are preferred. Further, polyfunctional adducts using these compounds as the main raw material, for example, trimers (biuret or isocyanurate) of these compounds, adducts (addition products) of these compounds with polyols, for example, trimethylolpropane, or formalin condensate of benzene isocyanate are also preferred. Of the compounds described above, isophorone diisocyanate, 2,4-tolylene diisocyanate, 2,6-tolylene diisocyanate, xylylene 1,4-diisocyanate and xylylene 1,3-diisocyanate are preferred.

These compounds are described in Polyurethane Resin Handbook (edited by Keiji Iwata, published by Nikkan Kogyo Shimbun, Ltd. (1987)).

The polyfunctional polymerization inhibitor having the center skeleton composed of a polyfunctional alcoholamine is obtained by a dehydration condensation reaction of the polyfunctional alcoholamine with a raw material compound having a carboxyl group, an addition reaction of the polyfunctional alcoholamine with a raw material compound having an isocyanate group or an addition reaction of the polyfunctional alcoholamine with a raw material compound having a thioisocyanate group.

[Polyfunctional alcoholamine]

Specific examples of the polyfunctional alcoholamine include diethanolamine (3), serinol (3), diisopropanolamine (3), 2-amino-2-ethyl-1,3-propanediol (3), 2-amino-2-methyl-1,3-propanediol (3), tris(hydroxymethyl)aminomethane (4), bishomotris (4), 1,3-diamino-2-hydroxypropane (3), 2-(2-aminoethylamino)ethanol (3), N,N'-bis(2-hydroxyethyl)ethylenediamine (4), 1,3-bis[tris(hydroxymethyl)methylamino]propane (8), 1-amino-1-deoxy-D-sorbitol (6), N-methyl-D-glucamine (6), 2,3-diaminophenol (3), 4-aminoresorcinol (3), norphenylephrine (3), octopamine (3), synephrine (3), 3,4-dihydroxybenzylamine (3), 3-hydroxytyramine (3), norepinephrine (4), 5-hydroxydopamine (4) and 6-hydroxydopamine (4). Herein, the number shown in parentheses denotes a number of the functional groups.

Of the polyfunctional alcoholamines, serinol (3), 2-amino-2-methyl-1,3-propanediol (3), tris(hydroxymethyl)aminomethane (4), bishomotris (4), 1,3-diamino-2-hydroxypropane (3), N,N'-bis(2-hydroxyethyl)ethylenediamine (4), 1,3-bis[tris(hydroxymethyl)methylamino]propane (8), 1-amino-1-deoxy-D-sorbitol (6), N-methyl-D-glucamine (6), norepinephrine (4), 5-hydroxydopamine (4) and 6-hydroxydopamine (4) are preferred, and tris(hydroxymethyl)aminomethane (4), bishomotris (4), N,N'-bis(2-hydroxyethyl)ethylenediamine (4), 1,3-bis[tris(hydroxymethyl)methylamino]propane (8), 1-amino-1-deoxy-D-sorbitol (6), N-methyl-D-glucamine (6), norepinephrine (4), 5-hydroxydopamine (4) and 6-hydroxydopamine (4) are particularly preferred.

The polyfunctional polymerization inhibitor having the center skeleton composed of a polyfunctional thiol is obtained by a Michael addition reaction of the polyfunctional thiol with a raw material compound, an addition reaction of the polyfunctional thiol with a raw material compound having an isocyanate group or an addition reaction of the polyfunctional thiol with a raw material compound having a thioisocyanate group.

[Polyfunctional thiol]

As specific examples of the polyfunctional thiol, the compounds are set forth below, but the invention should not be construed as being limited thereto.

1,2-Ethane dithiol, 1,3-propane dithiol, 1,4-butane dithiol, 1,6-hexane dithiol, 1,8-octane dithiol, 1,10-decane

dithiol and 3,6-dioxa-1,8-octane dithiol.

The polyfunctional thiol is a compound obtained by reacting an electrophilic agent, for example, a halide, a sulfonic acid ester of alcohol, with a sulfurizing agent, for example, thiourea, potassium thiocyanate or thioacetic acid and then conducting various treatments.

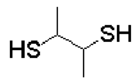

S-1

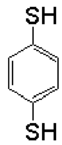

S-2

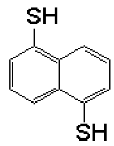

S-3

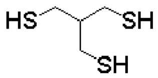

S-4

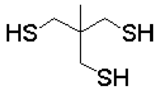

S-5

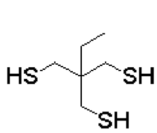

S-6

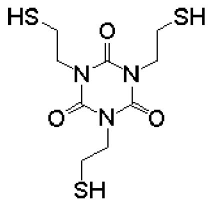

S-7

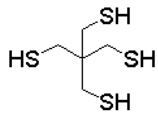

S-8

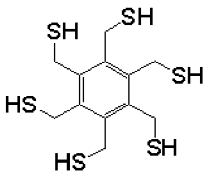

S-9

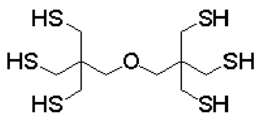

S-10

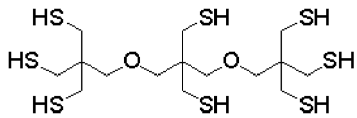

S-11

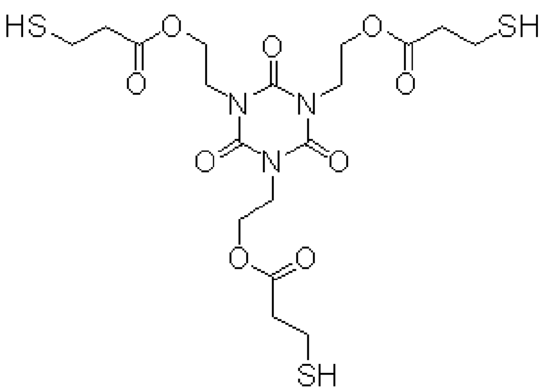

S-12

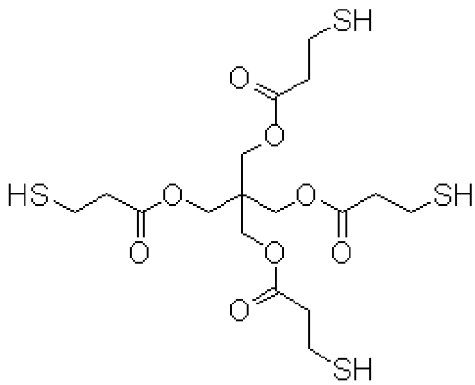

S-13

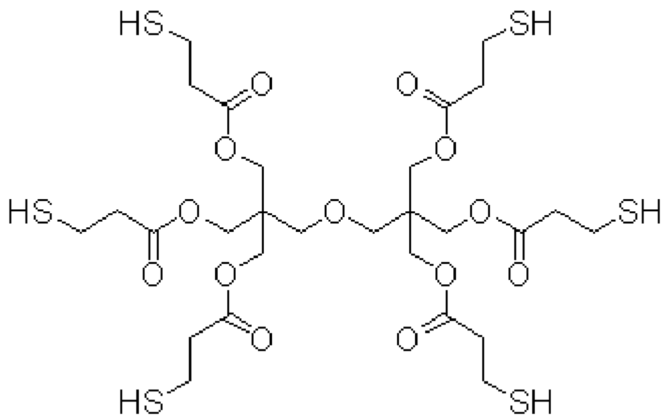

S-14

[Synthesis of polyfunctional polymerization inhibitor having N-oxy free radical site - reference embodiments]

The polyfunctional polymerization inhibitor having an N-oxy free radical site is obtained by a dehydration condensation reaction, an addition reaction or etherification between the raw material compound having an N-oxy free radical site and a polyfunctional alcohol, a polyfunctional carboxylic acid, a polyfunctional amine, a polyfunctional alcoholamine, a polyfunctional isocyanate or a polyfunctional thiol.

The reaction by which the polyfunctional polymerization inhibitor is synthesized depending on the functional group of the raw material compound having an N-oxy free radical site is shown below.

TABLE 2

| Polyfunctional Body | Functional Group of Raw Material Compound Having N-Oxy Free Radical Site | | | |
|---|---|---|---|---|
| | Carboxylic Acid | Hydroxy Group | Amine | Thioisocyanate |
| Polyfunctional Alcohol | Dehydration Condensation | Etherification | -- | Addition Reaction |
| Polyfunctional Carboxylic Acid | -- | Dehydration Condensation | Dehydration Condensation | -- |
| Polyfunctional Amine | Dehydration Condensation | Dehydration Condensation | -- | Addition Reaction |
| Polyfunctional Isocyanate | -- | Addition Reaction | Addition Reaction | -- |
| Polyfunctional Alcoholamine | Dehydration Condensation | -- | -- | Addition Reaction |
| Polyfunctional Thiol | Dehydration Condensation | -- | -- | Addition Reaction |

Specific examples of the polyfunctional polymerization inhibitor having an N-oxy free radical site are set forth below..

In the table below, the symbol which indicates the specific example (for example, PFT-1) is a symbol which denotes a compound obtained by a reaction between the corresponding raw material compound having the N-oxy free radical site described above (for example, T-1) and the corresponding polyfunctional carboxylic acid or the like described above (for example, terephthalic acid). Also, the polyfunctional polymerization inhibitor in the table below is a compound obtained by reacting all of the functional groups of the polyfunctional body (mother skeleton) with the raw material compound.

TABLE 3

| Mother Skeleton | | Raw Material Compound Having N-Oxy Free Radical Site | | | | | | |
|---|---|---|---|---|---|---|---|---|
| Number of Functional Groups Shown in () | | T-1 | T-2 | T-3 | T-4 | T-5 | T-6 | T-7 |
| Polyfunctional Alcohol | Ethylene Glycol (2) | -- | PFT-10 | PFT-26 | PFT-39 | PFT-52 | PFT-65 | PFT-78 |
| | Cyclohexanetriol (3) | -- | PFT-11 | PFT-27 | PFT-40 | PFT-53 | PFT-66 | PFT-79 |
| | 1,3,5-Tris(2-hydroxyethyl) isocyanurate(3) | -- | PFT-12 | PFT-28 | PFT-41 | PFT-54 | PFT-67 | PFT-80 |
| | 1,1,1-Tris(4-hydroxyphenyl) ethane (3) | -- | PFT-13 | PFT-29 | PFT-42 | PFT-55 | PFT-68 | PFT-81 |
| | Pentaerythritol (4) | -- | PFT-14 | PFT-30 | PFT-43 | PFT-56 | PFT-69 | PFT-82 |
| | Dipentaerythritol (6) | -- | PFT-15 | PFT-31 | PFT-44 | PFT-57 | PFT-70 | PFT-83 |
| | Tripentaerythritol (8) | -- | PFT-16 | PFT-32 | PFT-45 | PFT-58 | PFT-71 | PFT-84 |
| Polyfunctional Carboxylic Acid | Terephthalic Acid (2) | PFT-1 | PFT-17 | -- | -- | -- | -- | -- |
| | 1,3,5-Cyclohexanetricarboxylic Acid (3) | PFT-2 | PFT-18 | -- | -- | -- | -- | -- |
| | 1,3,5-Benzenetricarboxylic Acid (3) | PFT-3 | PFT-19 | -- | -- | -- | -- | -- |
| | 1,2,3,4-Butanetetracarboxylic Acid (4) | PFT-4 | PFT-20 | -- | -- | -- | -- | -- |
| | 1,2,4,5-Benzenetetracarboxylic Acid (4) | PFT-5 | PFT-21 | -- | -- | -- | -- | -- |
| | 1,4,5,8-Naphthalenetetracarboxylic Acid (4) | PFT-6 | PFT-22 | -- | -- | -- | -- | -- |
| | Mellitic Acid (6) | PFT-7 | PFT-23 | -- | -- | -- | -- | -- |
| Polyfunctional Amine | 4,4'-Diamino-3,3'-dimethylbiphenyl (2) | -- | -- | PFT-33 | PFT-46 | PFT-59 | PFT-72 | PFT-85 |
| | Tris(2-aminoethyl)amine (3) | -- | -- | PFT-34 | PFT-47 | PFT-60 | PFT-73 | PFT-86 |
| | 3,3'-Diaminobenzidine (4) | -- | -- | PFT-35 | PFT-48 | PFT-61 | PFT-74 | PFT-87 |
| Polyfunctional Isocyanate | Isophorone Diisocyanate (2) | PFT-8 | PFT-24 | -- | -- | -- | -- | -- |
| | Tris(isocyanatehexyl) Isocyanurate (3) | PFT-9 | PFT-25 | -- | -- | -- | -- | -- |

(continued)

| Mother Skeleton<br>Number of Functional Groups Shown in () | | Raw Material Compound Having N-Oxy Free Radical Site | | | | | | |
|---|---|---|---|---|---|---|---|---|
| | | T-1 | T-2 | T-3 | T-4 | T-5 | T-6 | T-7 |
| Polyfunctional Alcoholamine | Tris(hydroxymethyl) aminomethane (4) | -- | -- | PFT-36 | PFT-49 | PFT-62 | PFT-75 | PFT-88 |
| | N-Methyl-D-glucamine (6) | -- | -- | PFT-37 | PFT-50 | PFT-63 | PFT-76 | PFT-89 |
| Polyfunctional Thiol | S-12(3) | -- | -- | PFT-38 | PFT-51 | PFT-64 | PFT-77 | PFT-90 |

[Synthesis of polyfunctional polymerization inhibitor having benzoquinone site]

The polyfunctional polymerization inhibitor having a benzoquinone site is obtained by a dehydration condensation reaction, an addition reaction or etherification between the raw material compound having a benzoquinone site and a polyfunctional alcohol, a polyfunctional carboxylic acid, a polyfunctional amine, a polyfunctional alcoholamine, a polyfunctional isocyanate or a polyfunctional thiol.

The reaction by which the polyfunctional polymerization inhibitor is synthesized depending on the functional group of the raw material compound having a benzoquinone site is shown below.

TABLE 4

| Polyfunctional Body | Functional Group of Raw Material Compound Having Benzoquinone Site | | | |
|---|---|---|---|---|
| | None | Carboxylic Acid | Hydroxy Group | Amine |
| Polyfunctional Alcohol | -- | Dehydration Condensation | Etherification | -- |
| Polyfunctional Carboxylic Acid | -- | -- | Dehydration Condensation | Dehydration Condensation |
| Polyfunctional Amine | Addition Reaction | Dehydration Condensation | Dehydration Condensation | |
| Polyfunctional Isocyanate | -- | -- | Addition Reaction | Addition Reaction |
| Polyfunctional Alcoholamine | -- | Dehydration Condensation | -- | -- |
| Polyfunctional Thiol | Addition Reaction | Dehydration Condensation | -- | -- |

Specific examples of the polyfunctional polymerization inhibitor having a benzoquinone site are set forth below.

In the table below, the symbol which indicates the specific example (for example, PFBQ-1) is a symbol which denotes a compound obtained by a reaction between the corresponding raw material compound having the benzoquinone site described above (for example, benzoquinone) and the corresponding polyfunctional amine or the like described above (for example, 4,4'-diamino-3,3'-dimethylbiphenyl). Also, the polyfunctional polymerization inhibitor in the table below is a compound obtained by reacting all of the functional groups of the polyfunctional body (mother skeleton) with the raw material compound.

TABLE 5

| Mother Skeleton Number of Functional Groups Shown in () | | Raw Material Compound Having Benzoquinone Site | | | | | | | | | | | | | |
|---|---|---|---|---|---|---|---|---|---|---|---|---|---|---|---|
| | | Benzoquinone | Chloranil | BQ-1 | BQ4 | BQ-6 | BQ-7 | BQ-8 | BQ-14 | BQ-26 | BQ-31 | BQ-34 | BQ-45 | BQ-52 | BQ-60 |
| Polyfunctional Alcohol | Ethylene Glycol (2) | -- | -- | PFBQ-9 | PFBQ-20 | -- | PFBQ-45 | PFBQ-56 | -- | PFBQ-81 | PFBQ-94 | PFBQ-107 | PFBQ-120 | PFBQ-136 | PFBQ-152 |
| | Cyclohexanetriol (3) | -- | -- | PFBQ-10 | PFBQ-21 | -- | PFBQ-46 | PFBQ-57 | -- | PFBQ-82 | PFBQ-95 | PFBQ-108 | PFBQ-121 | PFBQ-137 | PFBQ-153 |
| | 1,3,5-Tris(2-hydroxyethyl)is ocyanurate (3) | -- | -- | PFBQ-11 | PFBQ-22 | -- | PFBQ-47 | PFBQ-58 | -- | PFBQ-83 | PFBQ-96 | PFBQ-109 | PFBQ-122 | PFBQ-138 | PFBQ-154 |
| | 1,1,1-Tris(4-hydroxyphenyl) ethane (3) | -- | -- | PFBQ-12 | PFBQ-23 | -- | PFBQ-48 | PFBQ-59 | -- | PFBQ-84 | PFBQ-97 | PFBQ-110 | PFBQ-123 | PFBQ-139 | PFBQ-155 |
| | Pentaerythritol (4) | -- | -- | PFBQ-13 | PFBQ-24 | -- | PFBQ-49 | PFBQ-60 | -- | PFBQ-85 | PFBQ-98 | PFBQ-111 | PFBQ-124 | PFBQ-140 | PFBQ-156 |
| | Dipentaerythritol (6) | -- | -- | PFBQ-14 | PFBQ-25 | -- | PFBQ-50 | PFBQ-61 | -- | PFBQ-86 | PFBQ-99 | PFBQ-112 | PFBQ-125 | PFBQ-141 | PFBQ-157 |
| | Tripentaerythritol (8) | -- | -- | PFBQ-15 | PFBQ-26 | -- | PFBQ-51 | PFBQ-62 | -- | PFBQ-87 | PFBQ-100 | PFBQ-113 | PFBQ-126 | PFBQ-142 | PFBQ-158 |
| Polyfunctional Carboxylic Acid | Terephthalic Add (2) | -- | -- | -- | PFBQ-27 | PFBQ-36 | -- | PFBQ-63 | PFBQ-72 | -- | -- | -- | PFBQ-127 | PFBQ-143 | PFBQ-159 |
| | 1,3,5-Cyclohexanetricarbox ylic Acid (3) | -- | -- | -- | PFBQ-28 | PFBQ-37 | -- | PFBQ-64 | PFBQ-73 | -- | -- | -- | PFBQ-128 | PFBQ-144 | PFBQ-160 |
| | 1,3,5-Benzenetricarboxylic Acid (3) | -- | -- | -- | PFBQ-29 | PFBQ-38 | -- | PFBQ-65 | PFBQ-74 | -- | -- | -- | PFBQ-129 | PFBQ-145 | PFBQ-161 |

(continued)

| Mother Skeleton Number of Functional Groups Shown in () | | Raw Material Compound Having Benzoquinone Site | | | | | | | | | | | | | |
|---|---|---|---|---|---|---|---|---|---|---|---|---|---|---|---|
| | | Benzoquinone | Chloranil | BQ-1 | BQ4 | BQ-6 | BQ-7 | BQ-8 | BQ-14 | BQ-26 | BQ-31 | BQ-34 | BQ-45 | BQ-52 | BQ-60 |
| | 1,2,3,4-Butanetetracarboxyl ic Acid (4) | -- | -- | -- | PFBQ-30 | PFBQ-39 | -- | PFBQ-66 | PFBQ-75 | -- | -- | -- | PFBQ-130 | PFBQ-146 | PFBQ-162 |
| | 1,2,4,5-Benzenetetracarbo xylic Add (4) | -- | -- | -- | PFBQ-31 | PFBQ-40 | -- | PFBQ-67 | PFBQ-76 | -- | -- | -- | PFBQ-131 | PFBQ-147 | PFBQ-163 |
| | 1,4,5,8-Naphthalenetetraca rboxylic Acid (4) | -- | -- | -- | PFBQ-32 | PFBQ-41 | -- | PFBQ-68 | PFBQ-77 | -- | -- | -- | PFBQ-132 | PFBQ-148 | PFBQ-164 |
| | Mellitic Add (6) | -- | -- | -- | PFBQ-33 | PFBQ-42 | -- | PFBQ-69 | PFBQ-78 | -- | -- | -- | PFBQ-133 | PFBQ-149 | PFBQ-165 |
| Polyfunctional Amine | 4,4'-Diamino-3,3'-dimethylb iphenyl (2) | PFBQ-1 | PFBQ-5 | PFBQ-16 | -- | -- | PFBQ-52 | -- | -- | PFBQ-88 | PFBQ-101 | PFBQ-114 | -- | -- | -- |
| | Tris(2-aminoethyl) amine (3) | PFBQ-2 | PFBQ-6 | PFBQ-17 | -- | -- | PFBQ-53 | -- | -- | PFBQ-89 | PFBQ-102 | PFBQ-115 | -- | -- | -- |
| | 3,3'-Diaminobenzidine (4) | PFBQ-3 | PFBQ-7 | PFBQ-18 | -- | -- | PFBQ-54 | -- | -- | PFBQ-90 | PFBQ-103 | PFBQ-116 | -- | -- | -- |
| Polyfunctional Isocyanate | Isophorone Diisocyanate (2) | -- | -- | -- | PFBQ-34 | PFBQ-43 | -- | PFBQ-70 | PFBQ-79 | -- | -- | -- | PFBQ-134 | PFBQ-150 | PFBQ-166 |
| | Tris(isocyanatehexyl) Isocyanurate (3) | -- | -- | -- | PFBQ-35 | PFBQ-44 | -- | PFBQ-71 | PFBQ-80 | -- | -- | -- | PFBQ-135 | PFBQ-151 | PFBQ-167 |
| Polyfunctional Alcoholamine | Tris(hydroxymethyl) amino methane (4) | -- | -- | -- | -- | -- | -- | -- | -- | PFBQ-91 | PFBQ-104 | PFBQ-117 | -- | -- | -- |
| | N-Methyl-D-glucamine (6) | -- | -- | -- | -- | -- | -- | -- | -- | PFBQ-92 | PFBQ-105 | PFBQ-118 | -- | -- | -- |
| Polyfunctional Thiol | S-12 (3) | PFBQ-4 | PFBQ-8 | PFBQ-19 | -- | -- | PFBQ-55 | -- | -- | PFBQ-93 | PFBQ-106 | PFBQ-119 | -- | -- | -- |

[Synthesis of polyfunctional polymerization inhibitor having benzothiazole site, benzoxazole site or benzimidazole site - reference embodiments]

The polyfunctional polymerization inhibitor having a benzothiazole site, a benzoxazole site or a benzimidazole site is obtained by a dehydration condensation reaction, an addition reaction or etherification between the raw material compound having a 2-mercaptobenzothiazole site, a 2-mercaptobenzoxazole site or a 2-mercaptobenzimidazole site and a polyfunctional alcohol, a polyfunctional carboxylic acid, a polyfunctional amine, a polyfunctional alcoholamine, a polyfunctional isocyanate or a polyfunctional thiol.

The reaction by which the polyfunctional polymerization inhibitor is synthesized depending on the functional group of the raw material compound having a benzothiazole site, a benzoxazole site or a benzimidazole site is shown below.

TABLE 6

| Polyfunctional Body | Functional Group of Raw Material Compound Having 2-Mercaptobenzothiazole Site, 2-Mercaptobenzoxazole Site or 2-Mercaptobenzimidazole site | | |
|---|---|---|---|
| | Carboxylic Acid | Hydroxy Group | Amine |
| Polyfunctional Alcohol | Dehydration Condensation | Etherification | -- |
| Polyfunctional Carboxylic Acid | -- | Dehydration Condensation | Dehydration Condensation |
| Polyfunctional Amine | Dehydration Condensation | Dehydration Condensation | |
| Polyfunctional Isocyanate | -- | Addition Reaction | Addition Reaction |
| Polyfunctional Alcoholamine | Dehydration Condensation | -- | -- |
| Polyfunctional Thiol | Dehydration Condensation | -- | -- |

Specific examples of the polyfunctional polymerization inhibitor having a 2-mercaptobenzothiazole site, a 2-mercaptobenzoxazole site or a 2-mercaptobenzimidazole site are set forth below as reference embodiments.

In the table below, the symbol which indicates the specific example (for example, PFMB-1) is a symbol which denotes a compound obtained by a reaction between the corresponding raw material compound having the mercaptobenzothiazole site or the like described above (for example, 6-amino-2-mercaptobenzothiazole (MB-1)) and the corresponding polyfunctional carboxylic acid or the like described above (for example, terephthalic acid). Also, the polyfunctional polymerization inhibitor in the table below is a compound obtained by reacting all of the functional groups of the polyfunctional body (mother skeleton) with the raw material compound.

TABLE 7

| Mother Skeleton Number of Functional Groups Shown in () | | Raw Material Compound Having 2-Mercaptobenzothiazole Site, 2-Mercaptobenzoxazole Site or 2-Mercaptobenzimidazole Site | | | | | | | | |
|---|---|---|---|---|---|---|---|---|---|---|
| | | MB-1 | MB-2 | MB-3 | MB-4 | MB-5 | MB-6 | MB-7 | MB-8 | MB-9 |
| Polyfunctional Alcohol | Ethylene Glycol (2) | -- | PFMB-10 | PFMB-26 | -- | PFMB-48 | PFMB-64 | PFMB-77 | -- | PFMB-99 |
| | Cyclohexanetriol (3) | -- | PFMB-11 | PFMB-27 | -- | PFMB-49 | PFMB-65 | PFMB-78 | -- | PFMB-100 |
| | 1,3,5-Tris(2-hydroxyethyl) isocya nurate (3) | -- | PFMB-12 | PFMB-28 | -- | PFMB-50 | PFMB-66 | PFMB-79 | -- | PFMB-101 |
| | 1,1,1-Tris(4-hydroxyphenyl)etha ne (3) | -- | PFMB-13 | PFMB-29 | -- | PFMB-51 | PFMB-67 | PFMB-80 | -- | PFMB-102 |
| | Pentaerythritol (4) | -- | PFMB-14 | PFMB-30 | -- | PFMB-52 | PFMB-68 | PFMB-81 | -- | PFMB-103 |
| | Dipentaerythritol (6) | -- | PFMB-15 | PFMB-31 | -- | PFMB-53 | PFMB-69 | PFMB-82 | -- | PFMB-104 |
| | Tripentaerythritol (8) | -- | PFMB-16 | PFMB-32 | -- | PFMB-54 | PFMB-70 | PFMB-83 | -- | PFMB-105 |

(continued)

| Mother Skeleton Number of Functional Groups Shown in () | | Raw Material Compound Having 2-Mercaptobenzothiazole Site, 2-Mercaptobenzoxazole Site or 2-Mercaptobenzimidazole Site | | | | | | | | |
|---|---|---|---|---|---|---|---|---|---|---|
| | | MB-1 | MB-2 | MB-3 | MB-4 | MB-5 | MB-6 | MB-7 | MB-8 | MB-9 |
| Polyfunctional Carboxylic Acid | Terephthalic Acid (2) | PFMB-1 | PFMB-17 | -- | PFMB-39 | PFMB-55 | -- | -- | PFMB-90 | PFMB-106 |
| | 1,3,5-Cyclohexanetricarboxylic Acid (3) | PFMB-2 | PFMB-18 | -- | PFMB-40 | PFMB-56 | -- | -- | PFMB-91 | PFMB-107 |
| | 1,3,5-BenzenetricarboxylicAcid (3) | PFMB-3 | PFMB-19 | -- | PFMB-41 | PFMB-57 | -- | -- | PFMB-92 | PFMB-108 |
| | 1,2,3,4-Butanetetracarboxylic Acid (4) | PFMB-4 | PFMB-20 | -- | PFMB-42 | PFMB-58 | -- | -- | PFMB-93 | PFMB-109 |
| | 1,2,4,5-Benzenetetracarboxylic Acid (4) | PFMB-5 | PFMB-21 | -- | PFMB-43 | PFMB-59 | -- | -- | PFMB-94 | PFMB-110 |
| | 1,4,5,8-Naphthalenetetracarboxylic Acid (4) | PFMB-6 | PFMB-22 | -- | PFMB-44 | PFMB-60 | -- | -- | PFMB-95 | PFMB-111 |
| | Mellitic Acid (6) | PFMB-7 | PFMB-23 | -- | PFMB-45 | PFMB-61 | -- | -- | PFMB-96 | PFMB-112 |
| Polyfunctional Amine | 4,4'-Diamino-3,3'-dimethylbiphe nyl (2) | -- | -- | PFMB-33 | -- | -- | PFMB-71 | PFMB-84 | -- | PFMB-113 |
| | Tris(2-aminoethyl)amine (3) | -- | -- | PFMB-34 | -- | -- | PFMB-72 | PFMB-85 | -- | PFMB-114 |
| | 3,3'-Diaminobenzidine (4) | -- | -- | PFMB-35 | -- | -- | PFMB-73 | PFMB-86 | -- | PFMB-115 |
| Polyfunctional Isocyanate | Isophorone Diisocyanate (2) | PFMB-8 | PFMB-24 | -- | PFMB-46 | PFMB-62 | -- | -- | PFMB-97 | PFMB-116 |
| | Tris(isocyanatehexyl) Isocyanurate (3) | PFMB-9 | PFMB-25 | -- | PFMB-47 | PFMB-63 | -- | -- | PFMB-98 | PFMB-117 |

(continued)

| Mother Skeleton Number of Functional Groups Shown in () | | Raw Material Compound Having 2-Mercaptobenzothiazole Site, 2-Mercaptobenzoxazole Site or 2-Mercaptobenzimidazole Site | | | | | | | | |
|---|---|---|---|---|---|---|---|---|---|---|
| | | MB-1 | MB-2 | MB-3 | MB-4 | MB-5 | MB-6 | MB-7 | MB-8 | MB-9 |
| Polyfunctional Alcoholamine | Tris(hydroxymethyl) aminometha ne (4) | -- | -- | PFMB-36 | -- | -- | PFMB-74 | PFMB-87 | -- | PFMB-118 |
| | N-Methyl-D-glucamine (6) | -- | -- | PFMB-37 | -- | -- | PFMB-75 | PFMB-88 | -- | PFMB-119 |
| Polyfunctional Thiol | S-12 (3) | -- | -- | PFMB-38 | -- | -- | PFMB-76 | PFMB-89 | -- | PFMB-120 |

[Synthesis of polyfunctional polymerization inhibitor having nitroso site - reference embodiments]

The polyfunctional polymerization inhibitor having a nitroso site is obtained by a dehydration condensation reaction, an addition reaction or etherification between the raw material compound having a nitro site and a polyfunctional alcohol, a polyfunctional carboxylic acid, a polyfunctional amine, a polyfunctional alcoholamine, a polyfunctional isocyanate or a polyfunctional thiol.

TABLE 8

| Polyfunctional Body | Functional Group of Raw Material Compound Having Nitroso Site | | | |
|---|---|---|---|---|
| | None | Carboxylic Acid | Hydroxy Group | Amine |
| Polyfunctional Alcohol | -- | Dehydration Condensation | Etherification | -- |
| Polyfunctional Carboxylic Acid | -- | -- | Dehydration Condensation | Dehydration Condensation |
| Polyfunctional Amine | Addition Reaction | Dehydration Condensation | Dehydration Condensation | |
| Polyfunctional Isocyanate | -- | -- | Addition Reaction | Addition Reaction |
| Polyfunctional Alcoholamine | -- | Dehydration Condensation | -- | -- |
| Polyfunctional Thiol | Addition Reaction | Dehydration Condensation | -- | -- |

Specific examples of the polyfunctional polymerization inhibitor having a nitroso site are set forth below as reference embodiments. In the table below, the symbol which indicates the specific example (for example, PFNO-1) is a symbol which denotes a compound obtained by a reaction between the corresponding raw material compound having the nitro site described above (for example, NO-2) and the corresponding polyfunctional alcohol or the like described above (for example, ethylene glycol). Also, the polyfunctional polymerization inhibitor in the table below is a compound obtained by reacting all of the functional groups of the polyfunctional body (mother skeleton) with the raw material compound.

TABLE 9

| Mother Skeleton Number of Functional Groups Shown in () | | Raw Material Compound Having Nitroso Site | |
|---|---|---|---|
| | | NO-2 | NO-12 |
| Polyfunctional Alcohol | Ethylene Glycol (2) | PFNO-1 | -- |
| | Cyclohexanetriol (3) | PFNO-2 | -- |
| | 1,3,5-Tris(2-hydroxyethyl)isocyanurate (3) | PFNO-3 | -- |
| | 1,1,1-Tris(4-hydroxyphenyl)ethane (3) | PFNO-4 | -- |
| | Pentaerythritol (4) | PFNO-5 | -- |
| | Dipentaerythritol (6) | PFNO-6 | -- |
| | Tripentaerythritol (8) | PFNO-7 | -- |

(continued)

| Mother Skeleton Number of Functional Groups Shown in () | | Raw Material Compound Having Nitroso Site | |
|---|---|---|---|
| | | NO-2 | NO-12 |
| Polyfunctional Carboxylic Acid | Terephthalic Acid (2) | PFNO-8 | PFNO-17 |
| | 1,3,5-Cyclohexanetricarboxylic Acid (3) | PFNO-9 | PFNO-18 |
| | 1,3,5-Benzenetricarboxylic Acid (3) | PFNO-10 | PFNO-19 |
| | 1,2,3,4-Butanetetracarboxylic Acid (4) | PFNO-11 | PFNO-20 |
| | 1,2,4,5-Benzenetetracarboxylic Acid (4) | PFNO-12 | PFNO-21 |
| | 1,4,5,8-Naphthalenetetracarboxylic Acid (4) | PFNO-13 | PFNO-22 |
| | Mellitic Acid (6) | PFNO-14 | PFNO-23 |
| Polyfunctional Amine | 4,4'-Diamino-3,3'-dimethylbiphenyl (2) | -- | -- |
| | Tris(2-aminoethyl)amine (3) | -- | -- |
| | 3,3'-Diaminobenzidine (4) | -- | -- |
| Polyfunctional Isocyanate | Isophorone Diisocyanate (2) | PFNO-15 | PFNO-24 |
| | Tris(isocyanatehexyl) Isocyanurate (3) | PFNO-16 | PFNO-25 |
| Polyfunctional Alcoholamine | Tris(hydroxymethyl)aminomethane (4) | -- | -- |
| | N-Methyl-D-glucamine (6) | -- | -- |
| Polyfunctional Thiol | S-12 (3) | -- | -- |

[Synthesis of polyfunctional polymerization inhibitor having nitro site - reference embodiments]

The polyfunctional polymerization inhibitor having a nitro site is obtained by a dehydration condensation reaction, an addition reaction or etherification between the raw material compound having a nitro site and a polyfunctional alcohol, a polyfunctional carboxylic acid, a polyfunctional amine, a polyfunctional alcoholamine, a polyfunctional isocyanate or a polyfunctional thiol.

TABLE 10

| Polyfunctional Body | Functional Group of Raw Material Compound Having Nitro Site | | | |
|---|---|---|---|---|
| | Carboxylic Acid | Hydroxy Group | Amine | Thioisocyanate |
| Polyfunctional Alcohol | Dehydration Condensation | Etherification | -- | Addition Reaction |
| Polyfunctional Carboxylic Acid | -- | Dehydration Condensation | Dehydration Condensation | -- |
| Polyfunctional Amine | Dehydration Condensation | Dehydration Condensation | -- | Addition Reaction |
| Polyfunctional Isocyanate | -- | Addition Reaction | Addition Reaction | -- |
| Polyfunctional Alcoholamine | Dehydration Condensation | -- | -- | Addition Reaction |
| Polyfunctional Thiol | Dehydration Condensation | -- | -- | Addition Reaction |

Specific examples of the polyfunctional polymerization inhibitor having a nitro site are set forth below as reference

embodiments..

In the table below, the symbol which indicates the specific example (for example, PFNI-1) is a symbol which denotes a compound obtained by a reaction between the corresponding raw material compound having the nitro site described above (for example, NI-1) and the corresponding polyfunctional alcohol or the like described above (for example, ethylene glycol). Also, the polyfunctional polymerization inhibitor in the table below is a compound obtained by reacting all of the functional groups of the polyfunctional body (mother skeleton) with the raw material compound.

TABLE 11

| Mother Skeleton Number of Functional Groups Shown in () | | Raw Material Compound Having Nitro Site | | |
|---|---|---|---|---|
| | | NI-1 | NI-2 | NI-3 |
| Polyfunctional Alcohol | Ethylene Glycol (2) | PFNI-1 | -- | PFNI-26 |
| | Cyclohexanetriol (3) | PFNI-2 | -- | PFNI-27 |
| | 1,3,5-Tris(2-hydroxyethyl)isocyanurate (3) | PFNI-3 | -- | PFNI-28 |
| | 1,1,1-Tris(4-hydroxyphenyl)ethane (3) | PFNI-4 | -- | PFNI-29 |
| | Pentaerythritol (4) | PFNI-5 | -- | PFNI-30 |
| | Dipentaerythritol (6) | PFNI-6 | -- | PFNI-31 |
| | Tripentaerythritol (8) | PFNI-7 | -- | PFNI-32 |
| Polyfunctional Carboxylic Acid | Terephthalic Acid (2) | PFNI-8 | PFNI-17 | -- |
| | 1,3,5-Cyclohexanetricarboxylic Acid (3) | PFNI-9 | PFNI-18 | -- |
| | 1,3,5-Benzenetricarboxylic Acid (3) | PFNI-10 | PFNI-19 | - |
| | 1,2,3,4-Butanetetracarboxylic Acid (4) | PFNI-11 | PFNI-20 | -- |
| | 1,2,4,5-Benzenetetracarboxylic Acid (4) | PFNI-12 | PFNI-21 | -- |
| | 1,4,5,8-Naphthalenetetracarboxylic Acid (4) | PFNI-13 | PFNI-22 | -- |
| | Mellitic Acid (6) | PFNI-14 | PFNI-23 | |
| Polyfunctional Amine | 4,4'-Diamino-3,3'-dimethylbiphenyl (2) | -- | -- | PFNI-33 |
| | Tris(2-aminoethyl)amine (3) | -- | -- | PFNI-34 |
| | 3,3'-Diaminobenzidine (4) | -- | -- | PFNI-35 |
| Polyfunctional Isocyanate | Isophorone Diisocyanate (2) | PFNI-15 | PFNI-24 | -- |
| | Tris(isocyanatehexyl) Isocyanurate (3) | PFNI-16 | PFNI-25 | -- |
| Polyfunctional Alcoholamine | Tris(hydroxymethyl)aminomethane (4) | -- | -- | PFNI-36 |
| | N-Methyl-D-glucamine (6) | -- | -- | PFNI-37 |
| Polyfunctional Thiol | S-12 (3) | -- | -- | PFNI-38 |

The content of the polyfunctional polymerization inhibitor (C) is preferably from 0.1 to 20% by mole, more preferably from 1 to 15% by mole, particularly preferably from 1 to 10% by mole, to the radical polymerization initiator (A).

In particular, the content of the polyfunctional polymerization inhibitor having the N-oxyl free radical site is more preferably from 1 to 10% by mole, and particularly preferably from 1 to 8% by mole.

In particular, the content of the polyfunctional polymerization inhibitor having the benzoquinone site is more preferably from 2 to 15% by mole, and particularly preferably from 2 to 10% by mole.

[Components other than (A) radical polymerization initiator, (B) radical polymerizable compound and (C) polyfunctional polymerization inhibitor]

[(D) Sensitizing dye]

The image-recording layer of the lithographic printing plate precursor which can be used in the invention preferably contains a sensitizing dye.

The sensitizing dye which can be used in the invention is not particularly limited and known sensitizing dyes can be used. Of the sensitizing dyes, a sensitizing dye having an absorption wavelength in a range from 300 to 900 nm is preferred.

For instance, by adding a sensitizing dye having a maximum absorption in a range from 300 to 450 nm, a sensitizing dye having a maximum absorption in a range from 500 to 600 nm or a sensitizing dye having a maximum absorption in a range from 750 to 1,400 nm, a high-sensitive lithographic printing plate precursor corresponding to a violet laser of 405 nm, a green laser of 532 nm or an IR laser of 830 nm ordinarily used in the field of technology can be provided, respectively.

The sensitizing dye having an absorption maximum in a range from 750 to 1,400 preferably used in the invention is described in detail below.

In the invention, the "sensitizing dye having a maximum absorption in a range from 750 to 1,400 nm" is also referred to as an "infrared absorbing agent".

The infrared absorbing agent is preferably a dye or pigment having an absorption maximum in a wavelength range from 750 to 1,400 nm.

[IR dye]

An IR dye is a dye which has an absorption maximum in a range from 750 to 1,400 nm and excited by the infrared ray absorbed, and is also referred to as an infrared absorbing dye, infrared absorbing dye or infrared absorbing agent.

In the invention, the IR dye represented by formula (3) is used.

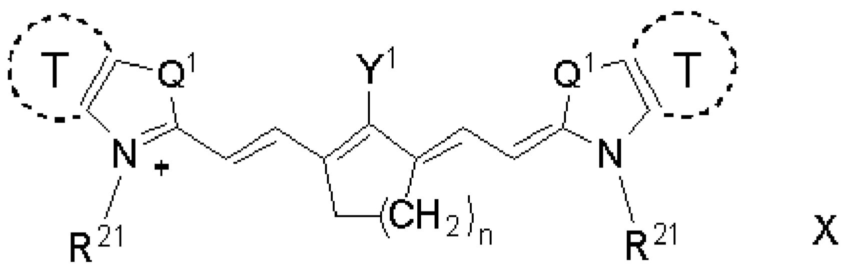

(3)

In formula (3), $R^{21}$ represents an alkyl group which may have a substituent, and plural $R^{21}$s may be the same or different. The alkyl group for $R^{21}$ is preferably an alkyl group having from 1 to 20 carbon atoms, more preferably an alkyl group having from 1 to 10 carbon atoms, and most preferably an alkyl group having from 1 to 4 carbon atoms.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, 1-methylbutyl group, an isohexyl group, a 2-ethylhexyl group, a 2-methylhexyl group, a cyclohexyl group, a cyclopentyl group and a 2-norbornyl group.

Of the alkyl groups, a methyl group, an ethyl group, a propyl group, a butyl group and a tert-butyl group are particularly preferred.

The substituent on the alkyl group is preferably $OR^{22}$, $O(CO)R^{22}$, $NR^{23}R^{24}$, $NR^{23}(CO)R^{22}$ or $SR^{25}$, more preferably $OR^{22}$ or $O(CO)R^{22}$, and most preferably $OR^{22}$. $R^{22}$ and $R^{25}$ each represents an alkyl group or an aryl group. $R^{23}$ and $R^{24}$ each represents a hydrogen atom, an alkyl group, an aryl group, an alkylcarbonyl group, an arylcarbonyl group, an alkoxycarbonyl group, an aminocarbonyl group or a sulfonyl group, or $R^{23}$ and $R^{24}$ may be combined with each other to form a ring structure.

$Y^1$ represents $OR^{12}$, $NR^{13}R^{14}$, $SR^{15}$ or a chlorine atom. $Y^1$ is more preferably $NR^{13}R^{14}$ or a chlorine atom, and most preferably $N(Ph)_2$. Herein, Ph represents a phenyl group.

$R^{12}$ represents an alkyl group or an aryl group. $R^{13}$ and $R^{14}$ each represents a hydrogen atom, an alkyl group, an aryl group, an alkylcarbonyl group, an arylcarbonyl group, an alkoxycarbonyl group, an aminocarbonyl group or an alkylsulfonyl group, or $R^{13}$ and $R^{14}$ may be combined with each other to form a ring structure. $R^{15}$ represents an alkyl group, an aryl group or a heterocyclic group.

The alkyl group represented by any one of $R^{12}$, $R^{13}$, $R^{14}$ and $R^{15}$ is preferably an alkyl group having from 1 to 20 carbon atoms, more preferably an alkyl group having from 1 to 10 carbon atoms, and most preferably an alkyl group having from 1 to 4 carbon atoms.

Specific examples of the alkyl group include a methyl group, an ethyl group, a propyl group, a butyl group, a

pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, 1-methylbutyl group, an isohexyl group, a 2-ethylhexyl group, a 2-methylhexyl group, a cyclohexyl group and a cyclopentyl group.

Of the alkyl groups, a methyl group, an ethyl group, a propyl group, a butyl group and a tert-butyl group are particularly preferred.

The aryl group represented by any of $R^{12}$, $R^{13}$, $R^{14}$ and $R^{15}$ is preferably an aryl group having from 6 to 30 carbon atoms, more preferably an aryl group having from 6 to 20 carbon atoms, and most preferably an aryl group having from 6 to 12 carbon atoms.

Specific examples of the aryl group include a phenyl group, a biphenyl group, a 1-naphthyl group, a 2-naphthyl group, an o-, m- or p-tolyl group, a xylyl group, a mesityl group, a p-chlorophenyl group, a p-fluorophenyl group, an o-chlorophenyl group, an o-fluorophenyl group, a p-methoxyphenyl group, a m-methoxyphenyl group, a p-dimethylaminophenyl group, a p-methylthiophenyl group, a m-methylthiophenyl group and p-phenyltiophenyl group. Of the aryl groups, a phenyl group, a p-methoxyphenyl group and a p-dimethylaminophenyl group are particularly preferred.

In the case where any of $R^{13}$ and $R^{14}$ represents an alkylcarbonyl group, an arylcarbonyl group, an alkoxycarbonyl group, an aminocarbonyl group or an alkylsulfonyl group, preferred embodiments of $R^{13}$ and $R^{14}$ are same as the preferred embodiments of $R^{13}$ and $R^{14}$ in formula (1).

The heterocyclic group represented by $R^{15}$ is preferably a 3-membered to 8-membered heterocyclic group, more preferably a 3-membered to 6-membered heterocyclic group containing a nitrogen atom, an oxygen atom or a sulfur atom, and most preferably a 5-membered or 6-membered heterocyclic group containing a nitrogen atom, an oxygen atom or a sulfur atom.

Specific examples of the heterocyclic group include, a pyrrole ring group, a furan ring group, a thiophene ring group, a benzopyrrole ring group, a benzofuran ring group, a benzothiophene ring group, a pyrazole ring group, an isoxazole ring group, an isothiazole ring group, an indazole ring group, a benzisoxazole ring, benzisothiazole ring group, an imidazole ring group, an oxazole ring group, a thiazole ring group, a benzimidazole ring group, a benzoxazole ring group, a benzothiazole ring group, a pyridine ring group, a quinoline ring group, an isoquinoline ring group, pyridazine ring group, a pyrimidine ring group, a pyrazine ring group, a phthalazine ring group, a quinazoline ring group, a quinoxaline ring group, aciridine ring, phenanthridine ring, carbazole ring group, a purine ring group, a pyran ring group, a piperidine ring group, piperazine ring group, a morpholine ring group, an indole ring group, an indolizine ring group, a chromene ring group, a cinnoline ring group, an acridine ring group, a phenothiazine ring group, a tetrazole ring group and a triazine ring group.

$Q^1$ represents a sulfur atom or a dimethylmethylene group, and plural $Q^1$s may be the same or different. T represents a benzene ring which may have a substituent or a naphthalene ring which may have a substituent, and plural Ts may be the same or different. T is more preferably a benzene ring. The substituent substituted on the ring is preferably an alkyl group, $OR^{12}$, $O(CO)R^{12}$, $NR^{13}R^{14}$, $NR^{13}(CO)R^{12}$, $SR^{15}$, $SO_3^-$ or a halogen atom, more preferably an alkyl group, $OR^{12}$ or a chlorine atom, and most preferably $OR^{12}$ or a chlorine atom. $R^{12}$ to $R^{15}$ have the same meanings as $R^{12}$ to $R^{15}$ in $Y^1$, and preferred embodiments are also the same. n represents an integer of 1 or 2. X represents a counter ion in order to maintain electrical neutrality of the IR dye represented by formula (3).

The IR dye for use in the invention is more preferably an IR dye represented by formula (8).

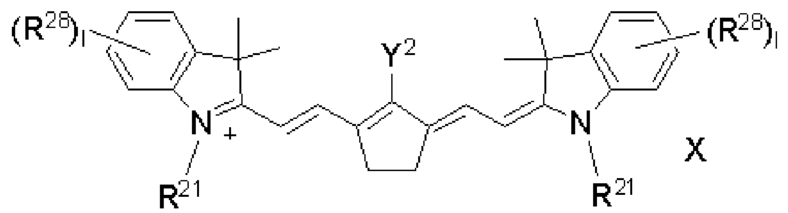

(8)

In formula (8), $R^{21}$ has the same meaning as $R^{21}$ in formula (3), and preferred embodiments are also the same. $Y^2$ represents $NR^{13}R^{14}$ or a chlorine atom, and $R^{13}$ and $R^{14}$ have the same meanings as $R^{13}$ and $R^{14}$ in formula (3). $Y^2$ is most preferably $N(Ph)_2$. Herein, Ph represents a phenyl group. $R^{28}$ represents an alkyl group, an alkoxy group or a chlorine atom, and plural $R^{28}$s may be the same or different. In the case where $R^{28}$ represents an alkyl group, preferred embodiments thereof are same as the preferred embodiment in the case where $R^{21}$ in formula (3) represents an alkyl group. In the case where $R^{28}$ represents an alkoxy group, it is represented by an alkyl group-O-, and preferred embodiments of the alkyl group is same as the preferred embodiment of the alkyl group in the case where $R^{21}$ represents the alkyl group. L represents an integer from 0 to 2, and is more preferably 1. X has the same meaning as X in formula (3).

Above all, the IR dye for use in the invention is most preferably an IR dye represented by formula (9).

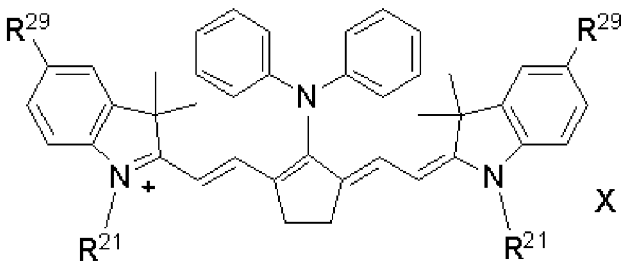

(9)

In formula (9), $R^{29}$ represents a hydrogen atom, a methyl group or a chlorine atom, and plural $R^{29}$s may be the same or different. $R^{21}$ has the same meaning as $R^{21}$ in formula (3), and preferred embodiments are also the same. X represents a counter ion in order to maintain electrical neutrality of the IR dye represented by formula (9). When X is a cation chemical species, a sodium cation, a potassium cation, an ammonium cation or a pyridinium cation is preferred, a sodium cation or an ammonium cation is more preferred, and an ammonium cation is most preferred. When X is an anion chemical species, a halide ion, a perchlorate ion, a tetrafluoroborate ion, a hexafluorophosphate ion or a sulfonate ion is more preferred, and a perchlorate ion, a tetrafluoroborate ion, a hexafluorophosphate ion or an arylsulfonate ion is particularly preferred.

Preferred specific examples of the IR dye are set forth below, but the invention should not be construed as being limited thereto.

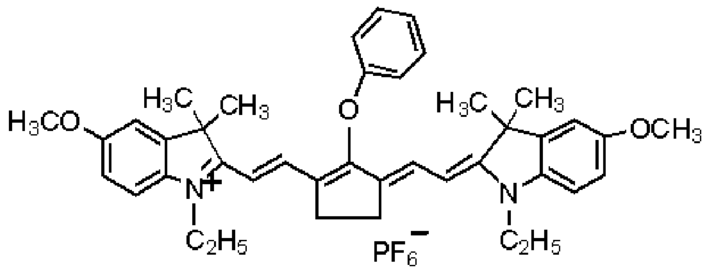

IR-1

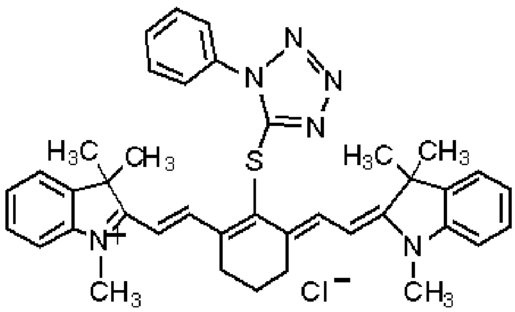

IR-2

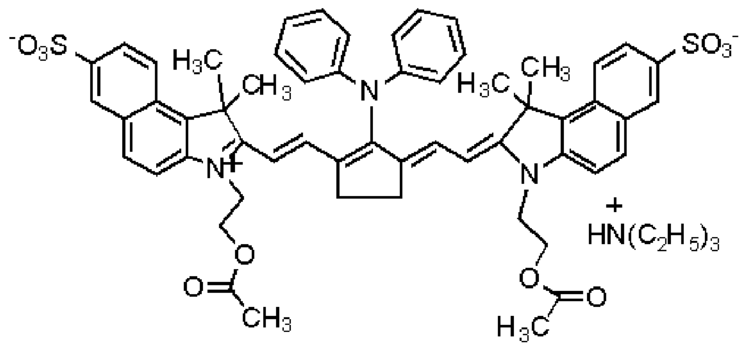

IR－3

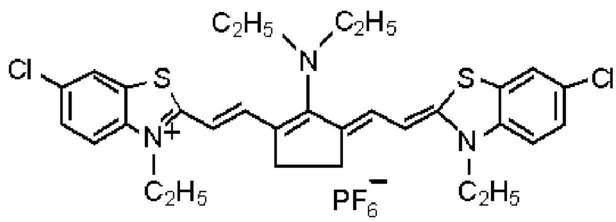

IR－4

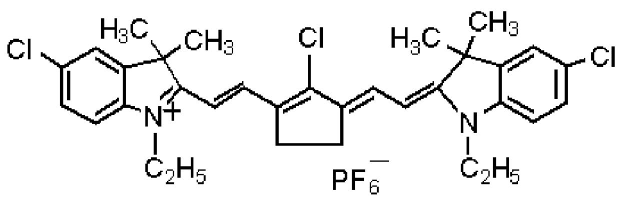

IR－5

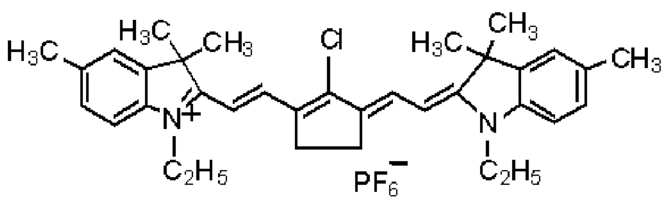

IR－6

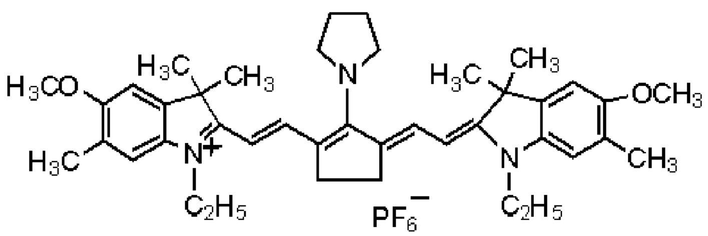

IR－7

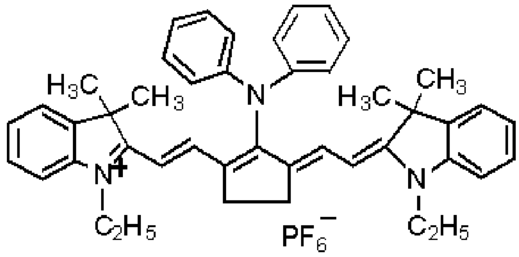

IR−8

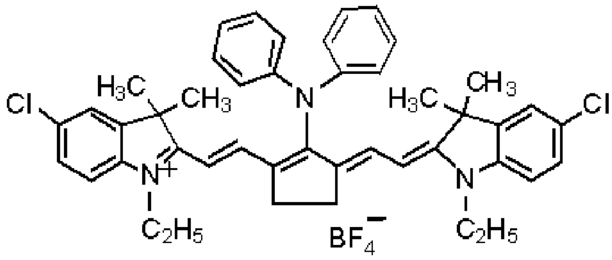

IR−9

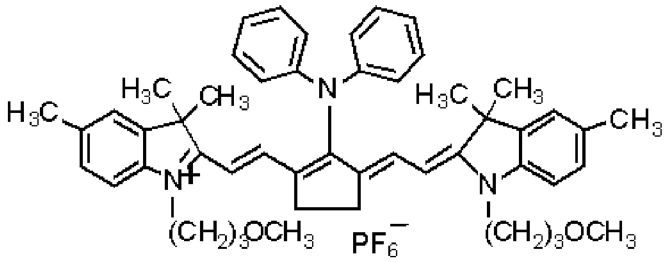

IR−10

The content of the IR dye is preferably from 0.05 to 15.0% by weight, more preferably from 0.1 to 10.0% by weight, most preferably from 0.5 to 5.0% by weight, based on the total solid content constituting the image-recording layer. In the range described above, good color formation and good stability of the colored image after exposure are obtained.

[(E) Binder polymer]

The image-recording layer according to the invention may contain a binder polymer in order to impart a film-forming property. As the binder polymer which can be used in the invention, heretofore known binder polymers can be used without limitation as long as it can impart the film-forming property. It may be a straight-chain binder polymer or a star-like polymer as described in JP-A-2007-249036. For example, an addition polymer and a urethane resin having a crosslinkable group in its side chain described below for the lithographic printing plate precursor are preferably exemplified.

The binder polymer can be incorporated into the image-recording layer in an arbitrary amount, and the content of the binder polymer in the image-recording layer is preferably from 10 to 90% by weight, more preferably from 30 to 80% by weight, based on the total solid content constituting the image-recording layer.

In the image-recording layer of the lithographic printing plate precursor according to the invention, it is preferred to use the binder polymer depending on a development method.

(E1) Binder polymer for alkali development

Although the chemical structure of the binder polymer is not particularly limited, from the standpoint of solubility

in an alkaline processing solution, that is, development property, an organic polymer having an acid group is preferred and particularly, an organic polymer having a carboxylic acid or a salt thereof is more preferred.

As the binder polymer which can be used in the image-recording layer for lithographic printing plate precursor of alkali development type, an aqueous alkali soluble or swellable organic polymer having a carboxylic acid is exemplified. Useful examples of such an organic polymer include addition polymers having a carboxylic acid group in their side chains, for example, polymers described in JP-B-59-44615, JP-B-54-34327, JP-B-58-12577, JP-B-54-25957, JP-A-54-92723, JP-A-59-53836 and JP-A-59-71048, specifically, methacrylic acid copolymers, acrylic acid copolymers, itaconic acid copolymers, crotonic acid copolymers, maleic acid copolymers and partially esterified maleic acid copolymers. As the binder polymer, a copolymer containing a monomer unit derived from a (meth)acrylate and having a carboxylic acid (salt) group is preferred.

Also, an acidic cellulose derivative having a carboxylic acid group in its side chain and a product obtained by adding a cyclic acid anhydride to an addition polymer having a hydroxy group are useful. Further, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful as the aqueous alkali soluble or swellable binder. As the binder polymer for use in the invention, an acrylic resin, a methacrylic resin or a urethane resin is preferably employed.

One preferred example of material for the binder polymer for alkali development is a copolymer having (a) a monomer unit having a carboxylic acid group (including its salt) and (b) a monomer unit for imparting a radical crosslinking property.

The monomer unit (a) having a carboxylic acid group is not particularly limited and structures described in JP-A-2002-40652 and Paragraph Nos. [0059] to [0075] of JP-A-2005-300650 are preferably used.

The monomer unit (b) for imparting a radical crosslinking property is not particularly limited and structures described in Paragraph Nos. [0041] to [0053] of JP-A-2007-248863 are preferably used.

The binder polymer for alkali development may contain a monomer unit derived from an ethylenically unsaturated compound which contains neither the monomer unit (a) having a carboxylic acid group nor the monomer unit (b) for imparting a radical crosslinking property as a copolymerization component.

As such a monomer unit, a monomer unit derived from a (meth)acrylate or (meth)acrylamide is preferred. Particularly, a monomer unit derived from amido group (meth)acrylamide described in Paragraph Nos. [0061] to [0084] of JP-A-2007-272134 is preferably used. The content of such a monomer unit is preferably from 5 to 50 units, more preferably from 5 to 35 units, still more preferably from 5 to 25 units, when the total number of monomer units is taken as 100.

In the image-recording layer of the lithographic printing plate precursor according to the invention, in addition to the addition polymer containing a combination of the monomer units described above, a urethane resin having a crosslinkable group in its side chain can also be used as the binder polymer. The term "crosslinkable group" as used herein means a group capable of crosslinking the binder polymer upon a chemical reaction which is caused in the image-recording layer, when the lithographic printing plate precursor is exposed to light. A chemical structure of the crosslinkable group is not particularly limited as long as the crosslinkable group has such a function and, for example, an ethylenically unsaturated group is preferred as a functional group capable of undergoing an addition polymerization reaction. Also, functional groups described in Paragraph Nos. [0130] to [0139] of JP-A-2007-17948 are exemplified.

The polyurethane resin having a crosslinkable group in its side chain particularly preferably used in the invention can be obtained by a polyaddition reaction of (i) a diisocyanate compound, (ii) a diol compound having a carboxyl group, (iii) a diisocyanate compound having a crosslinkable group and, if desired, (iv) a diol compound containing no carboxyl group and (v) a compound having an amino group.

The compounds of (i), (ii) and (iii) above include compounds represented by formulae (4) to (10) and specific examples described in Paragraph Nos. [0142] to [0167] of JP-A-2007-17948. The compound of (iv) above include compounds represented by formula (A'), formulae (a) to (e), formulae (11) to (22) and specific compounds described in Paragraph Nos. [0180] to [0225] of JP-A-2007-17948. The compound of (v) above include compounds represented by formulae (31) and (32) and specific compounds described in Paragraph Nos. [0227] to [0230] of JP-A-2007-17948. In addition to the polyurethane resin described above, a polyurethane resin obtained by introducing a crosslinkable group into polyurethane having a carboxyl group by a polymer reaction as described in JP-A-2003-270775 may also be exemplified.

The binder polymer for use in the invention preferably has an appropriate molecular weight in order to maintain the development property of the image-recording layer of lithographic printing plate precursor. The weight average molecular weight (Mw) thereof according to GPC method is preferably from 5,000 to 300,000, and more preferably from 20,000 to 150,000.

The binder polymer can be incorporated into the image-recording layer in an arbitrary amount, and the content of the binder polymer in the image-recording layer is preferably from 10 to 90% by weight, more preferably from 30 to 80% by weight, based on the total solid content constituting the image-recording layer.

(E2) Binder polymer for on-press development

As the binder polymer for on-press development, a binder polymer having an alkylene oxide group is preferred.

The binder polymer having an alkylene oxide group for use in the image-recording layer of the lithographic printing plate precursor according to the invention may have a poly(alkylene oxide) moiety in the main chain thereof or in the side chain thereof, or may be a graft polymer having a poly(alkylene oxide) in its side chain or a block copolymer composed of a block constituted by a repeating unit containing a poly(alkylene oxide) and a block constituted by a repeating unit not containing an (alkylene oxide).

In the case where the alkylene oxide group is present in the main chain, a polyurethane resin is preferred. In the case where the alkylene oxide group is present in the side chain, a polymer constituting its main chain includes an acrylic resin, a polyvinyl acetal resin, a polyurethane resin, a polyurea resin, a polyimide resin, a polyamide resin, an epoxy resin, a methacrylic resin, a polystyrene resin, a novolac type phenolic resin, a polyester resin, a synthesis rubber and a natural rubber. In particular, an acrylic resin is preferred.

The alkylene oxide is preferably an alkylene oxide having from 2 to 6 carbon atoms, and particularly preferably an ethylene oxide or a propylene oxide.

A repeating number of alkylene oxide in the poly(alkylene oxide) moiety is from 2 to 120, preferably in a range from 2 to 70, and more preferably in a range from 2 to 50.

It is preferred that the repeating number of alkylene oxide is 120 or less because both the printing durability as to abrasion and the printing durability as to ink receptivity are not decreased.

The poly(alkylene oxide) moiety is preferably introduced into an side chain of the binder as a structure represented by formula (a) shown below. More preferably, it is introduced into a side chain of an acrylic resin as a structure represented by formula (a) shown below.

Formula (a)

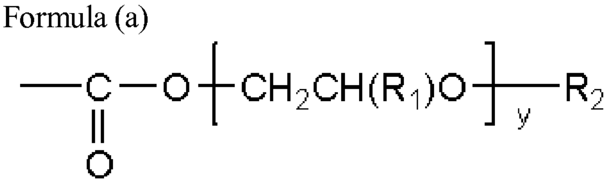

In formula (a), y represents a number from 2 to 120, preferably in a range from 2 to 70, and more preferably in a range from 2 to 50. $R_1$ represents a hydrogen atom or an alkyl group. $R_2$ represents a hydrogen atom or an organic group. The organic group is preferably an alkyl group having from 1 to 6 carbon atoms and includes a methyl group, an ethyl group, an n-propyl group, an isopropyl group, an n-butyl group, a sec-butyl group, an isobutyl group, a tert-butyl group, an n-pentyl group, an isopentyl group, a neopentyl group, an n-hexyl group, an isohexyl group, a 1,1-dimethylbutyl group, a 2,2-dimethylbutyl group, a cyclopentyl group and a cyclohexyl group.

In formula (a), $R_1$ is preferably a hydrogen atom or a methyl group and most preferably a hydrogen atom. $R_2$ is most preferably a hydrogen atom or a methyl group.

The binder polymer may have a crosslinking property in order to improve the film strength of the image area. In order to impart the crosslinking property to the binder polymer, a crosslinkable functional group, for example, an ethylenically unsaturated bond is introduced into a main chain or side chain of the polymer. The crosslinkable functional group may be introduced by copolymerization.

Examples of the polymer having an ethylenically unsaturated bond in the main chain thereof include poly-1,4-butadiene and poly-1,4-isoprene.

Examples of the polymer having an ethylenically unsaturated bond in the side chain thereof include a polymer of an ester or amide of acrylic acid or methacrylic acid, which is a polymer wherein the ester or amido residue (R in -COOR or -CONHR) has an ethylenically unsaturated bond.

Examples of the residue (R described above) having an ethylenically unsaturated bond include $-(CH_2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$ and $-(CH_2CH_2O)_2-X$ (wherein $R^1$ to $R^3$ each independently represents a hydrogen atom, a halogen atom or an alkyl group having from 1 to 20 carbon atoms, an aryl group, an alkoxy group or an aryloxy group, or $R^1$ and $R^2$ or $R^1$ and $R^3$ may be combined with each other to form a ring. n represents an integer from 1 to 10. X represents a dicyclopentadienyl residue).

Specific examples of the ester residue include $-CH_2CH=CH_2$ (described in JP-B-7-21633), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$ and $-CH_2CH_2O-X$ (wherein X represents a dicyclopentadienyl residue).

Specific examples of the amido residue include $-CH_2CH=CH_2$, $-CH_2CH_2-Y$ (wherein Y represents a cyclohexene residue) and $-CH_2CH_2-OCO-CH=CH_2$.

The binder polymer having a crosslinking property is cured, for example, by addition of a free radical (a polymerization initiating radical or a growing radical of a polymerizable compound in the process of polymerization) to the crosslinkable functional group of the polymer and undergoing addition polymerization between the polymers directly or through a polymerization chain of the polymerizable compound to form crosslinkage between the polymer molecules. Alternately, it is cured by generation of a polymer radical upon extraction of an atom (for example, a hydrogen atom on a carbon atom adjacent to the functional crosslinkable group) in the polymer by a free radial and connecting the polymer radicals with each other to form cross-linkage between the polymer molecules.

The content of the crosslinkable group (content of the radical polymerizable unsaturated double bond determined by iodine titration) in the binder polymer is preferably from 0.1 to 10.0 mmol, more preferably from 1.0 to 7.0 mmol, most preferably from 2.0 to 5.5 mmol, based on 1 g of the polymer compound. In the range described above, good sensitivity and good preservation stability are obtained.

Specific examples (1) to (13) of the binder polymer for used in the invention are set forth below, but the invention should not be construed as being limited thereto.

In the exemplified compounds described below, a numerical value appended to each repeating unit (numerical value appended to a repeating unit of a main chain) indicates a mole percent of the repeating unit. A numerical value appended to a repeating unit of a side chain indicates a repeating number of the repeating unit.

(1) 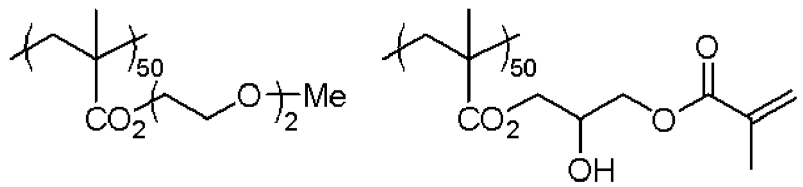

(2) 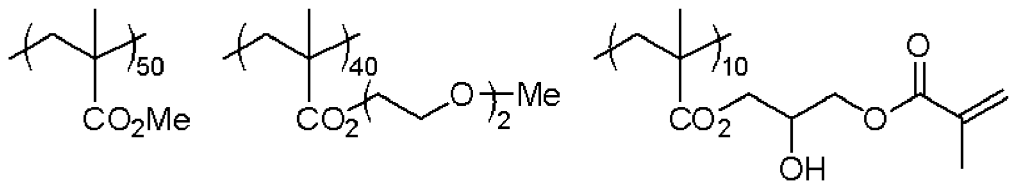

(3) 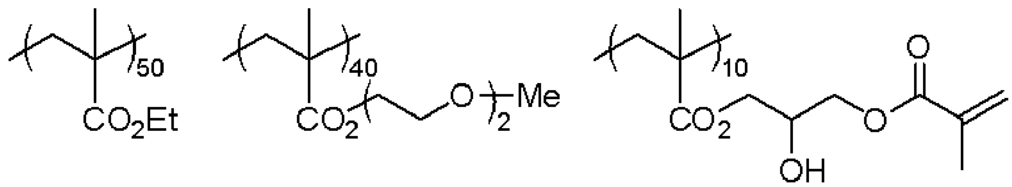

(4) 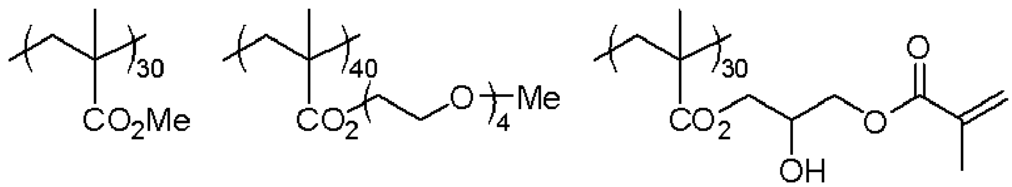

(5) 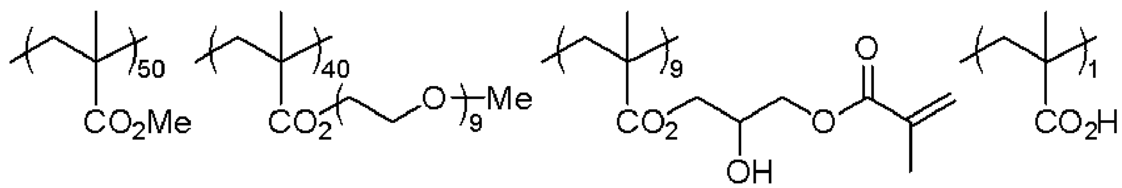

(6) 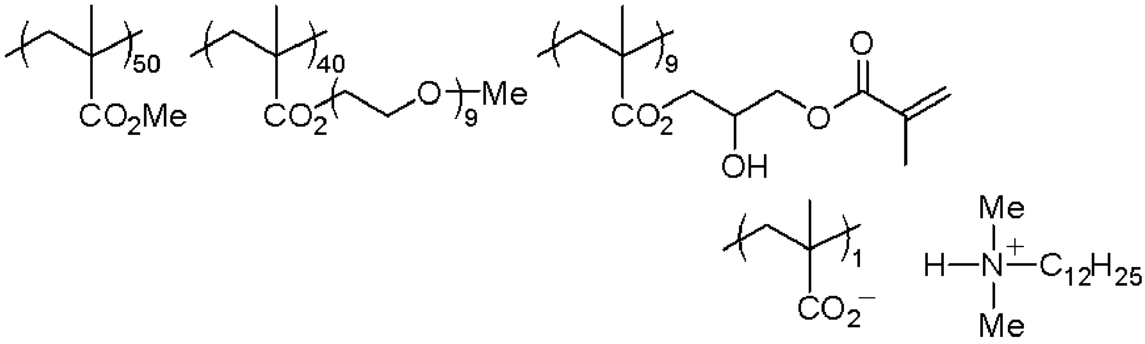

(7) 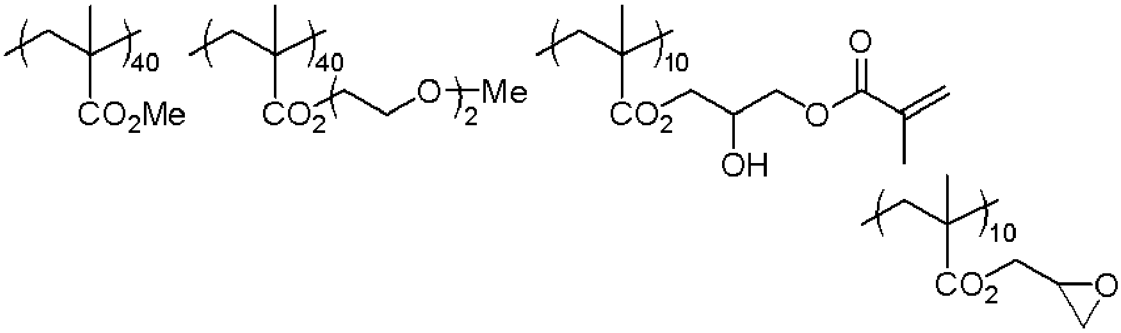

(8) 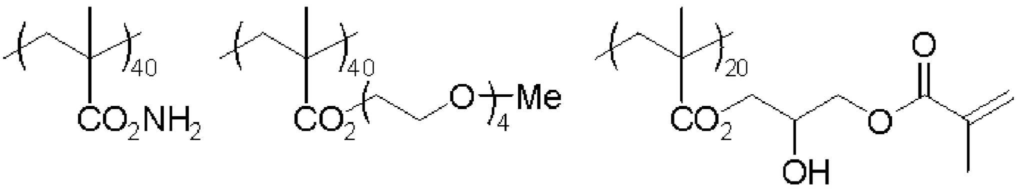

(9) 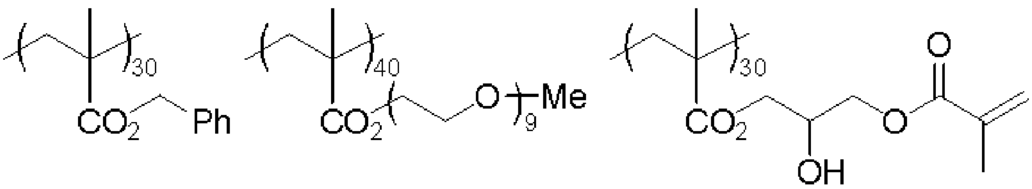

(10) 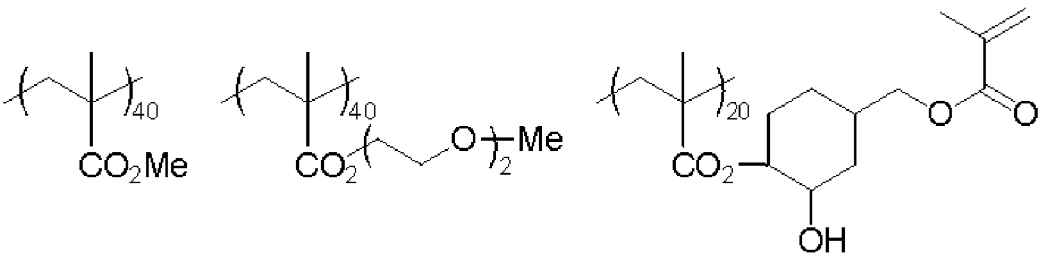

(11)

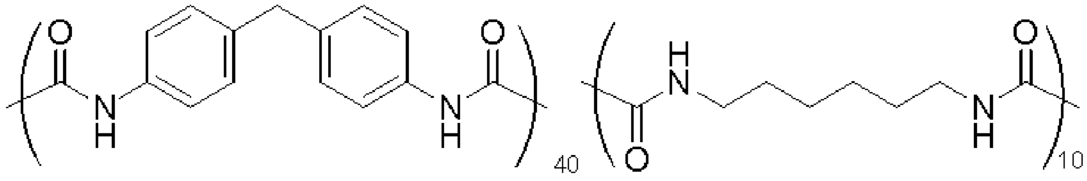

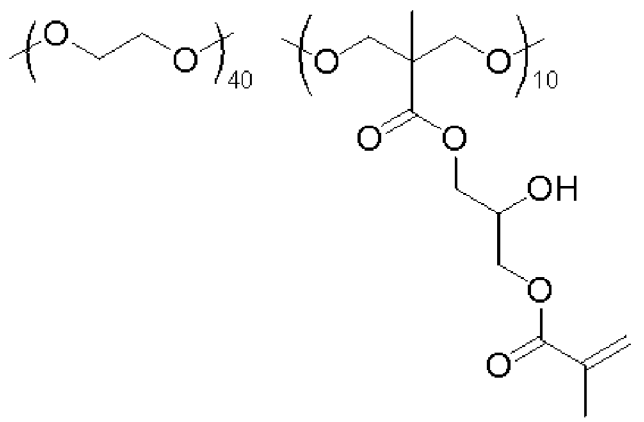

(12)

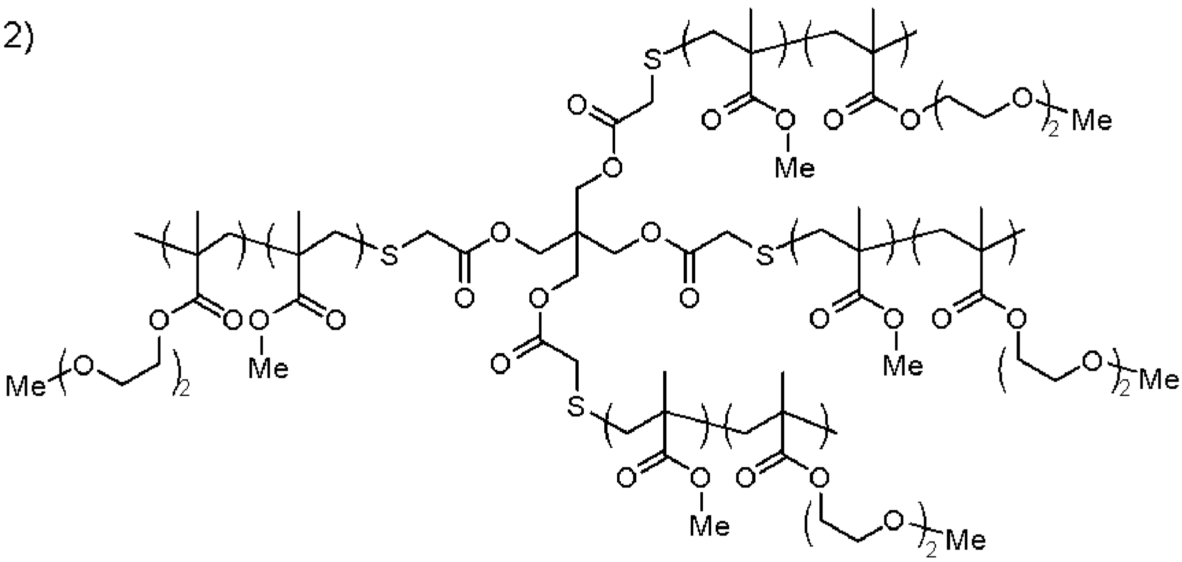

(13)

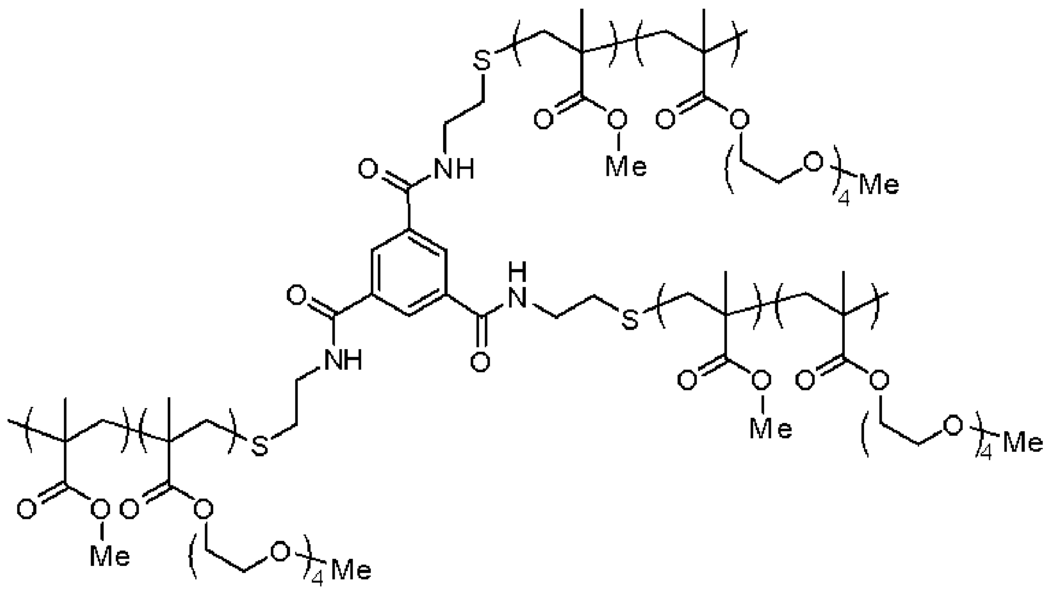

The weight average molecular weight (Mw) according to GPC method of the binder polymer according to the invention is preferably 2,000 or more, more preferably 5,000 or more, and still more preferably from 10,000 to 300,000.

According to the invention, a hydrophilic polymer compound, for example, polyacrylic acid or polyvinyl alcohol described in JP-A-2008-195018 may be used together, if desired. Further, an oleophilic polymer compound may be used in combination with a hydrophilic polymer compound.

In the case of applying to the image-recording layer, as to the configuration of the binder polymer, it may be present as a binder acting as a bond of each ingredient or in the form of fine particle in the image-recording. In the case of existing in the form of fine particle, the average particle size thereof is in a range from 10 to 1,000 nm, preferably in a range from 20 to 300 nm, and particularly preferably in a range from 30 to 120 nm.

The content of the binder polymer according to the invention is preferably from 5 to 90% by weight, more preferably from 5 to 80% by weight, still more preferably from 10 to 70% by weight, based on the total solid content of the image-recording layer.

As a preferred combination of the onium polymerization initiator and the sensitizing dye or as a preferred combination of the radical polymerization initiator and the polyfunctional polymerization inhibitor compound, a combination of the respective preferred embodiments thereof is most preferred. Also, as a preferred combination of the radical polymerization initiator, the sensitizing dye and the polyfunctional polymerization inhibitor compound, a combination of the respective preferred embodiments thereof is most preferred.

[(F) Polymer fine particle]

According to the invention, a polymer fine particle can be used in order to improve the development property. In particular, a polymer fine particle having a polyalkylene oxide structure is preferred. Among them, a polymer fine particle having a polyalkylene oxide group in its side chain is preferred.

This increases permeability of dampening water to improve the development property. As the polyalkylene oxide structure, an alkylene oxide structure containing from 2 to 120 alkylene oxide units having from 2 to 3 carbon atoms is preferred, and a polyethylene oxide structure containing from 2 to 120 ethylene oxide units is more preferred. Particularly, a polyethylene oxide structure containing from 20 to 100 ethylene oxide units is preferred. By means of such a polymer fine particle containing a polyalkylene oxide structure, compatibility between the printing durability and the development property can be achieved. Also, the ink receptivity can be improved.

The polymer fine particle according to the invention is preferably a hydrophobizing precursor capable of converting the image-recording layer to be hydrophobic when heat is applied. The hydrophobizing precursor polymer fine particle is preferably at least one fine particle selected from a hydrophobic thermoplastic polymer fine particle, a thermoreactive polymer fine particle, a microcapsule having a hydrophobic compound encapsulated and a microgel (crosslinked polymer fine particle). Among them, a polymer fine particle having a polymerizable group and a microgel are preferred. In order to improve the development property, the polymer fine particle preferably contains a polyalkylene oxide structure as described above.

As the hydrophobic thermoplastic polymer fine particle, hydrophobic thermoplastic polymer fine particles described, for example, in Research Disclosure, No. 33303, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile or polymethyl methacrylate is more preferred.

The average particle size of the hydrophobic thermoplastic polymer fine particle for use in the invention is preferably from 0.01 to 2.0 μm.

The thermo-reactive polymer fine particle for use in the invention includes a polymer fine particle having a thermo-reactive group and forms a hydrophobized region by crosslinkage due to thermal reaction and change in the functional group involved therein.

As the thermo-reactive group of the polymer fine particle having a thermo-reactive group for use in the invention, a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an isocyanate group or a blocked form thereof, an epoxy group or a vinyloxy group performing an addition reaction and a functional group having an active hydrogen atom (for example, an amino group, a hydroxy group or a carboxyl group) as the reaction partner thereof, a carboxyl group performing a condensation reaction and a hydroxy group or an amino group as the reaction partner thereof, and an acid anhydride performing a ring opening addition reaction and an amino group or a hydroxy group as the reaction partner thereof are preferably exemplified.

As the microcapsule for use in the invention, microcapsule having all or part of the constituting components of the image-recording layer encapsulated as described, for example, in JP-A-2001-277740, JP-A-2001-277742 and EP 2383118 is exemplified. The constituting components of the image-recording layer may be present outside the microcapsule. It is a preferred embodiment of the image-recording layer containing microcapsule that hydrophobic constituting components are encapsulated in the microcapsule and hydrophilic constituting components are present outside the microcapsule.

The image-recording layer according to the invention may be an embodiment containing a crosslinked resin particle, that is, a microgel. The microgel can contain a part of the constituting components of the image-recording layer inside and/or on the surface thereof. Particularly, an embodiment of a reactive microgel containing the polymerizable compound (B) on the surface thereof is preferred in view of the image-forming sensitivity and printing durability.

As a method of microencapsulation or microgelation of the constituting components of the image-recording layer, known methods can be used.

The average particle size of the microcapsule or microgel is preferably from 0.01 to 3.0 μm, more preferably from 0.05 to 2.0 μm, particularly preferably from 0.10 to 1.0 μm. In the range described above, good resolution and good time-lapse stability can be achieved.

The content of the polymer fine particle is preferably in a range from 5 to 90% by weight based on the total solid content of the image-recording layer.

[(G) Other components]

The image-recording layer according to the invention may further contain other components described below, if desired.

(G-1) Hydrophilic low molecular weight compound

The image-recording layer according to the invention may contain a hydrophilic low molecular weight compound in order to improve the on-press development property without accompanying the decrease in the printing durability.

The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyol, e.g., glycerol, pentaerythritol or tris(2-hydroxyethyl) isocyanurate, an organic amine, e.g., triethanol amine, diethanol amine or monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.

According to the invention, it is preferred that at least one compound selected from a polyol, an organic sulfate, an organic sulfonate and a betaine is incorporated.

Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphtyldisulfonate or trisodium 1,3,6-naphtyltrisulfonate; and compounds described in Paragraph Nos. [0026] to [0031] of JP-A-2007-276454 and Paragraph Nos. [0020] to [0047] of JP-A-2009-154525. The salt may also be a potassium salt or a lithium salt.

The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt. Specific examples thereof include compounds described in Paragraph Nos. [0034] to [0038] of JP-A-2007-276454.

As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The addition amount of the hydrophilic low molecular weight compound in the image-recording layer is preferably from 0.5 to 20% by weight, more preferably from 1 to 15% by weight, still more preferably from 2 to 10% by weight, based on the total solid content of the image-recording layer. In the range described above, good on-press development property and good printing durability are achieved.

The hydrophilic low molecular weight compounds may be used individually or as a mixture of two or more thereof.

(G-2) Oil-sensitizing agent

In order to improve the ink receptivity, an oil-sensitizing agent, for example, a phosphonium compound, a nitrogen-containing low molecular weight compound or an ammonium group-containing polymer can be used in the image-recording layer according to the invention. In particular, in the case where an inorganic stratiform compound is incorporated into a protective layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples thereof include compounds described in Paragraph Nos. [0089] to [0105] of JP-A-2009-208458.

As to the ammonium group-containing polymer, its reduced specific viscosity value (unit: ml/g) determined according to the measuring method described below is preferably in a range from 5 to 120, more preferably in a range from 10 to 110, and particularly preferably in a range from 15 to 100. When the reduced specific viscosity value described above is calculated in terms of weight average molecular weight (Mw) according to GPC method, from 10,000 to 150,000 is preferred, from 17,000 to 140,000 is more preferred, and 20,000 to 130,000 is particularly preferred.

<Measuring method of reduced specific viscosity>

In a 20 ml measuring flask was weighed 1 g of polymer solid content and the measuring flask is filled up to the gauge line with N-methyl pyrrolidone. The resulting solution was allowed to stand in a thermostatic bath of 30°C for 30 minutes and put into an Ubbelohde viscometer (viscometer constant: 0.010 cSt/s) and a period for running down of the solution at 30°C was measured. The measurement was conducted twice for the same sample and an average value of the measurement was determined. The measurement was also conducted for a blank (only N-methyl pyrrolidone) in the same manner. The reduced specific viscosity (ml/g) was calculated according to the formula shown below.

$$\text{Reduced specific viscosity (ml/g)} = \frac{\dfrac{\text{Period for running down of sample solution (sec)} - \text{Period for running down of blank (sec)}}{\text{Period for running down of blank (sec)}}}{\dfrac{3.33\,(\text{g}) \times \dfrac{30}{100}}{20\,(\text{ml})}}$$

Specific examples of the ammonium group-containing polymer are set forth below. (1) 2-(Trimethylammonio)ethyl methacrylate p-toluenesulfonate/3,6-dioxaheptyl methacrylate copolymer (molar ratio: 10/90, Mw: 45,000) (2) 2-(Trimethylammonio)ethyl methacrylate hexafluorophosphate/3,6-dioxaheptyl methacrylate copolymer (molar ratio: 20/80, Mw: 60,000) (3) 2-(Ethyldimethylammonio)ethyl methacrylate p-toluenesulfonate/hexyl methacrylate copolymer (molar ratio: 30/70, Mw: 45,000) (4) 2-(Trimethylammonio)ethyl methacrylate hexafluorophosphate /2-ethylhexyl methacrylate copolymer (molar ratio: 20/80, Mw: 60,000) (5) 2-(Trimethylammonio)ethyl methacrylate methylsulfate/hexyl methacrylate copolymer (molar ratio: 40/60, Mw: 70,000) (6) 2-(Butyldimethylammonio)ethyl methacrylate hexafluorophosphate/3,6-dioxaheptyl methacrylate copolymer (molar ratio: 25/75, Mw: 65,000) (7) 2-(Butyldimethylammonio)ethyl acrylate hexafluorophosphate/3,6-dioxaheptyl methacrylate copolymer (molar ratio: 20/80, Mw: 65,000) (8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80, Mw: 75,000) (9) 2-(Butyldimethylammonio)ethyl methacrylate hexafluorophosphate/3,6-dioxaheptyl methacrylate/2-hydroxy-3 -methacryloyloxypropyl methacrylate copolymer (molar ratio: 15/80/5, Mw: 65,000)

The content of the oil-sensitizing agent is preferably from 0.01 to 30.0% by weight, more preferably from 0.1 to 15.0% by weight, still more preferably from 1 to 10% by weight, based on the total solid content of the image-recording layer.

(G-3) Other components

Other components, for example, a surfactant, a coloring agent, a print-out agent, a polymerization inhibitor, a higher fatty acid derivative, a plasticizer, an inorganic fine particle, an inorganic stratiform compound, a sensitizing aid or a chain transfer agent may further be added to the image-recording layer. Specifically, compounds and addition amounts thereof as described, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

[Formation of image-recording layer]

The image-recording layer according to the invention is formed by dispersing or dissolving each of the necessary components described above in a known solvent to prepare a coating solution and coating the solution on a support by a known method, for example, bar coater coating and drying as described in Paragraph Nos. [0142] to [0143] of JP-A-2008-195018. The coating amount (solid content) of the image-recording layer formed on the support after coating and drying may be varied according to the intended purpose but is in general preferably from 0.3 to 3.0 $g/m^2$. In the range described above, good sensitivity and good film property of the image-recording layer can be achieved.

[Undercoat layer]

In the lithographic printing plate precursor according to the invention, it is preferred to provide an undercoat layer (also referred to as an intermediate layer) between the image-recording layer and the support. The undercoat layer strengthens adhesion between the support and the image-recording layer in the exposed area and makes removal of

the image-recording layer from the support easy in the unexposed area, thereby contributing improvement in the development property without accompanying degradation of the printing durability. Further, in the case of infrared laser exposure, since the undercoat layer acts as a heat insulating layer, decrease in sensitivity due to diffusion of heat generated upon the exposure into the support is prevented.

As to a compound for use in the undercoat layer, an undercoat layer containing an acid group, for example, phosphonic acid, phosphoric acid or sulfonic acid is preferably used. Further, a compound having an adsorbing group capable of adsorbing to a surface of support and a crosslinkable group in order to improve an adhesion property to the image-recording layer is preferred. The compound may be a low molecular weight compound or a polymer compound. The compounds may be used in mixture of two or more thereof, if desired.

As the polymer compound, a copolymer of a monomer having an adsorbing group, a monomer having a hydrophilic group and a monomer having a crosslinkable group is preferred. As the adsorbing group capable of adsorbing to a surface of support, a phenolic hydroxy group, a carboxyl group, $-PO_3H_2$, $-OPO_3H_2$, $-CONHSO_2-$, $-SO_2NHSO_2-$ or $-COCH_2COCH_3$ is preferred. As the hydrophilic group, a sulfo group is preferred. As the crosslinkable group, for example, a methacryl group or an allyl group is preferred. The polymer compound may contain a crosslinkable group introduced by a salt formation between a polar substituent of the polymer compound and a compound containing a substituent having a counter charge to the polar substituent of the polymer compound and an ethylenically unsaturated bond and may also be further copolymerized with a monomer other than those described above, preferably a hydrophilic monomer.

Specifically, a silane coupling agent having an addition-polymerizable ethylenic double bond reactive group described in JP-A-10-282679 and a phosphorus compound having an ethylenic double bond reactive group described in JP-A-2-304441 are preferably exemplified. Low molecular weight compounds or polymer compounds having a crosslinkable group (preferably an ethylenically unsaturated bond group), a functional group capable of interacting with a surface of support and a hydrophilic group described in JP-A-2005-238816, JP-A-2005-125749, JP-A-2006-239867 and JP-A-2006-215263 are also preferably used. Polymer compounds having an adsorbing group capable of adsorbing to a surface of support, a hydrophilic group and a crosslinkable group described in JP-A-2005-125749 and JP-A-2006-188038 are more preferred.

The content of the unsaturated double bond in the polymer compound for undercoat layer is preferably from 0.1 to 10.0 mmol, most preferably from 0.2 to 5.5 mmol, based on 1 g of the polymer compound.

The weight average molecular weight of the polymer compound for undercoat layer is preferably 5,000 or more, and more preferably from 10,000 to 300,000.

The undercoat layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazabicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compound for the undercoat layer described above in order to prevent the occurrence of stain due to the lapse of time.

The undercoat layer is coated according to a known method. The coating amount (solid content) of the undercoat layer is preferably from 0.1 to 100 $mg/m^2$, and more preferably from 1 to 30 $mg/m^2$.

[Support]

As the support for use in the light-sensitive lithographic printing plate precursor according to the invention, a known support is employed. Particularly, an aluminum plate subjected to roughening treatment and anodizing treatment according to a known method is preferred.

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 $\mu$m.

The support for use in the lithographic printing plate precursor according to the invention may have a backcoat layer containing an organic polymer compound described in JP-A-5-45885 or an alkoxy compound of silicon described in JP-A-6-35174, provided on the back surface thereof, if desired.

[Protective layer]

In the lithographic printing plate precursor for use in the method according to the invention, it is preferred to provide a protective layer (an overcoat layer) on the image-recording layer. The protective layer has a function for preventing, for example, occurrence of scratch in the image-recording layer or ablation caused by exposure with high

illuminance laser, in addition to the function for restraining an inhibition reaction against the image formation by means of oxygen blocking.

The protective layer in the lithographic printing plate precursor according to the invention may be formed from two or more layers. For example, the protective layer may be constituted from two layer constitution of an upper protective layer and a lower protective layer.

With respect to the protective layer having such properties, there are described, for example, in U.S. Patent 3,458,311 and JP-B-55-49729. As a polymer having low oxygen permeability for use in the protective layer, any water-soluble polymer and water-insoluble polymer can be appropriately selected to use. The polymers may be used in mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified.

As the modified polyvinyl alcohol, an acid-modified polyvinyl alcohol having a carboxyl group or a sulfo group is preferably used. Specifically, modified polyvinyl alcohols described in JP-A-2005-250216 and JP-A-2006-259137 are preferably exemplified.

In the protective layer, a hydrophilic polymer containing at least a repeating unit represented by formula (1) shown below and a repeating unit represented by formula (2) shown below as described in JP-A-2012-73597 can be used.

In particular, the protective layer preferably contains a hydrophilic polymer containing repeating units represented by formulae (1) and (2) shown below (hereinafter, also referred to as a specific hydrophilic polymer (e)).

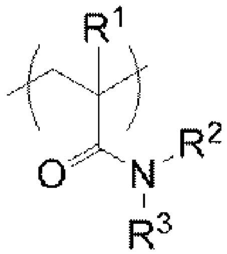

Formula (1)

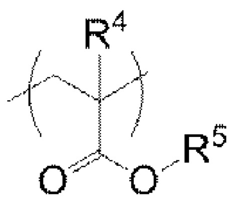

Formula (2)

In formulae (1) and (2), $R^1$ and $R^4$ each independently represents a hydrogen atom or a methyl group. $R^2$ and $R^3$ each independently represents a hydrogen atom, a methyl group or an ethyl group. $R^5$ represents an unsubstituted straight-chain, branched or cyclic alkyl group having from 2 to 8 carbon atoms, a substituted alkyl group which may have an aromatic ring or a heterocyclic ring as a substituent or a substituent represented by formula (3) shown below.

As the substituent which can be introduced into the substituted alkyl group, an aromatic ring group, a heterocyclic group and a polyether group are exemplified.

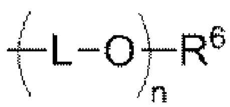

Formula (3)

In formula (3), L represents an alkylene group having from 2 to 6 carbon atoms, $R^6$ represents a straight-chain, branched or cyclic alkyl group having from 4 to 8 carbon atoms or an aromatic group-substituted alkyl group, and n means an average addition molar number of polyether and represents a number from 2 to 4.

In the repeating unit represented by formula (1), $R^2$ and $R^3$ each preferably represents a hydrogen atom. In the repeating unit represented by formula (2), $R^5$ preferably represents an unsubstituted straight-chain, branched or cyclic alkyl group having from 2 to 8 carbon atoms.

Of the combinations of the repeating units represented by formulae (1) and (2) respectively, a combination where $R^1$ and $R^4$ in formulae (1) and (2) are both hydrogen atoms, $R^2$ and $R^3$ in formula (1) are both hydrogen atoms, and $R^5$ in formula (2) is an unsubstituted branched alkyl group having 4 carbon atoms is most preferred.

The specific hydrophilic polymer (e) is preferably a hydrophilic polymer containing a repeating unit represented by formula (4) shown below.

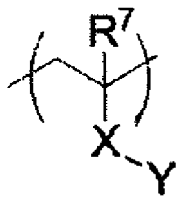

Formula (4)

In formula (4), $R^7$ represents a hydrogen atom or a methyl group. X represents a single bond, a divalent connecting group selected from structures described in structure group (5) shown below or a divalent connecting group formed by combination of plural structures selected from structures described in structure group (5) shown below. Y represents a carboxylic acid group, a carboxylic acid salt group, a sulfonic acid group, a sulfonic acid salt group, a phosphoric acid group, a phosphoric acid salt group, a phosphonic acid group, a phosphonic acid salt group, a hydroxy group, a carboxybetaine group, a sulfobetaine group, an ammonium group or a polyether group represented by formula (6) shown below.

In the repeating unit represented by formula (4), from the standpoint of water solubility and on-press development property, Y is preferably a sulfonic acid group, a sulfonic acid salt group, a carboxybetaine group, a sulfobetaine group or an ammonium group, and more preferably a sulfonic acid group, a sulfonic acid salt group or a sulfobetaine group.

Also, X is preferably a divalent connecting group selected from structures described in structure group (5) shown below.

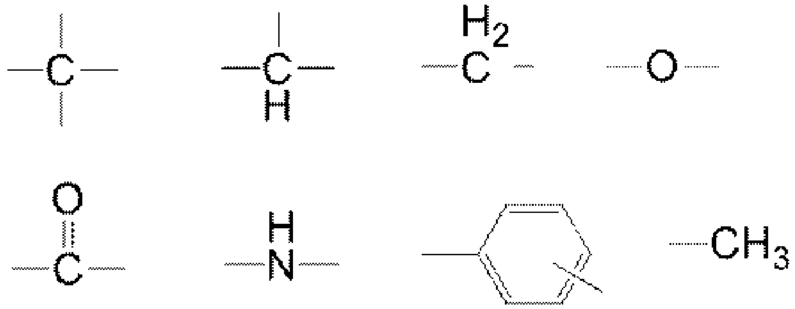

Structure group (5)

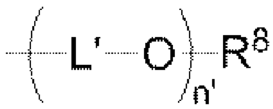

Formula (6)

In formula (6), L' represents an alkylene group having from 2 to 3 carbon atoms. $R^8$ represents a hydrogen atom or a methyl group. n' means an average addition molar number of polyether and represents a number from 2 to 4.

Specific examples of a monomer from which the repeating unit represented by formula (1) is derived include acrylamide, methacrylamide, N-methylacrylamide, N-methylmethacrylamide, N-ethylacrylamide, N-ethylmethacrylamide, N,N-dimethylacrylamide, N,N-dimethylmethacrylamide, N,N-diethylacrylamide, N,N-diethylmethacrylamide, N,N-ethylmethylacrylamide and N,N-ethylmethylmethacrylamide.

Specific examples of a monomer from which the repeating unit represented by formula (2) is derived include methyl acrylate, ethyl acrylate, propyl acrylate, isopropyl acrylate, n-butyl acrylate, isobutyl acrylate, tert-butyl acrylate, pentyl acrylate, hexyl acrylate, cyclohexyl acrylate, heptyl acrylate, octyl acrylate, 2-ethylhexyl acrylate, nonyl acrylate, decyl acrylate, 2-(2-ethylhexyloxyethoxy)ethyl acrylate, methyl methacrylate, ethyl methacrylate, propyl methacrylate, isopropyl methacrylate, n-butyl methacrylate, isobutyl methacrylate, tert-butyl methacrylate, pentyl methacrylate, hexyl methacrylate, cyclohexyl methacrylate, heptyl methacrylate, octyl methacrylate, 2-ethylhexyl methacrylate, nonyl methacrylate and decyl methacrylate.

The content of the repeating unit represented by formula (1) is preferably from 65 to 96.7% by mole, more

preferably from 70 to 80% by mole, particularly preferably from 74 to 80% by mole. The content of the repeating unit represented by formula (2) is preferably from 3 to 30% by mole, more preferably from 20 to 30% by mole, particularly preferably from 20 to 26% by mole.

Specific examples of a monomer from which the repeating unit represented by formula (4) is derived include 2-acryloylamino-2-methylpropanesulfonic acid, sodium 2-acryloylamino-2-methylpropanesulfonate, potassium 2-acryloylamino-2-methylpropanesulfonate, 4-((3-methacrylamidopropyl)dimethylammonio)butane-1-sulfonate, 4-((3-acrylamidopropyl)dimethylammonio)butane-1-sulfonate, vinyl alcohol, acrylic acid, methacrylic acid, sodium styrenesulfonate, diethylene glycol monomethyl ether methacrylate, hydroxyethyl acrylate, hydroxyethyl methacrylate, methacrylcholine chloride, potassium 3-sulfopropylmethacrylate, 2-(methacryloyloxy)ethyl phosphate, dimethyl-N-methacryloyloxyethyl-N-carboxymethyl-ammonium betaine and vinylphosphonic acid.

The specific hydrophilic polymer (e) contains the repeating unit represented by formula (4) preferably in a range from 0.3 to 5% by mole, more preferably from 0.3 to 3% by mole, and still more preferably from 0.3 to 1.5% by mole.

By incorporating the repeating unit represented by formula (4) into the hydrophilic polymer used in the protective layer according to the invention in the preferred range described above, the light-sensitive lithographic printing plate precursor for use in the invention provides good on-press development property, ink receptivity and printing durability.

The weight average molecular weight (Mw) according to GPC method of the hydrophilic polymer according to the invention is preferably in a range from 10,000 to 200,000, more preferably in a range from 10,000 to 100,000, and most preferably in a range from 10,000 to 30,000.

Specific examples of the hydrophilic polymer according to the invention are set forth below. The ratio x, y and z (in % by mole) of the respective repeating units and Mw of the hydrophilic polymer are shown in Table 12 below.

The content of the specific hydrophilic polymer (e) in the protective layer is preferably 40% by weight or more, more preferably from 60% by weight or more, particularly preferably from 80% by weight or more, based on the solid content of the protective layer. In the range described above, a lithographic printing plate having better ink receptivity and higher printing durability is provided and a lithographic printing plate precursor more excellent in on-press development property is obtained.

1 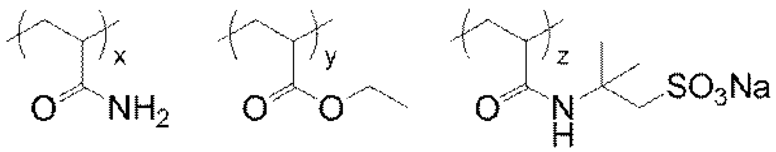

2 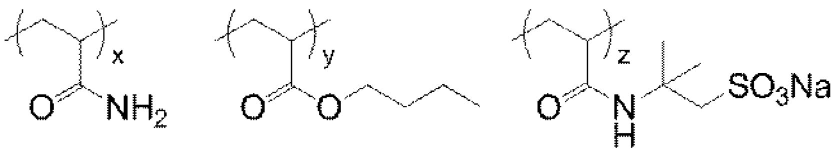

3 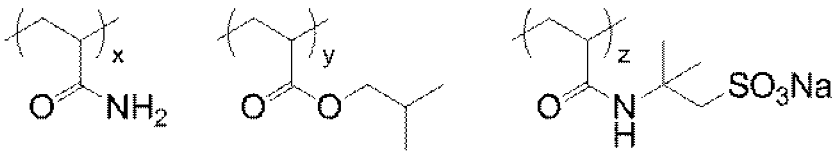

4 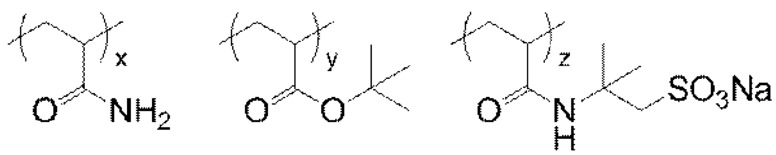

5 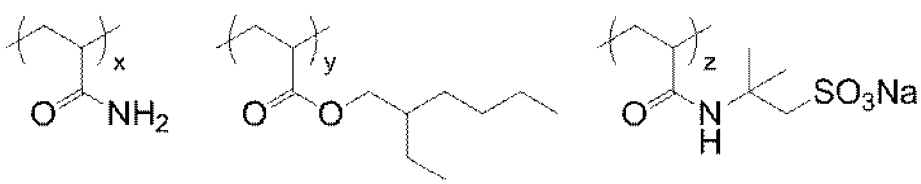

6 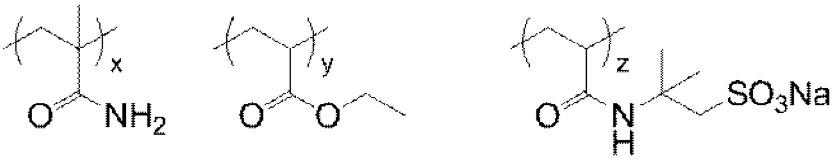

7 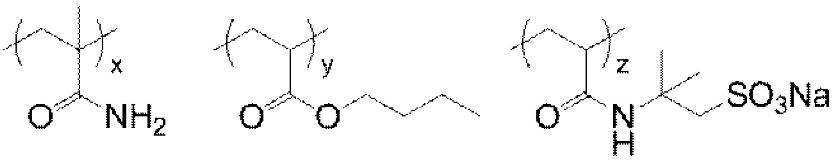

8 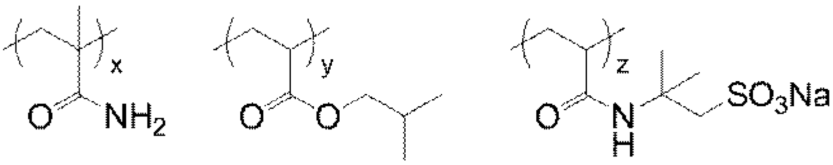

9 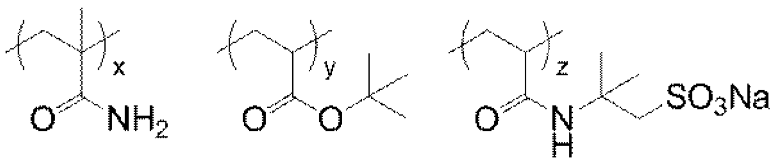

10 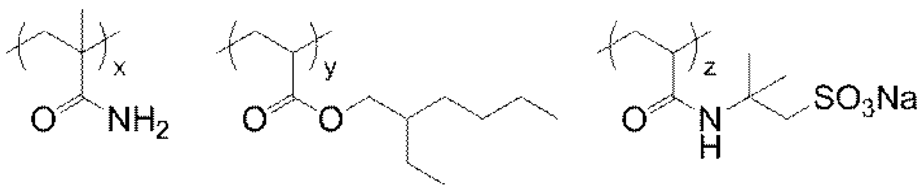

11 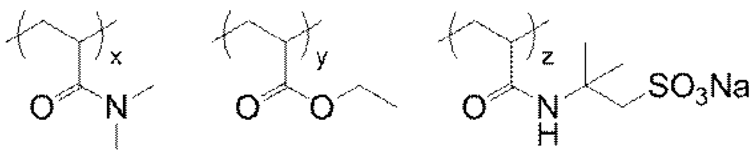

12 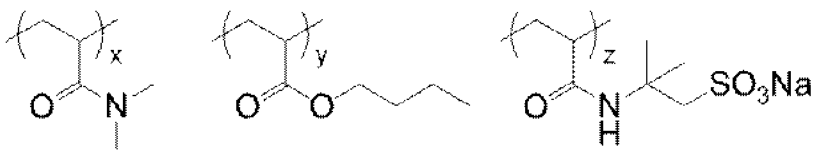

13 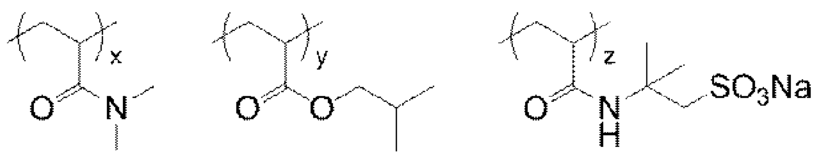

14 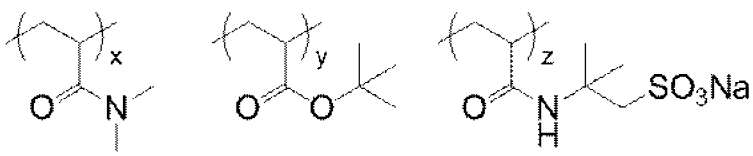

15 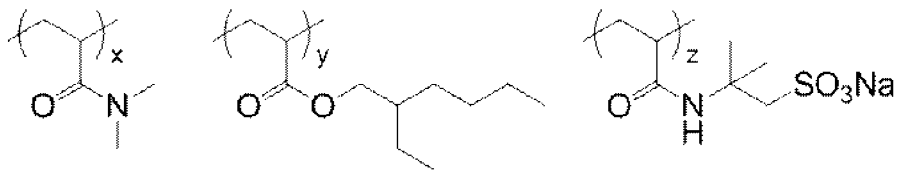

16 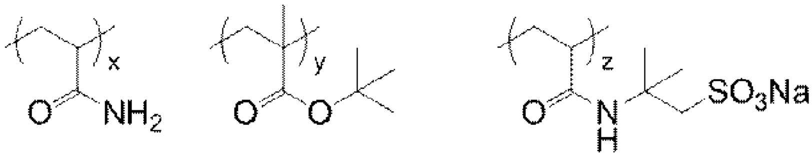

17 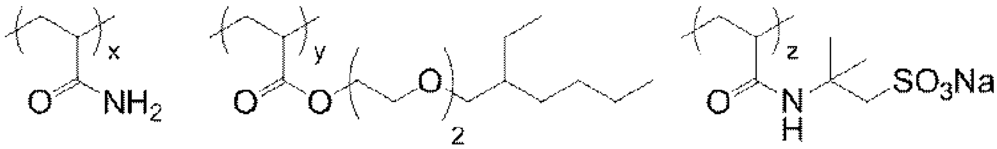

18 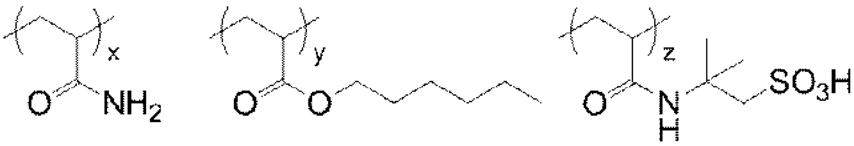

19 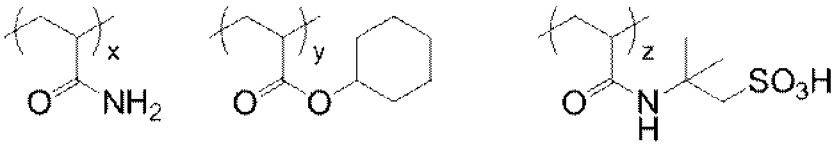

20 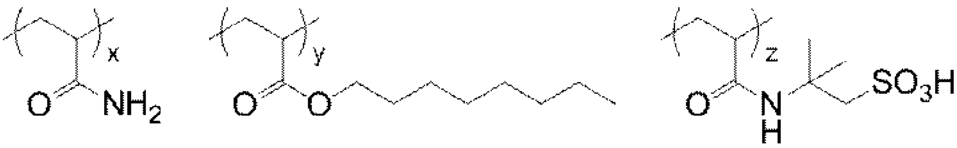

21 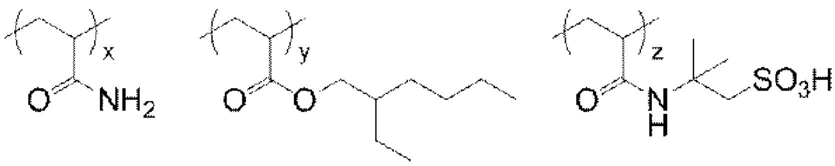

22 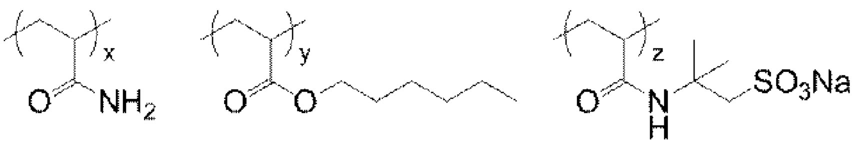

23 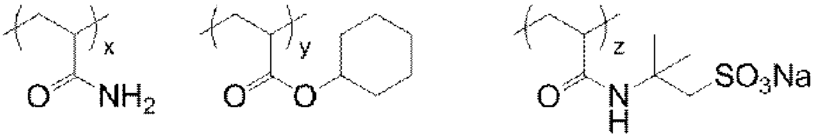

24 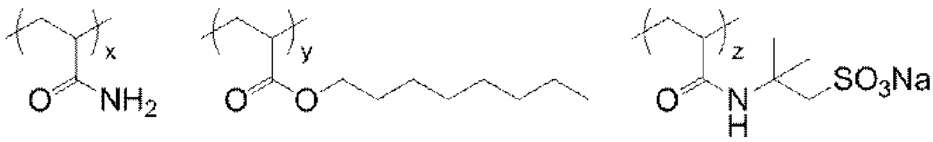

25 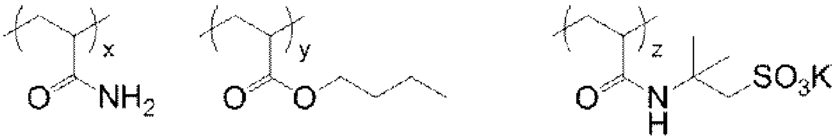

26 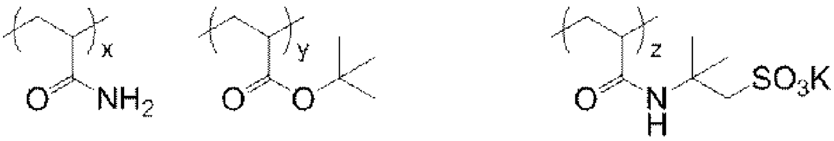

27 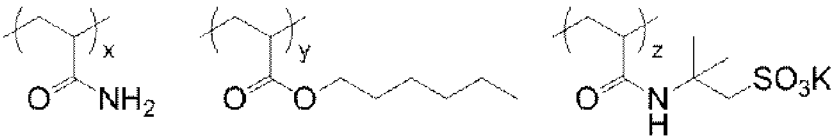

28 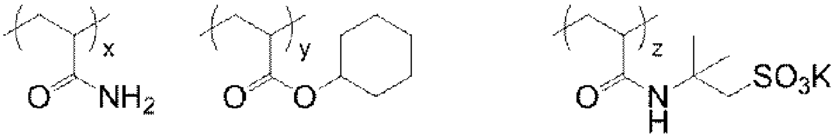

29 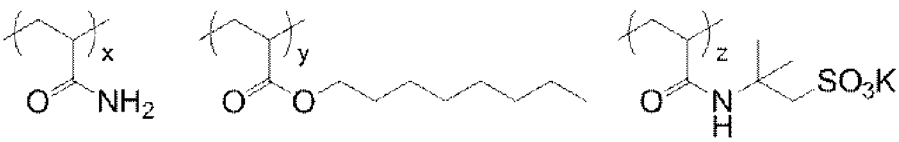

30 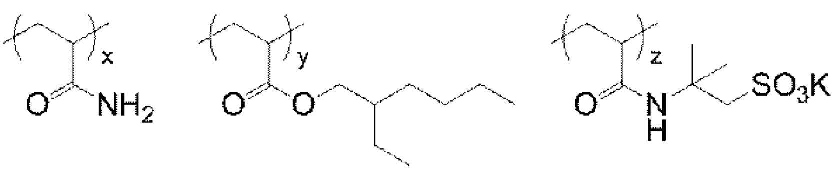

31 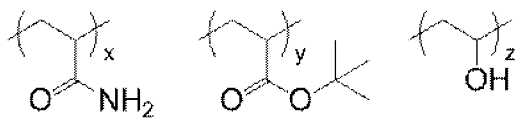

32 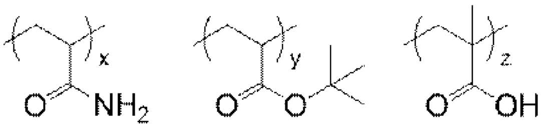

33 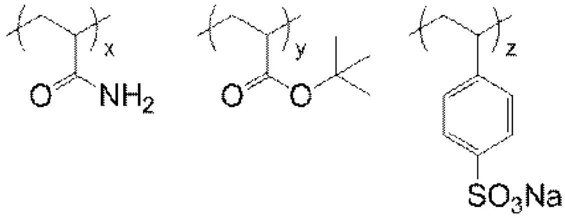

34 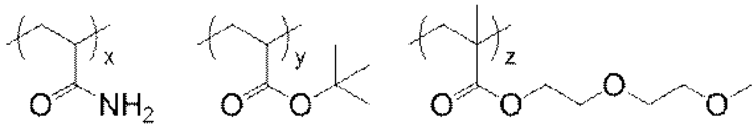

35 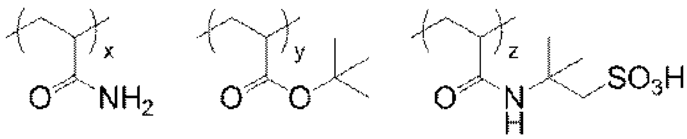

36 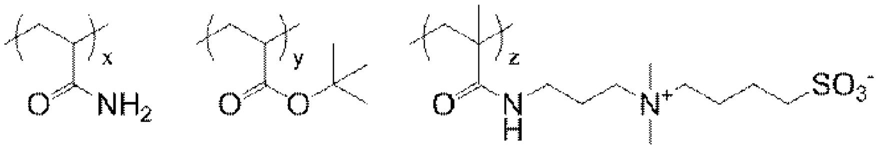

37 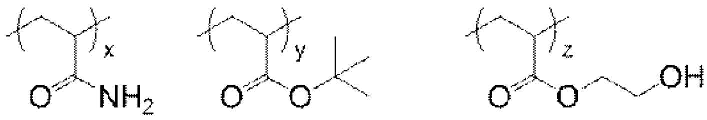

38 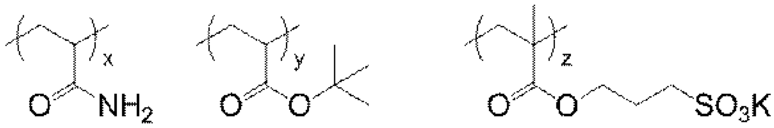

39 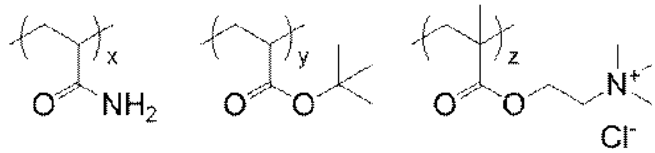

40 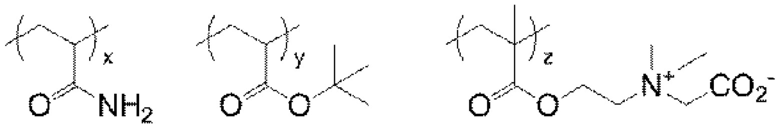

41 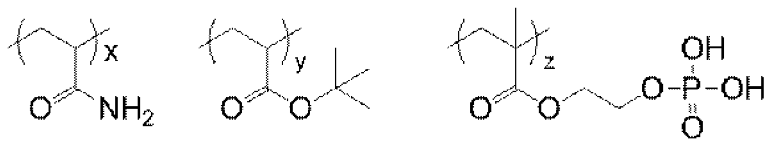

42 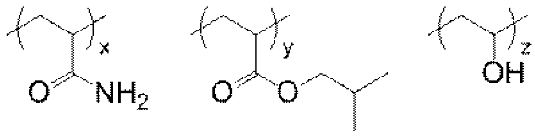

43 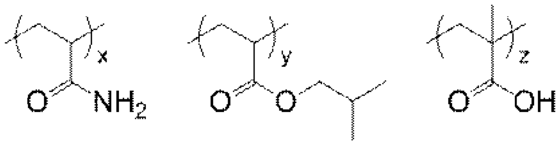

44 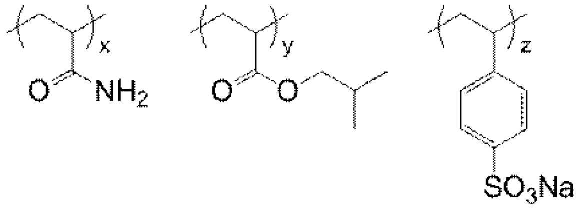

45 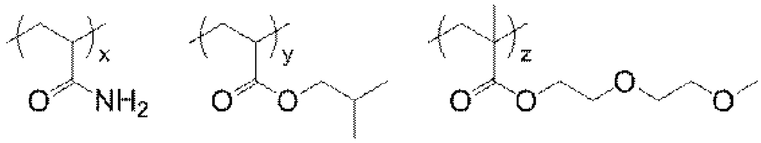

46 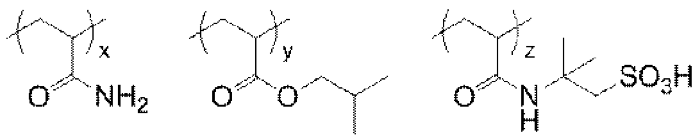

47 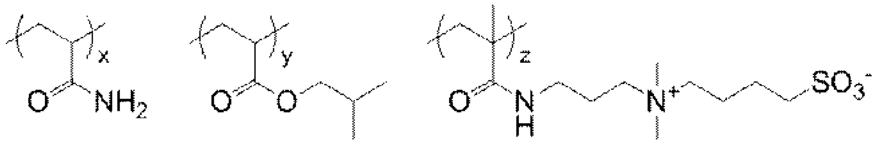

48 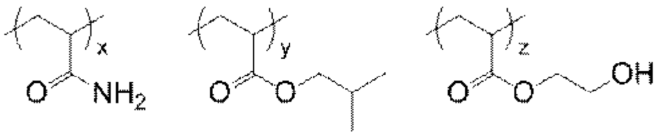

49 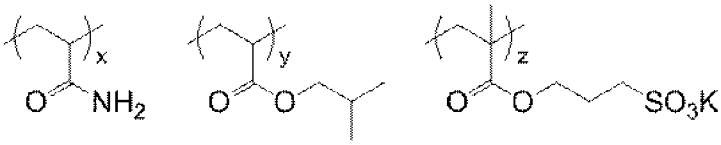

50 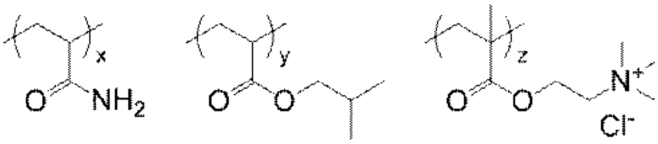

51 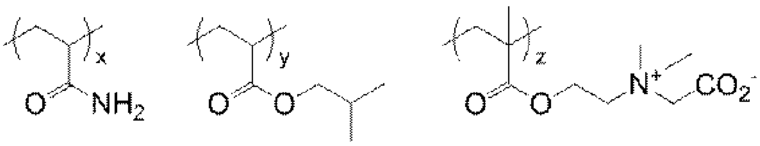

52 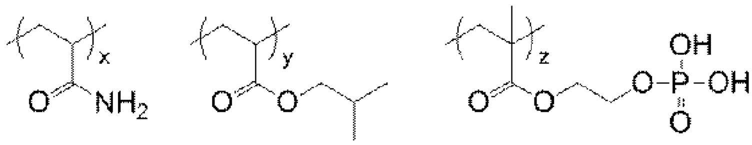

53-57 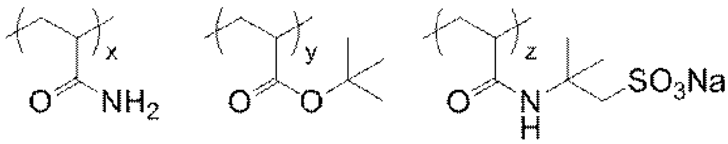

58-62 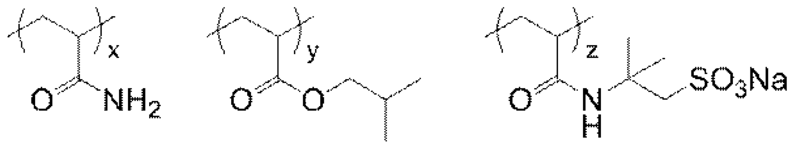

63-67 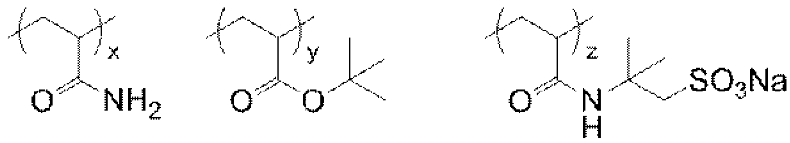

68-72 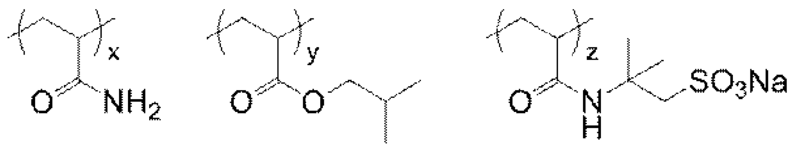

73-77 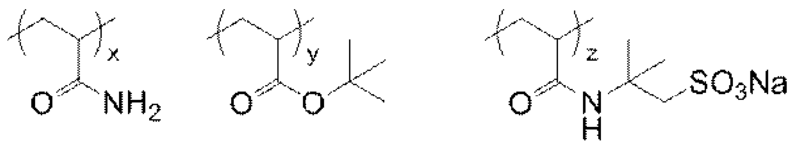

78-82 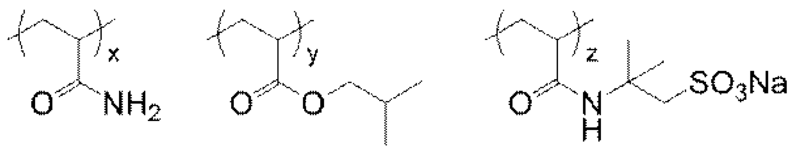

83-87 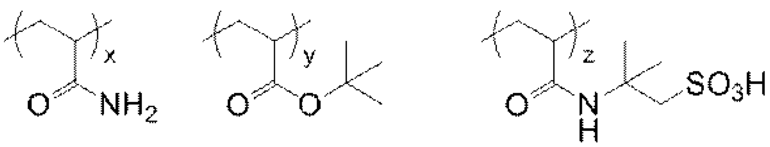

88-92 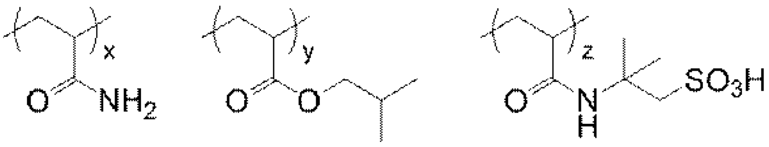

93 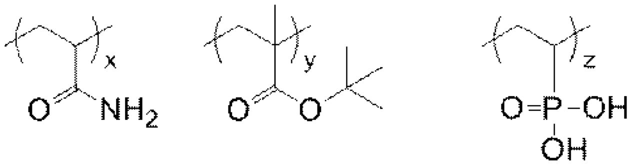

94 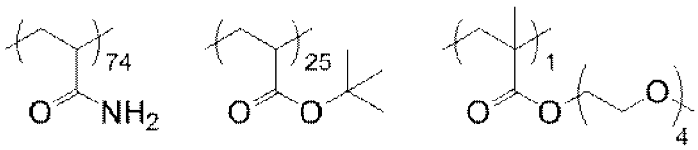

Mw=20, 000

TABLE 12

| Compound Number of Hydrophilic Polymer (e) | Composition Ratio (% by mole) | | | Mw |
|---|---|---|---|---|
| | x | y | z | |
| 1 to 52 | 74 | 25 | 1 | 20,000 |
| 53 | 94 | 5 | 1 | 20,000 |
| 54 | 89 | 10 | 1 | 20,000 |
| 55 | 84 | 15 | 1 | 20,000 |
| 56 | 79 | 20 | 1 | 20,000 |
| 57 | 72 | 27 | 1 | 20,000 |
| 58 | 94 | 5 | 1 | 20,000 |
| 59 | 89 | 10 | 1 | 20,000 |
| 60 | 84 | 15 | 1 | 20,000 |
| 61 | 79 | 20 | 1 | 20,000 |
| 62 | 72 | 27 | 1 | 20,000 |
| 63 | 74 | 25 | 1 | 200,000 |
| 64 | 74 | 25 | 1 | 100,000 |
| 65 | 74 | 25 | 1 | 50,000 |
| 66 | 74 | 25 | 1 | 30,000 |
| 67 | 74 | 25 | 1 | 10,000 |
| 68 | 74 | 25 | 1 | 200,000 |
| 69 | 74 | 25 | 1 | 100,000 |
| 70 | 74 | 25 | 1 | 50,000 |
| 71 | 74 | 25 | 1 | 30,000 |
| 72 | 74 | 25 | 1 | 10,000 |

(continued)

| Compound Number of Hydrophilic Polymer (e) | Composition Ratio (% by mole) | | | Mw |
|---|---|---|---|---|
| | x | y | z | |
| 73 | 74.7 | 25 | 0.3 | 20,000 |
| 74 | 73.5 | 25 | 1.5 | 20,000 |
| 75 | 73 | 25 | 2 | 20,000 |
| 76 | 72 | 25 | 3 | 20,000 |
| 77 | 70 | 25 | 5 | 20,000 |
| 78 | 74.7 | 25 | 0.3 | 20,000 |
| 79 | 73.5 | 25 | 1.5 | 20,000 |
| 80 | 73 | 25 | 2 | 20,000 |
| 81 | 72 | 25 | 3 | 20,000 |
| 82 | 70 | 25 | 5 | 20,000 |
| 83 | 74.7 | 25 | 0.3 | 20,000 |
| 84 | 73.5 | 25 | 1.5 | 20,000 |
| 85 | 73 | 25 | 2 | 20,000 |
| 86 | 72 | 25 | 3 | 20,000 |
| 87 | 70 | 25 | 5 | 20,000 |
| 88 | 74.7 | 25 | 0.3 | 20,000 |
| 89 | 73.5 | 25 | 1.5 | 20,000 |
| 90 | 73 | 25 | 2 | 20,000 |
| 91 | 72 | 25 | 3 | 20,000 |
| 92 | 70 | 25 | 5 | 20,000 |
| 93 | 74 | 25 | 1 | 20,000 |

Also, the protective layer preferably contains an inorganic stratiform compound, for example, natural mica or synthetic mica, as described in JP-A-2005-119273 in order to increase the oxygen blocking property.

Further, the protective layer may contain known additives, for example, a plasticizer for imparting flexibility, a surfactant for improving coating property, an inorganic fine particle for controlling a surface slipping property or an ultraviolet absorbing agent. Moreover, the oil-sensitizing agent described with respect to the image-recording layer may also be incorporated into the protective layer.

The adhesion property to the image-recording layer and scratch resistance are also extremely important in view of handling of the lithographic printing plate precursor. Specifically, when a hydrophilic protective layer containing a water-soluble polymer as the main component is stacked on the oleophilic image-recording layer, layer peeling due to an insufficient adhesion property is liable to occur, and the peeled portion causes such a defect as failure in curing of the image-recording layer due to polymerization inhibition by oxygen. Various proposals have been made for improving the adhesion property between two layers. For example, it is described in JP-B-54-12215 and BP-A-1303578 that a sufficient adhesion property can be obtained by mixing from 20 to 60% by weight of an acryl emulsion or a water-insoluble vinyl pyrrolidone/vinyl acetate copolymer in the protective layer. Any of these known techniques can be applied to the protective layer according to the invention.

As to a coating method of the protective layer, known methods described, for example, in U.S. Patent 3,458,311 and JP-B-55-49729 can be applied. The coating amount of the protective layer is preferably in a range from 0.01 to 10 $g/m^2$, more preferably in a range from 0.02 to 3 $g/m^2$, most preferably in a range from 0.02 to 1 $g/m^2$, in terms of the coating amount after drying.

Thus, a light-sensitive lithographic printing plate precursor applied to the method according to the invention can be obtained.

[Plate making method]

The plate making method of the lithographic printing plate according to the invention is preferably a method including at least a process of image exposure of the lithographic printing plate precursor (hereinafter, also referred to as an "exposure process") and a process of development processing of the exposed lithographic printing plate precursor with a processing solution (hereinafter, also referred to as a "development process").

<Exposure process>

The lithographic printing plate precursor for use in the invention is exposed using a light source of wavelength from 750 to 1,400 nm. As such a light source, a solid laser or semiconductor laser emitting an infrared ray is preferably used, and in particular, a method of conducting scanning exposure by such an infrared laser is preferred. The exposure mechanism may be any of an internal drum system, an external drum system and a flatbed system.

<Development process>

After the exposure, the lithographic printing plate precursor for use in the invention is developed with water or a developer having pH from 2 to 14 (developer processing) or developed with at least one of oily ink and an aqueous component on a printing machine (on-press development).

The developer processing is ordinarily practiced according to the following processes: (1) removing the non-image area with a developer, (2) conducting gumming solution treatment and (3) drying in a drying process. Although the lithographic printing plate precursor for use in the invention can be developed according to the ordinary processes described above (conventional development), it is preferred to conduct processes (1) and (2) simultaneously (simple development). In any of the development methods, a water washing process for removing a protective layer may be provided before process (1). The development of process (1) is conducted according to a conventional manner at temperature approximately from 0 to 60°C, preferably approximately from 15 to 40°C, using, for example, a method wherein the lithographic printing plate precursor subjected to the exposure treatment is immersed in a developer and rubbed with a brush or a method wherein a developer is sprayed to the lithographic printing plate precursor subjected to the exposure treatment by a spray and the lithographic printing plate precursor is rubbed with a brush.

In the case of the conventional development, a water washing process for removing an excess developer may be provided between process (1) and process (2). The developer used in process (1) is preferably a known alkali developer.

In the case of the simple development, it is preferred that after the development and gumming treatment, an excess developer is removed using a squeeze roller and then drying is conducted.

The developer for use in the simple development is an aqueous solution having pH from 2 to 11. An aqueous solution containing water as the main component (containing 60% by weight or more of water) is preferred. In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is preferably from 5 to 10.7, more preferably from 6 to 10.5, and most preferably from 7.5 to 10.3.

Further, in the plate making process of preparing a lithographic printing plate from the lithographic printing plate precursor according to the invention, the lithographic printing plate precursor may be heated its entire surface before or during the exposure or between the exposure and the development, if desired. By the heating, the image-forming reaction in the image-recording layer is accelerated and advantages, for example, improvement in the sensitivity and printing durability and stabilization of the sensitivity are achieved. For the purpose of increasing the image strength and printing durability, it is also effective to perform entire surface after-heating or entire surface exposure of the image after the development. Ordinarily, the heating before the development is preferably performed under a mild condition of 150°C or lower. When the temperature is too high, a problem may arise sometimes in that the unexposed area is also cured. In the heating after the development, very strong conditions are utilized. Ordinarily, the temperature is in a range from 100 to 500°C. When the temperature is too low, a sufficient effect of strengthening the image may not be obtained, whereas when it is excessively high, problems of deterioration of the support and thermal decomposition of the image area may occur sometimes.

The lithographic printing plate precursor according to the invention can also be subjected to plate making by an on-press development method. The on-press development method includes a process in which the lithographic printing plate precursor is imagewise exposed and a printing process in which at least one of oily ink and an aqueous component is supplied to the exposed lithographic printing plate precursor without undergoing any development processing to perform printing, and it is characterized in that the unexposed area of the lithographic printing plate precursor is removed in the course of the printing process. That is to say, according to the on-press development method, a lithographic

printing plate precursor of on-press development type is image-exposed by an infrared laser, the exposed lithographic printing plate precursor is mounted on a printing machine (typically, a cylinder of printing machine), and the unexposed area of the image-recording layer is removed with at least one of oily ink and an aqueous component.

The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing process. Then, the printing operation is initiated using the printing machine with supplying at least one of oily ink and an aqueous component and at an early stage of the printing the on-press development is carried out. Specifically, the image-recording layer in the unexposed area is removed and the hydrophilic surface of support is revealed therewith to form the non-image area. As the oily ink and the aqueous component, printing ink and dampening water for conventional lithographic printing can be employed, respectively.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

EXAMPLE

The invention will be described in more detail with reference to the following examples. With respect to the polymer compounds used in the examples, unless otherwise particularly defined, a molecular weight means a weight average molecular weight (Mw) according to GPC method and a ratio of repeating units is indicated in mole percent.

1. Production of lithographic printing plate precursor of on-press development type (for Examples 1 to 98 and Comparative Examples 1 to 13)

<Production of support>

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm$^3$) of pumice having a median size of 25 μm, followed by thorough washing with water. The plate was subjected to etching by immersing in 25% by weight aqueous sodium hydroxide of 45°C for 9 seconds, washed with water, then immersed in a 20% by weight nitric acid solution at 60°C for 20 seconds, and washed with water. The etching amount of the grained surface was about 3 g/m$^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm$^2$ in terms of the peak value of the electric current, and 5% of the electric current flowing from the electric source was divided to the auxiliary anode. The quantity of electricity in the nitric acid electrolysis was 175 C/dm$^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm$^2$ in terms of the quantity of electricity when the aluminum plate functioned as an anode. The plate was then washed with water by spraying.

The plate was then subjected to an anodizing treatment using as an electrolytic solution, 15% by weight sulfuric acid (containing 0.5% by weight of aluminum ion) at a current density of 15 A/dm$^2$ to form a direct current anodized film of 2.5 g/m$^2$, washed with water and dried to produce Support A.

Thereafter, in order to ensure the hydrophilicity of the non-image area, Support A was subjected to silicate treatment using a 2.5% by weight aqueous sodium silicate No. 3 solution at 60°C for 10 seconds and then was washed with water to obtain Support B. The adhesion amount of Si was 10 mg/m$^2$. The center line average roughness (Ra) of the support was measured using a stylus having a diameter of 2 μm and found to be 0.51 μm.

<Formation of undercoat layer>

Coating solution (A) for undercoat layer shown below was coated on Support B described above so as to have a dry coating amount of 20 mg/$m^2$ to produce a support having an undercoat layer shown below.

<Coating solution (A) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

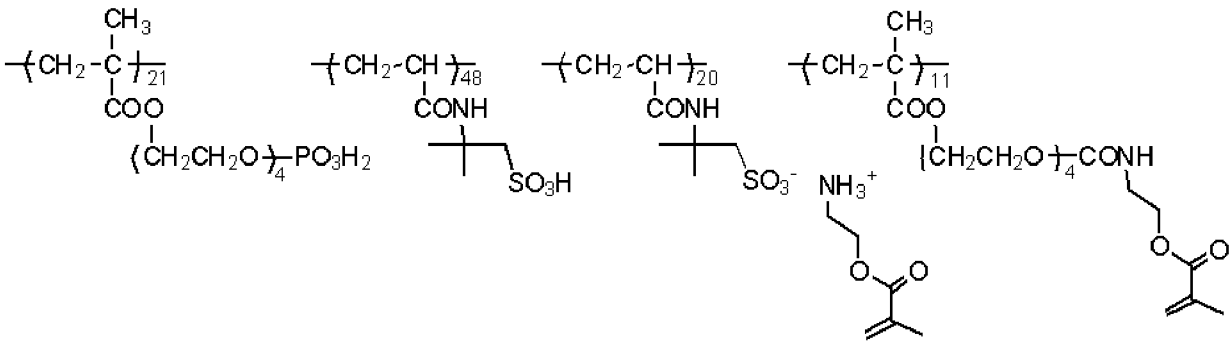

(Mw: 100,000)

Compound (1) for undercoat layer

<Formation of image-recording layer>

Coating solution (1) for image-recording layer having the composition shown below was coated on the undercoat layer formed as described above by a bar and dried in an oven at 100°C for 60 seconds to form an image-recording layer having a dry coating amount of 1.0 g/$m^2$.

Coating solution (1) for image-recording layer was prepared by mixing the photosensitive solution shown below with the microgel solution shown below just before the coating, followed by stirring.

<Photosensitive solution>

| | |
|---|---|
| Binder polymer (2) having structure shown below | 0.240 g |
| IR dye (infrared absorbing agent) (IR-10) | 0.030 g |
| Polyfunctional polymerization inhibitor (C) (compound shown in Table 13) | Amount shown in Table 13 |
| Polymerization initiator (compound shown in Table 13) | 0.200 g |
| Aid (TPB having structure shown below) | 0.4 g (in case of addition) |
| Polymerizable compound | 0.192 g |
| Tris(acryloyloxyethyl) isocyanurate (NK ESTER A-9300, produced by Shin-Nakamura Chemical Co., Ltd.) | |
| Hydrophilic low molecular weight compound Tris(2-hydroxyethyl) isocyanurate | 0.062 g |
| Hydrophilic low molecular weight compound (1) having structure shown below | 0.050 g |
| Oil-sensitizing agent (Phosphonium compound (1) having structure shown below) | 0.055 g |
| Oil-sensitizing agent | 0.018 g |

(continued)

| | |
|---|---|
| Benzyl dimethyl octyl ammonium $PF_6$ salt | |
| Oil-sensitizing agent (Ammonium group-containing polymer having structure shown below (reduced specific viscosity: 44 ml/g)) | 0.035 g |
| Fluorine-based surfactant (1) | 0.008 g |
| 2-Butanone | 1.091 g |
| 1-Methoxy-2-propanol | 8.609 g |

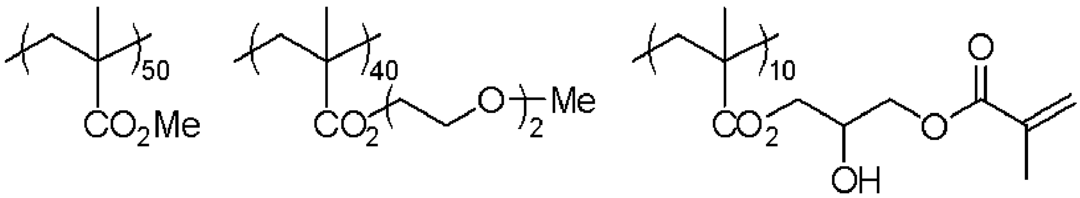

(Mw:70,000)

Binder polymer (2)

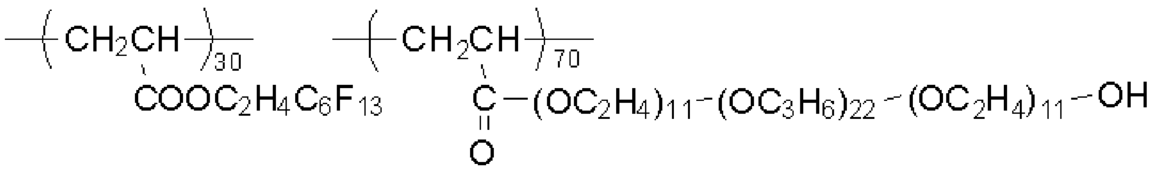

(Mw13,000)

Fluorine-based surfactant (1)

<Microgel solution>

| | |
|---|---|
| Microgel | 2.640 g |
| Distilled water | 2.425 g |

The structures of Hydrophilic low molecular weight compound (1), Phosphonium compound (1), Ammonium group-containing polymer and TPB used in Coating solution (1) for image-recording layer, and the synthesis method of microgel used in Coating solution (1) for image-recording layer are as shown below.

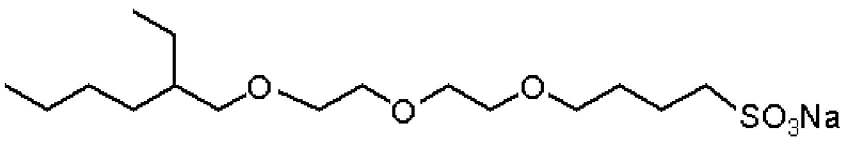

Hydrophilic low molecular weight compound (1)

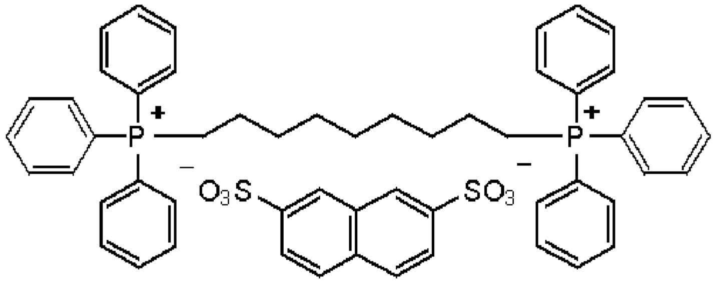

Phosphonium compound (1)

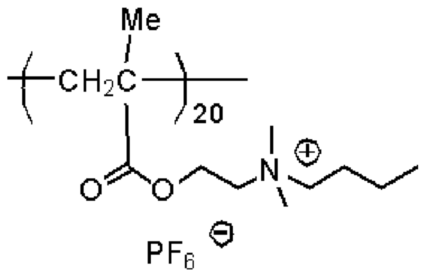

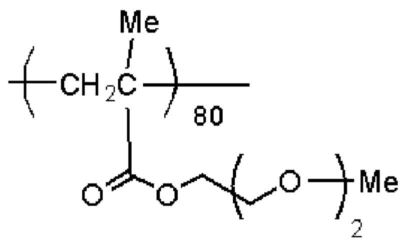

Ammonium group-containing polymer

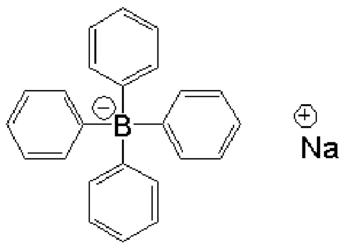

TPB

Also, Polymerization inhibitors T-2 and R-1 to R-8 and Polymerization initiators S-1 and I-1 shown in Table 13 are as shown below.

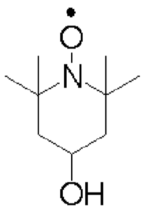

T-2

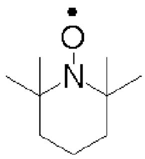

R-1

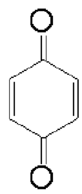

R-2

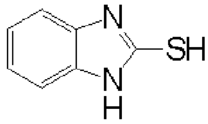

R-3

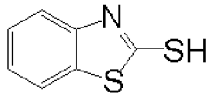

R-4

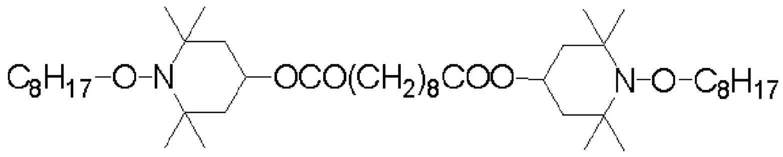

R-5

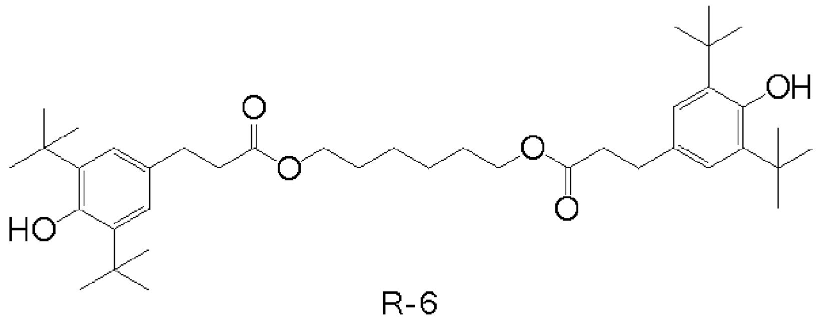

R-6

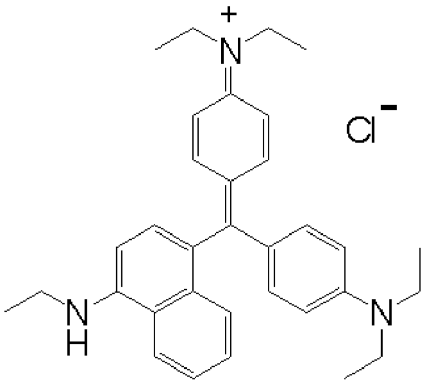

R-7

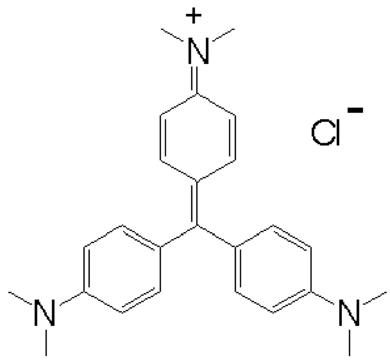

R-8

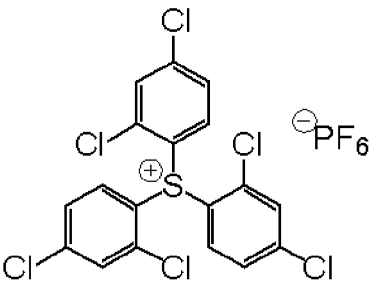

S-1

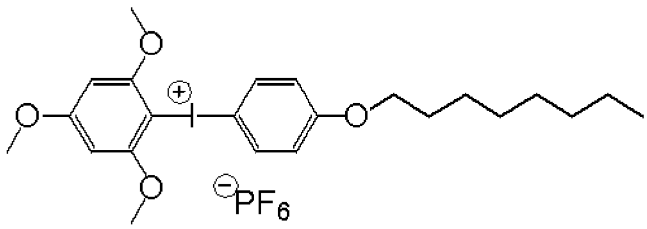

I-1

<Synthesis of microgel>

An oil phase component was prepared by dissolving 10 g of adduct of trimethylolpropane and xylene diisocyanate (TAKENATE D-110N, produced by Mitsui Chemicals Inc.), 3.15 g of pentaerythritol triacrylate (SR444, produced by Nippon Kayaku Co., Ltd.) and 0.1 g of an alkylbenzenesulfonate (PIONIN A-41C, produced by Takemoto Oil & Fat Co., Ltd.) in 17 g of ethyl acetate. As an aqueous phase component, 40 g of an aqueous 4% by weight solution of polyvinyl alcohol (PVA-205, produced by Kuraray Co., Ltd) was prepared. The oil phase component and the aqueous phase component were mixed and the mixture was emulsified using a homogenizer at 12,000 rpm for 10 minutes. The resulting emulsion was added to 25 g of distilled water and stirred at room temperature for 30 minutes and then at 50°C for 3

hours. The microgel liquid thus-obtained was diluted using distilled water so as to have the solid content concentration of 15% by weight to prepare the microgel. The average particle size of the microgel was measured by a light scattering method and found to be 0.2 μm.

<Formation of protective layer>

Coating solution for protective layer having the composition shown below was further coated on the image-recording layer described above by a bar and dried in an oven at 120°C for 60 seconds to form a protective layer having a dry coating amount of 0.15 g/m$^2$, thereby producing a lithographic printing plate precursor.

<Coating solution for protective layer>

| | |
|---|---|
| Dispersion of inorganic stratiform compound (1) | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of polyoxyethylene lauryl ether (surfactant, EMALEX 710, produced by Nihon Emulsion Co., Ltd.) | 0.86 g |
| Ion-exchanged water | 6.0 g |

<Preparation of Dispersion of inorganic stratiform compound (1)>

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm. The aspect ratio of the particle thus-dispersed was 100 or more.

<Evaluation of lithographic printing plate precursor>

(i) On-press development property

The lithographic printing plate precursor obtained was exposed by LUXEL PLATESETTER T-6000III equipped with an infrared semiconductor laser (produced by Fujifilm Corp.) under the conditions of a rotational number of an external drum of 1,000 rpm, laser output of 70% and resolution of 2,400 dpi. The exposed image contained a solid image and a 50% halftone dot chart of a 20 μm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by Fujifilm Corp.)/tap water = 2/98 (by volume ratio)) and SPACE COLOR FUSION-G (N) Black Ink (produced by DIC Graphics Corp.), the dampening water and ink were supplied according to the standard automatic printing start method of LITHRONE 26 to conduct printing on 100 sheets of TOKUBISHI art paper (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property.

The results are shown in Table 13.

(ii) Printing durability

After performing the evaluation for the on-press development property just after the production described above, the printing was continued. As the increase in a number of printing papers, the image-recording layer was gradually abraded to cause decrease in the ink density on a printed material. A number of printed materials wherein a value obtained by measuring a halftone dot area ratio of the 50% halftone dot of FM screen on the printed material using a Gretag densitometer decreased by 5% from the value measured on the 100th paper of the printing was regarded as a number of printed materials at the completion of printing to evaluate the printing durability. The results are shown in

Table 13.

(iii) Tone reproducibility

The lithographic printing plate precursor obtained was exposed under the conditions shown below in the same manner as in the evaluation for the on-press development property described above, conducted the on-press development in the same manner as described above, and a halftone dot area ratio of the exposed area and the unexposed area on the 100th printed material was measured by a halftone dot percent measuring device iCPlate II to evaluate. As the evaluation result is closer to 50, it is meant that the tone reproducibility is more excellent. The results are shown in Table 13. As to the exposure conditions, the exposure was conducted by LUXEL PLATESETTER T-6000III (produced by Fujifilm Corp.) under the conditions of a rotational number of an external drum of 400 rpm, laser output of 85% and resolution of 2,400 dpi. The exposed image contained a 50% halftone dot chart of AM 200 lines.

TABLE 13

| | Polymerization Inhibitor | Addition Amount of Polymerization Inhibitor (% by mole to Polymerization Initiator) | Polymerization Initiator | Aid | Printing Durability (10,000 sheets) | Tone Reproducibility (%) | On-press Development Property (sheets) |
|---|---|---|---|---|---|---|---|
| *Example 1 | PFT-1 | 5.0 | S-1 | TPB | 8.0 | 51 | 30 |
| *Example 2 | PFT-2 | 3.3 | S-1 | TPB | 9.0 | 51 | 30 |
| *Example 3 | PFT-3 | 3.0 | S-1 | TPB | 10.0 | 50 | 30 |
| *Example 4 | PFT-4 | 2.5 | S-1 | TPB | 9.0 | 51 | 30 |
| *Example 5 | PFT-5 | 2.5 | S-1 | TPB | 10.0 | 51 | 30 |
| *Example 6 | PFT-6 | 2.5 | S-1 | TPB | 10.0 | 51 | 30 |
| *Example 7 | PFT-7 | 1.5 | S-1 | TPB | 10.0 | 51 | 30 |
| *Example 8 | PFT-12 | 3.0 | S-1 | TPB | 10.0 | 50 | 30 |
| *Example 9 | PFT-13 | 3.3 | S-1 | TPB | 10.0 | 50 | 30 |
| *Example 10 | PFT-14 | 2.5 | S-1 | TPB | 9.5 | 51 | 30 |
| *Example 11 | PFT-17 | 5.0 | S-1 | TPB | 8.5 | 51 | 30 |
| *Example 12 | PFT-18 | 3.3 | S-1 | TPB | 9.5 | 51 | 30 |
| *Example 13 | PFT-19 | 3.0 | S-1 | TPB | 10.0 | 50 | 30 |
| *Example 14 | PFT-20 | 2.5 | S-1 | TPB | 9.0 | 52 | 30 |
| *Example 15 | PFT-21 | 2.5 | S-1 | TPB | 10.0 | 50 | 30 |
| *Example 16 | PFT-22 | 2.5 | S-1 | TPB | 10.0 | 50 | 30 |
| *Example 17 | PFT-23 | 1.7 | S-1 | TPB | 10.0 | 51 | 30 |
| *Example 18 | PFT-24 | 5.0 | S-1 | TPB | 8.5 | 51 | 30 |
| *Example 19 | PFT-25 | 3.3 | S-1 | TPB | 10.0 | 50 | 30 |
| *Example 20 | PFT-39 | 5.0 | S-1 | TPB | 8.0 | 51 | 30 |
| *Example 21 | PFT-40 | 3.3 | S-1 | TPB | 8.5 | 51 | 30 |
| *Examp le 22 | PFT-46 | 5.0 | S-1 | TPB | 8.0 | 52 | 30 |
| *Example 23 | PFT-55 | 3.3 | S-1 | TPB | 8.0 | 51 | 30 |
| *Example 24 | PFT-73 | 3.0 | S-1 | TPB | 8.0 | 52 | 30 |

(continued)

| | Polymerization Inhibitor | Addition Amount of Polymerization Inhibitor (% by mole to Polymerization Initiator) | Polymerization Initiator | Aid | Printing Durability (10,000 sheets) | Tone Reproducibility (%) | On-press Development Property (sheets) |
|---|---|---|---|---|---|---|---|
| *Example 25 | PFT-89 | 1.5 | S-1 | TPB | 8.0 | 51 | 30 |
| *Example 26 | PFT-12 | 3.0 | I-1 | -- | 6.0 | 50 | 30 |
| *Example 27 | PFT-12 | 3.0 | S-1 | -- | 8.0 | 50 | 30 |
| *Example 28 | PFT-12 | 3.0 | I-1 | TPB | 9.0 | 50 | 30 |
| Example 29 | PFBQ-1 | 7.5 | S-1 | TPB | 8.5 | 51 | 30 |
| Example 30 | PFBQ-2 | 5.0 | S-1 | TPB | 9.0 | 51 | 30 |
| Example 31 | PFBQ-3 | 4.0 | S-1 | TPB | 10.0 | 50 | 30 |
| Example 32 | PFBQ-4 | 5.0 | S-1 | TPB | 10.0 | 50 | 30 |
| Example 33 | PFBQ-5 | 7.5 | S-1 | TPB | 8.5 | 51 | 30 |
| Example 34 | PFBQ-6 | 5.0 | S-1 | TPB | 9.5 | 51 | 30 |
| Example 35 | PFBQ-7 | 4.0 | S-1 | TPB | 10.0 | 50 | 30 |
| Example 36 | PFBQ-8 | 5.0 | S-1 | TPB | 10.0 | 50 | 30 |
| Example 37 | PFBQ-9 | 7.5 | S-1 | TPB | 8.5 | 51 | 30 |
| Example 38 | PFBQ-10 | 5.0 | S-1 | TPB | 9.5 | 51 | 30 |
| Example 39 | PFBQ-11 | 5.0 | S-1 | TPB | 10.0 | 50 | 30 |
| Example 40 | PFBQ-12 | 5.0 | S-1 | TPB | 10.0 | 50 | 30 |
| Example 41 | PFBQ-13 | 4.0 | S-1 | TPB | 9.5 | 50 | 30 |
| Example 42 | PFBQ-14 | 2.5 | S-1 | TPB | 9.5 | 51 | 30 |
| Example 43 | PFBQ-22 | 5.0 | S-1 | TPB | 10.0 | 50 | 30 |
| Example 44 | PFBQ-23 | 5.0 | S-1 | TPB | 10.0 | 50 | 30 |
| Example 45 | PFBQ-25 | 2.5 | S-1 | TPB | 9.5 | 51 | 30 |
| Example 46 | PFBQ-30 | 4.0 | S-1 | TPB | 8.5 | 51 | 30 |
| Example 47 | PFBQ-32 | 4.0 | S-1 | TPB | 10.0 | 50 | 30 |
| Example 48 | PFBQ-34 | 7.5 | S-1 | TPB | 8.5 | 51 | 30 |

(continued)

| | Polymerization Inhibitor | Addition Amount of Polymerization Inhibitor (% by mole to Polymerization Initiator) | Polymerization Initiator | Aid | Printing Durability (10,000 sheets) | Tone Reproducibility (%) | On-press Development Property (sheets) |
|---|---|---|---|---|---|---|---|
| Example 49 | PFBQ-35 | 5.0 | S-1 | TPB | 10.0 | 50 | 30 |
| Example 50 | PFBQ-38 | 5.0 | S-1 | TPB | 10.0 | 50 | 30 |
| Example 51 | PFBQ-39 | 4.0 | S-1 | TPB | 8.5 | 51 | 30 |
| Example 52 | PFBQ-47 | 5.0 | S-1 | TPB | 10.0 | 50 | 30 |
| Example 53 | PFBQ-48 | 5.0 | S-1 | TPB | 10.0 | 50 | 30 |
| Example 54 | PFBQ-49 | 4.0 | S-1 | TPB | 9.0 | 51 | 30 |
| Example 55 | PFBQ-60 | 4.0 | S-1 | TPB | 9.0 | 51 | 30 |
| Example 56 | PFBQ-73 | 5.0 | S-1 | TPB | 9.0 | 51 | 30 |
| Example 57 | PFBQ-75 | 4.0 | S-1 | TPB | 8.5 | 51 | 30 |
| Example 58 | PFBQ-83 | 5.0 | S-1 | TPB | 10.0 | 50 | 30 |
| Example 59 | PFBQ-84 | 5.0 | S-1 | TPB | 10.0 | 51 | 30 |
| Example 60 | PFBQ-85 | 4.0 | S-1 | TPB | 9.5 | 51 | 30 |
| Example 61 | PFBQ-101 | 7.5 | S-1 | TPB | 8.5 | 51 | 30 |
| Example 62 | PFBQ-103 | 4.0 | S-1 | TPB | 10.0 | 51 | 30 |
| Example 63 | PFBQ-123 | 5.0 | S-1 | TPB | 10.0 | 50 | 30 |
| Example 64 | PFBQ-124 | 4.0 | S-1 | TPB | 9.5 | 51 | 30 |
| Example 65 | PFBQ-138 | 5.0 | S-1 | TPB | 8.0 | 51 | 30 |
| Example 66 | PFBQ-161 | 5.0 | S-1 | TPB | 10.0 | 50 | 30 |
| Example 67 | PFBQ-162 | 4.0 | S-1 | TPB | 8.5 | 51 | 30 |
| Example 68 | PFBQ-163 | 4.0 | S-1 | TPB | 10.0 | 51 | 30 |
| Example 69 | PFBQ-164 | 4.0 | S-1 | TPB | 10.0 | 50 | 30 |
| Example 70 | PFBQ-23 | 5.0 | I-1 | -- | 6.0 | 50 | 30 |
| Example 71 | PFBQ-23 | 5.0 | S-1 | -- | 8.0 | 50 | 30 |
| Example 72 | PFBQ-23 | 5.0 | I-1 | TPB | 9.0 | 50 | 30 |

(continued)

| | Polymerizatio n Inhibitor | Addition Amount of Polymerization Inhibitor (% by mole to Polymerization Initiator) | Polymerization Initiator | Aid | Printing Durability (10,000 sheets) | Tone Reproducibility (%) | On-press Development Property (sheets) |
|---|---|---|---|---|---|---|---|
| *Example 73 | PFMB-1 | 10.0 | S-1 | TPB | 8.5 | 51 | 30 |
| *Example 74 | PFMB-2 | 7.0 | S-1 | TPB | 9.5 | 51 | 30 |
| *Example 75 | PFMB-3 | 7.0 | S-1 | TPB | 10.0 | 51 | 30 |
| *Example 76 | PFMB-4 | 5.0 | S-1 | TPB | 9.0 | 51 | 30 |
| *Example 77 | PFMB-5 | 5.0 | S-1 | TPB | 10.0 | 50 | 30 |
| *Example 78 | PFMB-6 | 5.0 | S-1 | TPB | 10.0 | 50 | 30 |
| *Examp le 79 | PFMB-7 | 4.0 | S-1 | TPB | 10.0 | 50 | 30 |
| *Example 80 | PFMB-8 | 10.0 | S-1 | TPB | 8.5 | 51 | 30 |
| *Example 81 | PFMB-9 | 7.0 | S-1 | TPB | 10.0 | 50 | 30 |
| *Example 82 | PFMB-29 | 7.0 | S-1 | TPB | 10.0 | 51 | 30 |
| *Example 83 | PFMB-33 | 10.0 | S-1 | TPB | 8.5 | 51 | 30 |
| *Example 84 | PFMB-34 | 7.0 | S-1 | TPB | 9.0 | 51 | 30 |
| *Example 85 | PFMB-35 | 5.0 | S-1 | TPB | 10.0 | 51 | 30 |
| *Example 86 | PFMB-41 | 7.0 | S-1 | TPB | 8.0 | 51 | 30 |
| *Example 87 | PFMB-49 | 7.0 | S-1 | TPB | 8.5 | 51 | 30 |
| *Example 88 | PFMB-51 | 7.0 | S-1 | TPB | 8.5 | 51 | 30 |
| *Example 89 | PFMB-92 | 7.0 | S-1 | TPB | 8.5 | 52 | 30 |
| *Example 90 | PFMB-93 | 5.0 | S-1 | TPB | 8.0 | 52 | 30 |
| *Example 91 | PFMB-118 | 5.0 | S-1 | TPB | 8.0 | 51 | 30 |
| *Example 92 | PFMB-119 | 4.0 | S-1 | TPB | 8.5 | 51 | 30 |
| * Example 93 | PFMB-120 | 7.0 | S-1 | TPB | 8.5 | 52 | 30 |
| *Example 94 | PFMB-5 | 5.0 | I-1 | -- | 6.0 | 50 | 30 |
| *Example 95 | PFMB-5 | 5.0 | S-1 | -- | 8.0 | 50 | 30 |
| *Example 96 | PFMB-5 | 5.0 | I-1 | TPB | 9.0 | 50 | 30 |

(continued)

| | Polymerization Inhibitor | Addition Amount of Polymerization Inhibitor (% by mole to Polymerization Initiator) | Polymerization Initiator | Aid | Printing Durability (10,000 sheets) | Tone Reproducibility (%) | On-press Development Property (sheets) |
|---|---|---|---|---|---|---|---|
| *Example 97 | PFNO-11 | 4.0 | S-1 | TPB | 8.0 | 51 | 30 |
| *Example 98 | PFNI-19 | 7.0 | S-1 | TPB | 8.0 | 51 | 30 |
| Comparative Example 1 | -- | 0.0 | I-1 | -- | 6.0 | 50 | 30 |
| Comparative Example 2 | -- | 0.0 | S-1 | -- | 8.0 | 62 | 30 |
| Comparative Example 3 | -- | 0.0 | I-1 | TPB | 9.0 | 60 | 30 |
| Comparative Example 4 | -- | 0.0 | S-1 | TPB | 10.0 | 65 | 30 |
| Comparative Example 5 | T-2 | 10.0 | S-1 | TPB | 5.5 | 52 | 30 |
| Comparative Example 6 | R-1 | 10.0 | S-1 | TPB | 5.5 | 51 | 30 |
| Comparative Example 7 | R-2 | 15.0 | S-1 | TPB | 6.0 | 51 | 30 |
| Comparative Example 8 | R-3 | 20.0 | S-1 | TPB | 6.0 | 51 | 30 |
| Comparative Example 9 | R-4 | 20.0 | S-1 | TPB | 6.0 | 52 | 30 |
| Comparative Example 10 | R-5 | 20.0 | S-1 | TPB | 7.5 | 60 | 30 |
| Comparative Example 11 | R-6 | 20.0 | S-1 | TPB | 6.0 | 52 | 30 |
| Comparative Example 12 | R-7 | 15.0 | S-1 | TPB | 5.5 | 51 | 30 |

(continued)

| | Polymerization Inhibitor | Addition Amount of Polymerization Inhibitor (% by mole to Polymerization Initiator) | Polymerization Initiator | Aid | Printing Durability (10,000 sheets) | Tone Reproducibility (%) | On-press Development Property (sheets) |
|---|---|---|---|---|---|---|---|
| Comparative Example 13 | R-8 | 15.0 | S-1 | TPB | 6.0 | 52 | 30 |
| *Examples 1-28 and 73-98 denote Reference Embodiments that do not fall within the scope of the present claims. | | | | | | | |

It is apparent that the lithographic printing plate precursors according to the invention do not impair the on-press development property and provide lithographic printing plates exhibiting high printing durability and excellent tone reproducibility in comparison with the comparative examples. It is also apparent from the comparative examples that the monofunctional polymerization inhibitors and other polyfunctional polymerization inhibitors do not exhibit the effects according to the invention.

2. Production of lithographic printing plate precursor of developer processing type (for Examples 110 to 133, Examples 99-109 and 134-141 regarding Reference Embodiments and Comparative Examples 14 to 25)

A lithographic printing plate precursor was prepared in the same method as in Example 1 except for forming the undercoat layer and the image-recording layer as described below and changing the protective layer to the lower protective layer and the upper protective layer as described below.

<Formation of undercoat layer>

Coating solution (B) for undercoat layer shown below was coated on Support B described above so as to have a dry coating amount of 10 mg/m$^2$ to produce a support having an undercoat layer shown below.

<Coating solution (B) for undercoat layer>

Polymer shown below 0.3 parts by weight

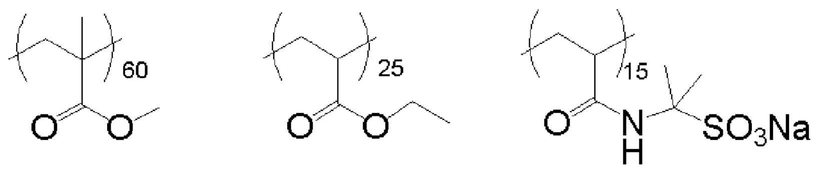

Mw:10000

| | |
|---|---|
| Pure water | 60.0 parts by weight |
| Methanol | 939.7 parts by weight |

<Formation of image-recording layer>

Coating solution (2) for image-recording layer shown below was prepared and coated on the undercoat layer formed as described above using a wire bar to from an image-recording layer. The drying was conducted by a hot air drying device at 125°C for 34 seconds. The coverage after drying was 1.4 g/m$^2$.

<Coating solution (2) for image-recording layer>

| | |
|---|---|
| IR dye (infrared absorbing agent) (IR-9) | 0.38 g |
| Polymerization initiator A (S-2) | 0.31 g |
| Polymerization initiator B (1-2) | 0.84 g |
| Polymerization initiator C (compound shown in Table 14) | 0.51 g |
| Aid (TPB) | 0.32 g (only in case of addition) |
| Mercapto compound (E-1) | 0.15 g |
| Ethylenically unsaturated compound (M-1) (trade name: A-BPE-4, produced by Shin-Nakamura Chemical Co., Ltd.) | 4.25 g |
| Binder polymer A (B-1) (Mw: 110,000) | 3.11 g |
| Binder polymer B (B-2) (Mw: 100,000) | 2.50 g |

(continued)

| | |
|---|---|
| Binder polymer C (B-3) (Mw: 120,000) | 0.62 g |
| Additive (T-1) | 0.79 g |
| Polyfunctional polymerization inhibitor (compound shown in Table 14) | Amount shown in Table 14 |
| Ethyl violet (EV-1) | 0.21 g |
| Fluorine-based surfactant (MEGAFAC F-780-F, produced by DIC Corp., 30% by weight methyl isobutyl ketone (MIBK) solution) | 0.081 g |
| Methyl ethyl ketone | 58.86 g |
| Methanol | 27.33 g |
| 1-Methoxy-2-propanol | 58.86 g |

The structures of Polymerization initiator A (S-2), Polymerization initiator B (1-2), Mercapto compound (E-1), Ethylenically unsaturated compound (M-1), Binder polymer A (B-1), Binder polymer B (B-2), Binder polymer C (B-3), Additive (T-1), Polymerization inhibitor (Q-1) and Ethyl violet (EV-1) used in Coating solution (2) for image-recording layer described above are shown below. Also, the structures of IR dye (infrared absorbing agent) (IR-9), and Compound (S-1) and Compound (1-1) both used as the polymerization initiator C are those as described above.

In the following description, Me represents a methyl group, and a ratio of monomer units in Binder polymers A to C is indicated as a molar ratio.

S-2

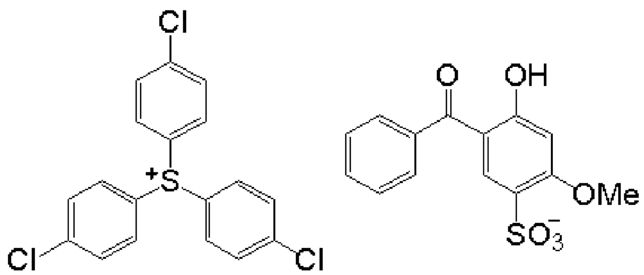

I-2

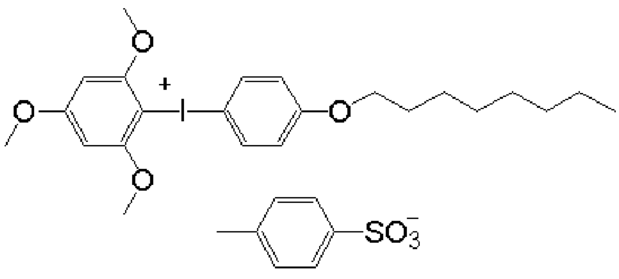

E-1

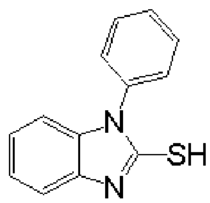

(M-1)

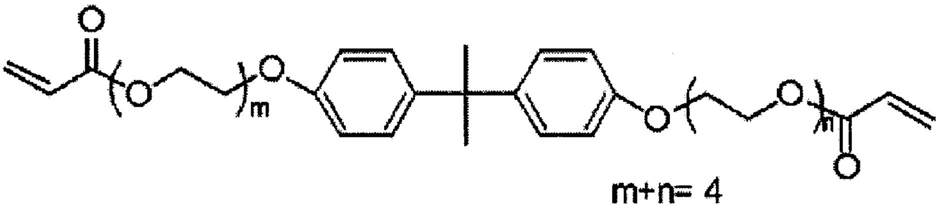

m+n= 4

(B-1)

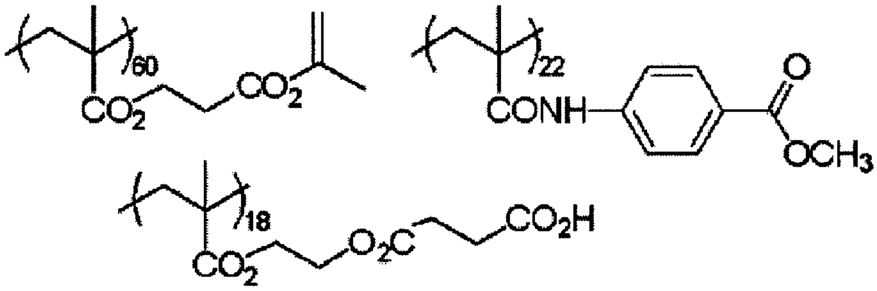

(B-2)

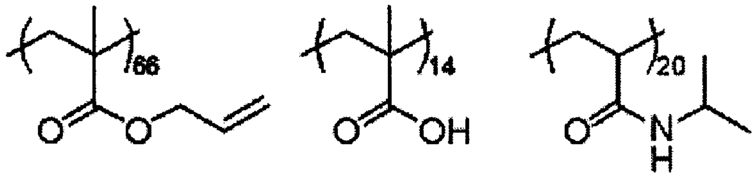

(B-3)

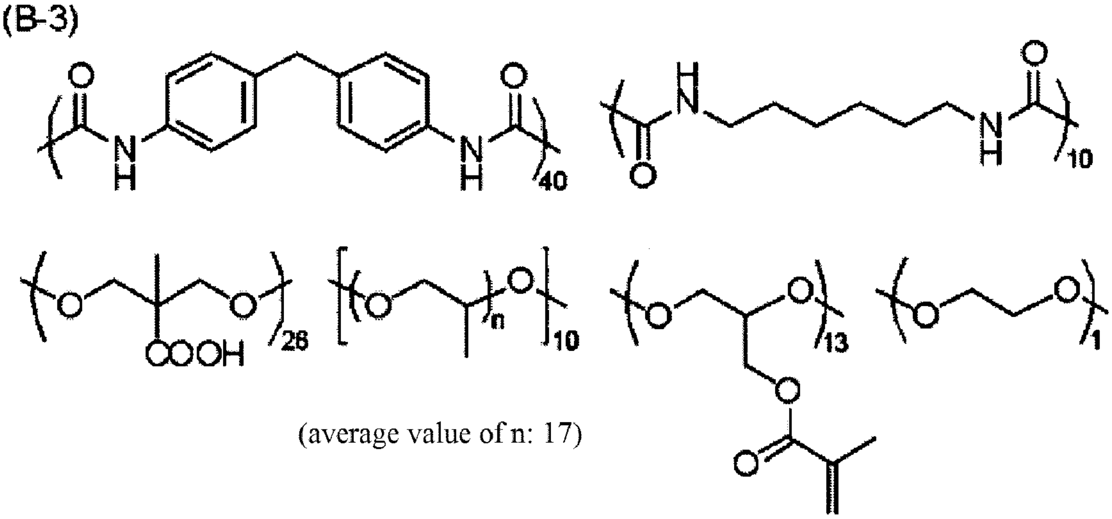

(average value of n: 17)

( T - 1 )

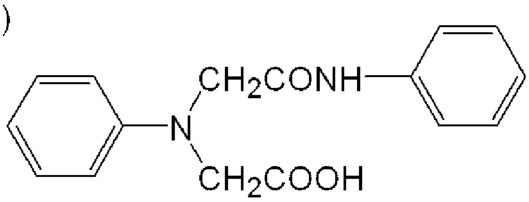

( Q - 1 )

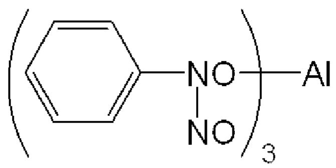

(EV-1)

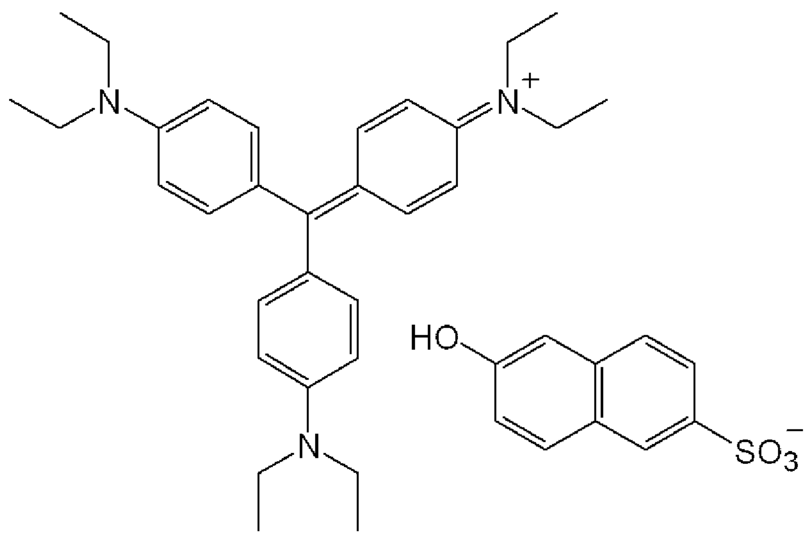

[Formation of lower protective layer]

A mixed aqueous solution (coating solution for forming lower protective layer) composed of synthetic mica (SOMASIF MEB-3L, 3.2% by weight aqueous dispersion, produced by CO-OP Chemical Co., Ltd.), polyvinyl alcohol (GOSERAN CKS-50, saponification degree: 99% by mole, polymerization degree: 300, sulfonic acid-modified polyvinyl alcohol, produced by Nippon Synthetic Chemical Industry Co., Ltd.), Surfactant A (EMALEX 710, produced by Nihon Emulsion Co., Ltd.) and Surfactant B (ADEKA PLURONIC P-84, produced by ADEKA Corp.) was coated on the image-recording layer by a wire bar and dried by a hot air drying device at 125°C for 30 seconds.

The content ratio of synthetic mica (solid content)/polyvinyl alcohol/Surfactant A/Surfactant B in the coating solution for forming lower protective layer was 7.5/89/2/1.5 (in % by weight) and the coating amount (coverage after drying) was 0.5 g/$m^2$.

[Formation of upper protective layer]

A mixed aqueous solution (coating solution for forming upper protective layer) composed of organic filler (ART PEARL J-7P, produced by Negami Chemical Industrial Co., Ltd.), synthetic mica (SOMASIF MEB-3L, 3.2% aqueous dispersion, produced by CO-OP Chemical Co., Ltd.), polyvinyl alcohol (L-3266, saponification degree: 87% by mole, polymerization degree: 300, sulfonic acid-modified polyvinyl alcohol, produced by Nippon Synthetic Chemical Industry Co., Ltd.), thickener (CELLOGEN FS-B, produced by Dai-ichi Kogyo Seiyaku Co., Ltd.) and surfactant (EMALEX 710, produced by Nihon Emulsion Co., Ltd.) was coated on the lower protective layer by a wire bar and dried by a hot air drying device at 125°C for 30 seconds.

The content ratio of organic filler/synthetic mica (solid content)/polyvinyl alcohol/thickener/surfactant in the coating solution for forming upper protective layer was 3.2/2.0/80.5/11.5/2.8 (in % by weight) and the coating amount (coverage after drying) was 1.76 g/$m^2$.

[Plate making method]

The lithographic printing plate precursor obtained was processed according to the order of exposure, development processing and drying.

Light source (setter) used in the exposure: The imagewise exposure was conducted by an infrared semiconductor laser (TRENDSETTER 3244VX, produced by Creo Co., Ltd., equipped with a water-cooled 40 W infrared semiconductor laser) under the conditions of output of 9W, a rotational number of an external drum of 210 rpm and resolution of 2,400 dpi. As to the exposed image, as an image for evaluating reverse thin line, an image including reverse thin lines of from 5 to 100 $\mu$m width (at intervals of 5 $\mu$m) rowed was used. As an image for evaluating printing durability, an image capable of evaluating solid printing durability was used.

After the exposure, water washing processing was conducted in order to remove the overcoat layer, and the development processing was conducted using a solution prepared by diluting Developer HN-D (old product name: DH-N) produced by Fujifilm Corp. with water in a ratio of 1:4. The pH of the developer was 12. The temperature of the

developing bath was 30°C.

The developer was supplied onto the surface of the lithographic printing plate precursor by showering from a spray pipe by a circulation pump. The tank volume of the developer was 10 liters. After the development, water washing processing was conducted in order to remove the developer attached on the surface of the lithographic printing plate precursor.

<Evaluation of lithographic printing plate precursor>

The lithographic printing plate precursor obtained was subjected to the plate making as described above, and the printing durability and the tone reproducibility were evaluated in the same manner as in the lithographic printing plate precursor of on-press development type. The results are shown in Table 14.

TABLE 14

| | Polymerization Inhibitor | Addition Amount of Polymerization Inhibitor (% by mole to Polymerization Initiator) | Initiator C | Aid | Printing Durability (10,000 sheets) | Tone Reproducibility (%) |
|---|---|---|---|---|---|---|
| *Example 99 | PFT-1 | 5.0 | S-1 | TPB | 13.0 | 51 |
| *Example 100 | PFT-2 | 3.3 | S-1 | TPB | 14.0 | 50 |
| *Example 101 | PFT-3 | 3.0 | S-1 | TPB | 15.0 | 50 |
| *Example 102 | PFT-4 | 2.5 | S-1 | TPB | 14.0 | 51 |
| *Example 103 | PFT-5 | 2.5 | S-1 | TPB | 15.0 | 51 |
| *Example 104 | PFT-6 | 2.5 | S-1 | TPB | 15.0 | 51 |
| *Example 105 | PFT-7 | 1.5 | S-1 | TPB | 15.0 | 51 |
| *Example 106 | PFT-12 | 3.0 | S-1 | TPB | 15.0 | 50 |
| *Example 107 | PFT-13 | 3.3 | S-1 | TPB | 15.0 | 50 |
| *Example 108 | PFT-12 | 3.0 | S-1 | -- | 13.0 | 50 |
| *Example 109 | PFT-12 | 3.0 | I-1 | TPB | 14.0 | 50 |
| Example 110 | PFBQ-1 | 7.5 | S-1 | TPB | 13.5 | 51 |
| Example 111 | PFBQ-2 | 5.0 | S-1 | TPB | 14.0 | 51 |
| Example 112 | PFBQ-3 | 4.0 | S-1 | TPB | 15.0 | 50 |
| Example 113 | PFBQ-4 | 5.0 | S-1 | TPB | 15.0 | 50 |
| Example 114 | PFBQ-5 | 7.5 | S-1 | TPB | 13.5 | 51 |
| Example 115 | PFBQ-8 | 5.0 | S-1 | TPB | 15.0 | 50 |
| Example 116 | PFBQ-9 | 7.5 | S-1 | TPB | 13.5 | 51 |
| Example 117 | PFBQ-10 | 5.0 | S-1 | TPB | 14.5 | 51 |
| Example 118 | PFBQ-25 | 2.5 | S-1 | TPB | 14.5 | 51 |
| Example 119 | PFBQ-30 | 4.0 | S-1 | TPB | 13.5 | 51 |

(continued)

| | Polymerization Inhibitor | Addition Amount of Polymerization Inhibitor (% by mole to Polymerization Initiator) | Initiator C | Aid | Printing Durability (10,000 sheets) | Tone Reproducibility (%) |
|---|---|---|---|---|---|---|
| Example 120 | PFBQ-31 | 4.0 | S-1 | TPB | 15.0 | 50 |
| Example 121 | PFBQ-32 | 4.0 | S-1 | TPB | 15.0 | 50 |
| Example 122 | PFBQ-37 | 5.0 | S-1 | TPB | 14.0 | 51 |
| Example 123 | PFBQ-39 | 4.0 | S-1 | TPB | 13.5 | 51 |
| Example 124 | PFBQ-59 | 5.0 | S-1 | TPB | 15.0 | 51 |
| Example 125 | PFBQ-73 | 5.0 | S-1 | TPB | 14.0 | 51 |
| Example 126 | PFBQ-74 | 5.0 | S-1 | TPB | 15.0 | 50 |
| Example 127 | PFBQ-75 | 4.0 | S-1 | TPB | 13.5 | 51 |
| Example 128 | PFBQ-84 | 5.0 | S-1 | TPB | 15.0 | 51 |
| Example 129 | PFBQ-124 | 4.0 | S-1 | TPB | 14.5 | 50 |
| Example 130 | PFBQ-138 | 5.0 | S-1 | TPB | 13.0 | 51 |
| Example 131 | PFBQ-164 | 4.0 | S-1 | TPB | 15.0 | 50 |
| Example 132 | PFBQ-23 | 5.0 | S-1 | -- | 13.0 | 50 |
| Example 133 | PFBQ-23 | 5.0 | I-1 | TPB | 14.0 | 50 |
| *Example 134 | PFMB-1 | 10.0 | S-1 | TPB | 13.5 | 51 |
| *Example 135 | PFMB-2 | 7.0 | S-1 | TPB | 14.5 | 50 |
| *Example 136 | PFMB-3 | 7.0 | S-1 | TPB | 15.0 | 50 |
| *Example 137 | PFMB-4 | 5.0 | S-1 | TPB | 14.0 | 50 |
| *Example 138 | PFMB-5 | 5.0 | S-1 | -- | 13.0 | 50 |
| *Example 139 | PFMB-5 | 5.0 | I-1 | TPB | 14.0 | 50 |
| *Example 140 | PFNO-11 | 4.0 | S-1 | TPB | 13.0 | 51 |
| *Example 141 | PFNI-19 | 7.0 | S-1 | TPB | 13.0 | 51 |
| Comparative Example 14 | -- | 0.0 | S-1 | -- | 13.0 | 58 |
| Comparative Example 15 | -- | 0.0 | S-1 | TPB | 15.0 | 60 |
| Comparative Example 16 | T-2 | 10.0 | S-1 | TPB | 10.5 | 52 |
| Comparative Example 17 | R-1 | 10.0 | S-1 | TPB | 10.5 | 51 |
| Comparative Example 18 | R-2 | 15.0 | S-1 | TPB | 11.0 | 51 |

(continued)

| | Polymerization Inhibitor | Addition Amount of Polymerization Inhibitor (% by mole to Polymerization Initiator) | Initiator C | Aid | Printing Durability (10,000 sheets) | Tone Reproducibility (%) |
|---|---|---|---|---|---|---|
| Comparative Example 19 | R-3 | 20.0 | S-1 | TPB | 11.0 | 51 |
| Comparative Example 20 | R-4 | 20.0 | S-1 | TPB | 11.0 | 51 |
| Comparative Example 21 | R-5 | 20.0 | S-1 | TPB | 12.5 | 59 |
| Comparative Example 22 | R-6 | 20.0 | S-1 | TPB | 11.0 | 51 |
| Comparative Example 23 | R-7 | 15.0 | S-1 | TPB | 10.5 | 50 |
| Comparative Example 24 | R-8 | 15.0 | S-1 | TPB | 11.0 | 51 |
| Comparative Example 25 | Q-1 | 10.0 | S-1 | TPB | 11.0 | 51 |
| * denote Reference Embodiments that do not fall within the scope of the present claims | | | | | | |

It is apparent that as to the lithographic printing plate precursors according to the invention, the lithographic printing plate exhibits high printing durability and excellent tone reproducibility. It is also apparent from the comparative examples that the monofunctional polymerization inhibitors and other polyfunctional polymerization inhibitors do not exhibit the effects according to the invention.

INDUSTRIAL APPLICABILITY

According to the invention, a lithographic printing plate precursor which is capable of being directly recorded from digital data, for example, of a computer, which has high sensitivity, which prevents an undesirable curing reaction in the non-image area from proceeding, and which provides high printing durability can be obtained.

## Claims

1. A lithographic printing plate precursor comprising a support having provided thereon an image-recording layer containing (A) a radical polymerization initiator, (B) a radical polymerizable compound, and (C) a polyfunctional polymerization inhibitor, wherein the polyfunctional polymerization inhibitor (C) has, in a molecule thereof, two or more radical trapping sites to form a covalent bond by directly connecting with a radical,
wherein radical trapping sites include one, two or more benzoquinone sites.

2. The lithographic printing plate precursor as claimed in Claim 1, wherein the benzoquinone site has the following structure, in which X represents S or NH:

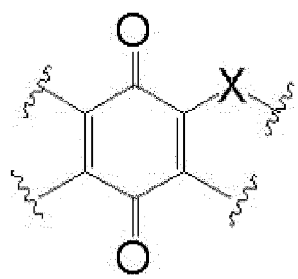

3. The lithographic printing plate precursor as claimed in Claim 2, wherein X is S.

4. The lithographic printing plate precursor as claimed in Claim 1, wherein the polyfunctional polymerization inhibitor (C) in addition has a 4-substituted-2,2,6,6-tetramethylpiperidin-1-oxyl free radical site shown below:

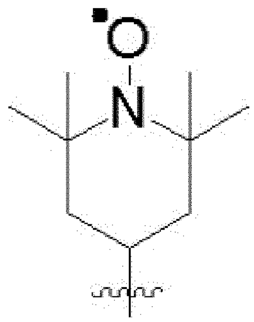

5. The lithographic printing plate precursor as claimed in Claim 1, wherein the polyfunctional polymerization inhibitor (C) in addition has a 4-oxy-2,2,6,6-tetramethylpiperidin-1-oxyl free radical site shown below:

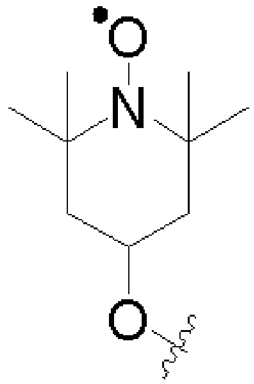

6. The lithographic printing plate precursor as claimed in any one of Claims 1 to 5, wherein the number of the radical trapping sites of the polyfunctional polymerization inhibitor (C) is from 2 to 6.

7. The lithographic printing plate precursor as claimed in any one of Claims 1 to 6, wherein the content of the polyfunctional polymerization inhibitor (C) is from 0.1 to 20% by mole to the radical polymerization initiator (A).

8. The lithographic printing plate precursor as claimed in any one of Claims 1 to 7, wherein the polyfunctional polymerization inhibitor (C) has a center skeleton B and n number, wherein n represents an integer of 2 or moreof the radical trapping sites.

9. The lithographic printing plate precursor as claimed in Claim 8, wherein the center skeleton B contains at least one of a benzene skeleton, an isocyanuric skeleton and an ester skeleton.

10. The lithographic printing plate precursor as claimed in any one of Claims 1 to 9, wherein the image-recording layer further contains (D) a sensitizing dye having an absorption wavelength in a range from 300 to 900 nm.

11. The lithographic printing plate precursor as claimed in any one of Claims 1 to 10, wherein the radical polymerization initiator (A) is an iodonium salt or a sulfonium salt.

12. The lithographic printing plate precursor as claimed in any one of Claims 1 to 11, wherein the image-recording layer contains an organic boron compound.

13. The lithographic printing plate precursor as claimed in any one of Claims 1 to 12, which has a protective layer containing an inorganic stratiform compound on the image-recording layer.

14. The lithographic printing plate precursor as claimed in any one of Claims 1 to 13, wherein an unexposed area of the image-recording layer is capable of being removed with at least one of dampening water and printing ink.

15. A plate making method comprising exposing imagewise the lithographic printing plate precursor as claimed in Claim 14 by an infrared laser, mounting the exposed lithographic printing plate precursor on a cylinder of printing machine, and removing the unexposed area of the image-recording layer with at least one of dampening water and printing ink.

**Patentansprüche**

1. Lithografie-Druckplattenvorläufer, umfassend einen Träger, auf dem eine Bildaufzeichnungsschicht vorgesehen ist, die (A) einen Radikalpolymerisationsinitiator, (B) eine radikalisch polymerisierbare Verbindung und (C) einen polyfunktionellen Polymerisationsinhibitor enthält, wobei der polyfunktionelle Polymerisationsinhibitor (C) in einem Molekül davon zwei oder mehr Radikal-fangende Stellen aufweist, um eine kovalente Bindung durch direktes Verbinden mit einem Rest zu bilden, wobei die Radikal-fangenden Stellen eine, zwei oder mehr Benzochinonstelle(n) einschliessen.

2. Lithografie-Druckplattenvorläufer gemäss Anspruch 1, wobei die Benzochinonstelle die nachstehende Struktur aufweist, in der X S oder NH darstellt:

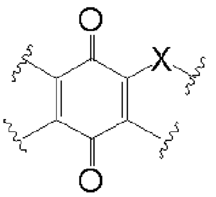

3. Lithografie-Druckplattenvorläufer gemäss Anspruch 2, wobei X S ist.

4. Lithografie-Druckplattenvorläufer gemäss Anspruch 1, wobei der polyfunktionelle Polymerisationsinhibitor (C) zusätzlich die nachstehend gezeigte freie 4-substituierte 2,2,6,6-Tetramethylpiperidin-1-oxyl-Radikalstelle aufweist:

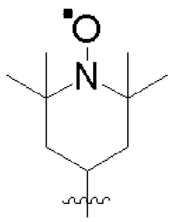

5. Lithografie-Druckplattenvorläufer gemäss Anspruch 1, wobei der polyfunktionelle Polymerisationsinhibitor (C) zusätzlich die nachsehend gezeigte freie 4-Oxy-2,2,6,6-tetramethylpiperidin-1-oxyl-Radikalstelle aufweist:

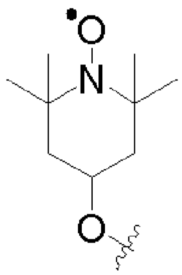

6. Lithografie-Druckplattenvorläufer gemäss irgendeinem der Ansprüche 1 bis 5, wobei die Zahl der Radikal-fangenden Stellen des polyfunktionellen Polymerisationsinhibitors (C) 2 bis 6 beträgt.

7. Lithografie-Druckplattenvorläufer gemäss irgendeinem der Ansprüche 1 bis 6, wobei der Gehalt des polyfunktionellen Polymerisationsinhibitors (C) 0,1 bis 20 Mol-% des Radikalpolymerisationsinitiators (A) beträgt.

8. Lithografie-Druckplattenvorläufer gemäss irgendeinem der Ansprüche 1 bis 7, wobei der polyfunktionelle Polymerisationsinhibitor (C) ein zentrales Gerüst B und n Zahlen aufweist, wobei n eine ganze Zahl von 2 oder mehr der Radikal-fangenden Stellen darstellt.

9. Lithografie-Druckplattenvorläufer gemäss Anspruch 8, wobei das zentrale Gerüst B zumindest eines von einem Benzolgerüst, einem Isocyanurgerüst und einem Estergerüst enthält.

10. Lithografie-Druckplattenvorläufer gemäss irgendeinem der Ansprüche 1 bis 9, wobei die Bildaufzeichnungsschicht ferner (D) einen Sensibilisierungsfarbstoff mit einer Absorptionswellenlänge in einem Bereich von 300 bis 900 nm enthält.

11. Lithografie-Druckplattenvorläufer gemäss irgendeinem der Ansprüche 1 bis 10, wobei der Radikalpolymerisationsinitiator (A) ein Iodoniumsalz oder ein Sulfoniumsalz ist.

12. Lithografie-Druckplattenvorläufer gemäss irgendeinem der Ansprüche 1 bis 11, wobei die Bildaufzeichnungsschicht eine organische Borverbindung enthält.

13. Lithografie-Druckplattenvorläufer gemäss irgendeinem der Ansprüche 1 bis 12, der eine Schutzschicht aufweist, die eine anorganische schichtförmige Verbindung auf der Bildaufzeichnungsschicht enthält.

14. Lithografie-Druckplattenvorläufer gemäss irgendeinem der Ansprüche 1 bis 13, wobei ein unbelichteter Bereich der Bildaufzeichnungsschicht in der Lage ist, mit zumindest einem von Feuchtwasser und Druckfarbe entfernt zu werden.

15. Plattenherstellungsverfahren, umfassend das bildweise Belichten des Lithografie-Druckplattenvorläufers gemäss Anspruch 14 durch einen Infrarotlaser, Montieren des belichteten Lithografie-Druckplattenvorläufers auf einem Zylinder der Druckvorrichtung und Entfernen des unbelichteten Bereichs der Bildaufzeichnungsschicht mit zumindest einem von Feuchtwasser und Druckfarbe.

**Revendications**

1. Précurseur de plaque d'impression lithographique comprenant un support sur lequel est appliquée une couche d'enregistrement d'image contenant (A) un initiateur de polymérisation par radicaux, (B) un composé polymérisable par radicaux et (C) un inhibiteur de polymérisation polyfonctionnel, dans lequel l'inhibiteur de polymérisation polyfonctionnel (C) a dans sa molécule deux ou plus de sites de piégeage de radicaux pour former une liaison covalente par liaison directe avec un radical,
dans lequel les sites de piégeage de radicaux comprennent un, deux ou plus de sites de benzoquinone.

2. Précurseur de plaque d'impression lithographique selon la revendication 1, dans lequel le site de benzoquinone a la structure suivante, dans laquelle X représente S ou NH :

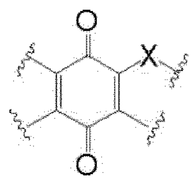

3. Précurseur de plaque d'impression lithographique selon la revendication 2, dans lequel X est S.

4. Précurseur de plaque d'impression lithographique selon la revendication 1, dans lequel l'inhibiteur de polymérisation polyfonctionnel (C) a en outre un site de radicaux libres de 4-substitué-2,2,6,6-tétraméthylpipéridin-1-oxyle illustré ci-dessous :

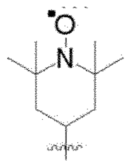

5. Précurseur de plaque d'impression lithographique selon la revendication 1, dans lequel l'inhibiteur de polymérisation polyfonctionnel (C) a en outre un site de radicaux libres de 4-oxy-2,2,6,6-tétraméthylpipéridin-1-oxyle illustré ci-dessous :

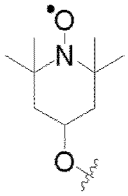

6. Précurseur de plaque d'impression lithographique selon l'une quelconque des revendications 1 à 5, dans lequel le nombre des sites de piégeage de radicaux de l'inhibiteur de polymérisation polyfonctionnel (C) est de 2 à 6.

7. Précurseur de plaque d'impression lithographique selon l'une quelconque des revendications 1 à 6, dans lequel le contenu de l'inhibiteur de polymérisation polyfonctionnel (C) est de 0,1 à 20 % en mole de l'initiateur de polymérisation par radicaux (A).

8. Précurseur de plaque d'impression lithographique selon l'une quelconque des revendications 1 à 7, dans lequel l'inhibiteur de polymérisation polyfonctionnel (C) a une ossature centrale B et un nombre n, dans lequel n représente un entier de 2 ou plus des sites de piégeage de radicaux.

9. Précurseur de plaque d'impression lithographique selon la revendication 8, dans lequel l'ossature centrale B contient au moins l'une d'une ossature de benzène, d'une ossature isocyanurique ou d'une ossature d'ester.

10. Précurseur de plaque d'impression lithographique selon l'une quelconque des revendications 1 à 9, dans lequel la couche d'enregistrement d'image contient en outre (D) un colorant de sensibilisation ayant une longueur d'onde d'absorption dans une plage de 300 à 900 nm.

11. Précurseur de plaque d'impression lithographique selon l'une quelconque des revendications 1 à 10, dans lequel l'initiateur de polymérisation par radicaux (A) est un sel d'iodonium ou un sel de sulfonium.

12. Précurseur de plaque d'impression lithographique selon l'une quelconque des revendications 1 à 11, dans lequel la couche d'enregistrement d'image contient un composé de bore organique.

13. Précurseur de plaque d'impression lithographique selon l'une quelconque des revendications 1 à 12, qui a une couche protectrice contenant un composé stratiforme inorganique sur la couche d'enregistrement d'image.

14. Précurseur de plaque d'impression lithographique selon l'une quelconque des revendications 1 à 13, dans lequel une zone non exposée de la couche d'enregistrement d'image peut être éliminée avec au moins un produit parmi de l'eau d'humectation et de l'encre d'impression.

15. Procédé de fabrication de plaques comprenant l'exposition selon une image du précurseur de plaque d'impression lithographique selon la revendication 14 par un laser à infrarouge, le montage du précurseur de plaque d'impression lithographique exposé sur un cylindre d'une machine d'impression et l'élimination de la zone non exposée de la couche d'enregistrement d'image par au moins un produit parmi de l'eau d'humectation et de l'encre d'impression.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2007160935 A
- US 2007099115 A
- JP 5066564 A
- JP 8507727 A
- JP 10058636 A
- JP 2001096710 A
- US 5340699 A
- JP 7103171 B
- JP 2002107916 A
- JP 2003076010 A
- JP 2005077978 A
- JP 2008195018 A
- JP 8108621 A
- JP 61166544 A
- JP 5158230 A
- US 4069055 A
- JP 4365049 A
- US 4069056 A
- EP 104143 A
- US 20080311520 A
- JP 2150848 A
- EP 370693 A
- EP 233567 A
- EP 297443 A
- EP 297442 A
- US 4933377 A
- EP 4760013 A
- EP 4734444 A
- EP 2833827 A
- DE 2904626
- DE 3604580
- DE 3604581
- US 20030118939 A
- US 20040091811 A
- US 20040259027 A
- JP 2005059446 A
- JP 2006508380 T
- JP 2002287344 A
- JP 2008256850 A
- JP 2001342222 A
- JP 9179296 A
- JP 9179297 A
- JP 9179298 A
- JP 2004294935 A
- JP 2006243493 A
- JP 2002275129 A
- JP 2003064130 A
- JP 2003280187 A
- JP 10333321 A
- JP 48041708 B
- JP 51037193 A
- JP 2032293 B
- JP 2016765 B
- JP 2003344997 A
- JP 2006065210 A
- JP 58049860 B
- JP 56017654 B
- JP 62039417 B
- JP 62039418 B
- JP 2000250211 A
- JP 2007094138 A
- US 7153632 B
- JP 8505958 T
- JP 2007293221 A
- JP 2007293223 A
- JP 2007249036 A
- JP 59044615 B
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A
- JP 11352691 A
- JP 2002040652 A
- JP 2005300650 A
- JP 2007248863 A
- JP 2007272134 A
- JP 2007017948 A
- JP 2003270775 A
- JP 7021633 B
- JP 9123387 A
- JP 9131850 A
- JP 9171249 A
- JP 9171250 A
- EP 931647 A
- JP 2001277740 A
- JP 2001277742 A
- EP 2383118 A
- JP 2007276454 A

- JP 2009154525 A
- JP 2006297907 A
- JP 2007050660 A
- JP 2008284858 A
- JP 2009090645 A
- JP 2009208458 A
- JP 2008284817 A
- JP 2006091479 A
- JP 10282679 A
- JP 2304441 A
- JP 2005238816 A
- JP 2005125749 A
- JP 2006239867 A
- JP 2006215263 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A
- US 3458311 A
- JP 55049729 B
- JP 2005250216 A
- JP 2006259137 A
- JP 2012073597 A
- JP 2005119273 A
- JP 54012215 B

**Non-patent literature cited in the description**


- **S. I. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh, Proc. Conf. Rad. Curing ASIA,* October 1988, 478
- Polyurethane Resin Handbook. Nikkan Kogyo Shimbun, Ltd, 1987
- *Research Disclosure,* January 1992